# EUROPEAN PATENT SPECIFICATION

(11) **EP 2 687 304 B1**
(45) Date of publication and mention of the grant of the patent: **23.01.2019**
(21) Application number: 12757963.9
(22) Date of filing: 15.03.2012
(51) Int. Cl.: B22F 1/02, B22F 1/00, C08K 7/02, C08K 3/08, C08L 65/00, H01B 1/00, H01B 1/12, H01B 1/20, H01B 1/22, H01B 5/14, H01L 51/05, H01L 51/30, C08G 61/02, C08G 61/12

(54) **METAL COMPLEX COMPOSITIONS AND MIXTURE THEREOF**
METALLKOMPLEXZUSAMMENSETZUNGEN UND MISCHUNGEN DARAUS
COMPOSITION DE COMPOSITE MÉTALLIQUE, ET MÉLANGE DE CELLE-CI

(30) Priority: 17.03.2011 JP 2011059151
(43) Date of publication of application: 22.01.2014
(73) Proprietor: Sumitomo Chemical Company Limited, Tokyo 104-8260 (JP)
(72) Inventor: IIJIMA, Takayuki, Tsukuba-shi, Ibaraki 300-3294 (JP); HIGASHIMURA, Hideyuki, Tsukuba-shi, Ibaraki 300-3294 (JP)
(74) Representative: J A Kemp
(86) International application number: PCT/JP2012/056739
(87) International publication number: WO 2012/124770

(56) References cited:
- EP-A1- 2 418 033
- WO-A2-2009/123666
- JP-A- 2008 165 988
- JP-A- 2009 102 601
- JP-A- 2010 062 059
- JP-A- 2010 261 102
- US-A1- 2006 231 805
- US-A1- 2007 120 115
- XIAOFENG LU ET AL: "One-dimensional conducting polymer nanocomposites: Synthesis, properties and applications", PROGRESS IN POLYMER SCIENCE, PERGAMON PRESS, OXFORD, GB, vol. 36, no. 5, 21 July 2010 (2010-07-21), pages 671-712, XP028369779, ISSN: 0079-6700, DOI: 10.1016/J.PROGPOLYMSCI.2010.07.010 [retrieved on 2010-08-11]

## Description

### Technical Field

The present invention relates to a light emitting device.

### Background Art

A material containing a metal and an organic compound is attracting attention in recent years, because the material is useful as an electrode material of an electronic device. Examples of the material containing a metal and an organic compound may include a metallic composite in which a metal and an organic compound are complexed and a composition in which a metallic composite and an organic compound are mixed. Specifically, it is proposed to manufacture an electrode by an application method using a dispersion liquid in which a silver nanowire having a conjugated compound adsorbed thereto, as the metallic composite, is dispersed in a polar solvent such as methanol, and then manufacturing a light-emitting device using the electrode (Patent Document 1).

### Related Art Document

### Patent Document

Patent Document 1: JP 2010-261102 A

EP 2 418 033 A1 discusses a metallic composite useful in light emitting devices, the metallic composite comprising a conjugated compound adsorbed to a metallic nanostructure.

US 2007/120115 A1 discusses an organic light-emitting element comprising: an anode; an organic light-emitting layer formed on one surface of the anode, an electron transportation layer formed on the organic light-emitting layer; and a cathode formed on a side being opposite to the organic light-emitting layer with respect to the electron transportation layer. A main material of the electron transportation layer is composed of an organic compound with electron transportation characteristic having at least one element that holds a unshared electron pair, and a metal ion including at least one kind of an alkali metal ion, alkaline earth metal ion and rare earth metal ion.

US 2006/231805 A1 discusses a method of forming metal nanoparticles using a polymer colloid that includes at least one conductive polymer and at least one polyelectrolyte. Metal ions are reduced in water by the conductive polymer to produce the nanoparticles, which may be then incorporated in the colloidal structure to form a colloid composite

WO 2009/123666 A2 discusses electrochemical storage devices, such as supercapacitors, batteries, etc., and particularly such devices that comprise an electrochemically active coaxial nanowire.

XIAOFENG LU ET AL: "One-dimensional conducting polymer nanocomposites: Synthesis, properties and applications", PROGRESS IN POLYMER SCIENCE, vol. 36, no. 5, 21 July 2010 pages 671-712 discusses intrinsically conducting polymers, particularly synthesis of one-dimensional (1D) conducting polymer nanocomposites and their properties and applications.

JP 2008 165988 A discusses a light emitting device which comprises metal cations in conductive polymer compositions which may be used as electrodes in light emitting devices.

JP 2010 062059 A discusses conductive composites for use as electrodes in light emitting devices.

### Summary of the Invention

### Problem to be Solved by the Invention

However, the conventional light-emitting device does not necessarily exhibit sufficient light-emitting brightness.

Therefore, an object of the present invention is to provide means for enabling further improvement of light-emitting brightness.

### Means for Solving Problem

The present invention provides a light-emitting device comprising an anode, a cathode, and a light-emitting layer provided between the anode and the cathode,
characterized in that the cathode comprises a metallic composite composition comprising:
(1) a metallic composite in which a conjugated compound having a polystyrene equivalent number average molecular weight of 1.0 x 10³ to 5.0 x 10⁶ as measured by gel permeation chromatography is adsorbed to a metallic nanostructure having the shape of a nanowire that is a metal or a metal oxide selected from the group consisting of indium oxide, zinc oxide, tin oxide, indium tin oxide, aluminum zinc oxide, indium zinc oxide, tin antimony oxide and NESA and having an aspect ratio of 1.5 or more; and
(2) an ionic compound, with the proviso that when the ionic compound is a conjugated compound, the ionic compound is a conjugated compound having a molecular weight of less than 200,
   wherein the ionic compound is a compound having a structure represented by Formula (hh-1) below:

   M^{m'+}ₐX'^{n'-}_{b} (hh-1)

   wherein
   M^{m}'⁺ represents an alkali metal cation,
   X'ⁿ'⁻ represents an anion,
   a and b each independently represent an integer of 1 or more, and
   when each of M^{m}'⁺ and X'ⁿ'⁻ is plurally present, they each may be the same as or different from each other, wherein the ionic compound is a compound having a molecular weight of less than 500, and the amount of the ionic compound is 1 to 50 parts by weight, with respect to 100 parts by weight of the metallic composite..

### Effect of Invention

According to the invention, an electronic device having excellent light-emitting brightness or photovoltaic efficiency can be manufactured.
The metallic composite composition and the mixture thereof disclosed herein are useful as, for example, a coated electrode, a transparent electrode, a conductive paint, a wiring material, an adhesive, a bond, an electrically conductive paint, a circuit, an integrated circuit, an electromagnetic wave shielding material, a sensor, an antenna, an antistatic agent, a fiber, a packaging material, an antimicrobial agent, a deodorant, a heating device, a radiator or a medical material. In particular, the metallic composite composition and the mixture thereof are useful as an electronic device such as a light-emitting device, a solar cell and an organic transistor, and particularly as an electrode material, because they are excellent in electrical conductivity and transparency.

Furthermore, the light-emitting device of the present invention can be simply manufactured, because a layer other than an anode is formed by an application method.

### Embodiments for Carrying Out the Invention

The present invention will be described below.

As used herein, the term "adsorption" means a chemical adsorption or a physical adsorption. The chemical adsorption is preferred due to strong adsorption. The chemical adsorption is accompanied by a chemical bond (such as a covalent bond, an ionic bond, a metallic bond, a coordination bond and a hydrogen bond) between an adsorbate and an adsorbent. Here, the adsorbate is a conjugated compound, and the adsorbent is a metallic nanostructure. On the other hand, in the physical adsorption, a chemical bond is not formed between an adsorbate and an adsorbent, and a reversible adsorption is caused by physical van der Waals force and the like.

An aspect ratio of a metallic nanostructure means a ratio of (the largest diameter) / (the smallest diameter). When the aspect ratio has a distribution, the aspect ratio is an average value. The average value is an arithmetic average value. The largest diameter and the smallest diameter of the metallic nanostructure such as a silver nanostructure can be confirmed with a photograph by a scanning electron microscope.

Because an electrical conductivity of a cathode is improved, the aspect ratio is preferably 2 or more, more preferably 5 or more, further preferably 10 or more, particularly preferably 50 or more, more particularly preferably 100 or more, and still further preferably 300 or more.

When the aspect ratio is less than 1.5, formation of a conductive path becomes insufficient, and then the electrical conductivity may be lowered.

The upper limit of the aspect ratio is not particularly limited. Because good dispersibility is obtained, the aspect ratio is preferably 10⁷ or less, more preferably 10⁶ or less, further preferably 10⁵ or less, particularly preferably 10⁴ or less, and more particularly preferably 10³ or less.

The metallic nanostructure is a metal or a metal oxide each having a nano-scale diameter. The metal oxide is selected from indium oxide, zinc oxide, tin oxide, indium tin oxide (ITO), aluminum zinc oxide (AZO), indium zinc oxide (IZO), tin antimony oxide and NESA (which are complexes containing indium oxide, zinc oxide or tin oxide). Among them, ITO and IZO are preferred. The smallest diameter of the metallic nanostructure is 1 nm or more and less than 1000 nm. For easy synthesis, the smallest diameter is preferably 800 nm or less, more preferably 600 nm or less, and further preferably 300 nm or less.

The largest diameter of the metallic nanostructure is usually 1000 nm or more. Because good dispersibility is obtained, the largest diameter is preferably 1300 nm or more, more preferably 1600 nm or more, and further preferably 2000 nm or more. The largest diameter is usually 250000 nm or less.

The shape of the metallic nanostructure is a nanowire.

Because being excellent in stability of metal, the metal that constitutes the metallic nanostructure is preferably a transition metal, more preferably a metal of Group 11 of the Periodic Table, and further preferably silver. These metals may be contained in the metallic nanostructure in combination of two or more types thereof and may be oxidized.

In the present invention, a mixture of two or more types of metallic nanostructures each having a different aspect ratio may be used.

When two or more types of metallic nanostructures each having a different aspect ratio are contained, the content of a metallic nanostructure having an aspect ratio less than a half of an average value of aspect ratios is preferably 50 parts by weight or less, more preferably 40 parts by weight or less, further preferably 30 parts by weight or less, and particularly preferably 10 parts by weight or less, when the total amount of the metallic nanostructures is 100 parts by weight.

Because the metallic composite having excellent stability is obtained, the polystyrene equivalent number average molecular weight of the conjugated compound, as measured by gel permeation chromatography, is 1.0 × 10³ to 5.0 × 10⁶. If the molecular weight of the conjugated compound were to be less than 200, the conjugated compound adsorbed to the metallic composite may become easily separated by evaporation or the like.

The metallic nanostructure can be manufactured by a publicly known method such as a liquid phase method and a gas phase method. Alternatively, a commercially available product can be used as it is for the metallic nanostructure. More specifically, examples of the method for manufacturing a gold nanostructure may include the methods described in JP 2006-233252 A and the like. Examples of the method for manufacturing a silver nanostructure may include the methods described in Xia, Y. et al., Chem. Mater. (2002), 14, 4736-4745; Xia, Y. et al., Nano Letters (2003), 3, 955-960; Xia, Y. et al., J. Mater. Chem. (2008) 18, 437-441; and the like. Examples of the method for manufacturing a copper nanostructure may include the methods described in JP 2002-266007 A and the like. Examples of the method for manufacturing a cobalt nanostructure may include the methods described in JP 2004-149871 A and the like.

As used herein, the conjugated compound means a compound having a conjugated system. The conjugated compound is preferably a compound containing a system in which multiple bonds (a double bond or a triple bond), unshared electron pairs (for example, an unshared electron pair that a nitrogen atom, an oxygen atom, a sulfur atom or a phosphorus atom has), vacant p orbitals (for example, a vacant p orbital that a boron atom has), or σ-bonding d orbitals (for example, a σ-bonding d orbital that a silicon atom has) are bound to each other with one single bond interposed therebetween.

Because good electron transport property is obtained, the conjugated compound has a value calculated by a formula of {(the number of atoms contained in the system in which multiple bonds, unshared electron pairs, vacant p orbitals or σ-bonding d orbitals are bound to each other with one single bond interposed therebetween on the mother skeleton or the main chain)/(the number of all atoms on the mother skeleton or the main chain)}×100% of preferably 50% or more, more preferably 60% or more, more preferably 70% or more, further preferably 80% or more, and particularly preferably 90% or more. It is particularly preferable that the conjugated compound is an aromatic compound. Because the metallic composite having good stability is obtained, the conjugated compound preferably contains a hetero atom.

The conjugated compound is preferably a compound having a group represented by Formula (I) below, or a repeating unit represented by Formula (II) below, or both of them.

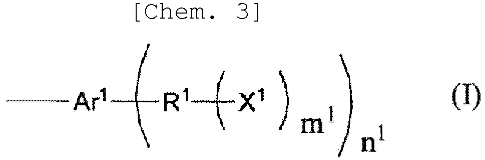

In Formula (I), Ar¹ represents an (n¹+1) valent aromatic group, R¹ represents a direct bond or an (m¹+1) valent group, X¹ represents a hetero atom-containing group, m¹ and n¹ each independently represent an integer of 1 or more, and when each of R¹, X¹ and m¹ is plurally present, they each may be the same as or different from each other.

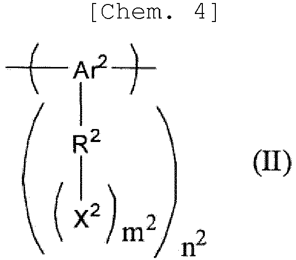

In Formula (II), Ar² represents an (n² + 2) valent aromatic group, R² represents a direct bond or an (m² + 1) valent group, X² is a hetero atom-containing group, m² and n² each independently represent an integer of 1 or more, and when each of R², X² and m² is plurally present, they each may be the same as or different from each other.

It is noted that "when each of R¹, X¹ and m¹ is plurally present, they each may be the same as or different from each other" has the same meaning as "when R¹ is plurally present, they each may be the same as or different from each other, when X¹ is plurally present, they each may be the same as or different from each other, and when m¹ is plurally present, they each may be the same as or different from each other."

In Formula (I), the (n¹+1) valent aromatic group represented by Ar¹ means an atomic group (a residue) remaining after removing (n¹+1) hydrogen atoms that are directly bonded to carbon atoms constituting a ring from a compound that has an aromatic ring optionally having a substituent.

In Formula (II), the (n²+2) valent aromatic group represented by Ar² means an atomic group (a residue) remaining after removing (n²+2) hydrogen atoms that are directly bonded to carbon atoms constituting a ring from a compound that has an aromatic ring optionally having a substituent.

Examples of the compound that has an aromatic ring may include a compound represented by Formulae (1) to (95) below. For easy synthesis, the compound that has an aromatic ring is preferably a compound represented by any one of Formulae (1) to (12), (15) to (22), (24) to (31), (37) to (40), (43) to (46), (49), (50), and (59) to (76) below; more preferably a compound represented by any one of Formulae (1) to (3), (8) to (10), (15) to (21), (24) to (31), (37), (39), (43) to (45), (49), (50), and (59) to (76) below; further preferably a compound represented by any one of Formulae (1) to (3), (8), (10), (15), (17), (21), (24), (30), (59), (60) and (61) below; particularly preferably a compound represented by any one of Formulae (1) to (3), (8), (10) and (59) below; and more particularly preferably a compound represented by Formula (1), (8) or (59) below.

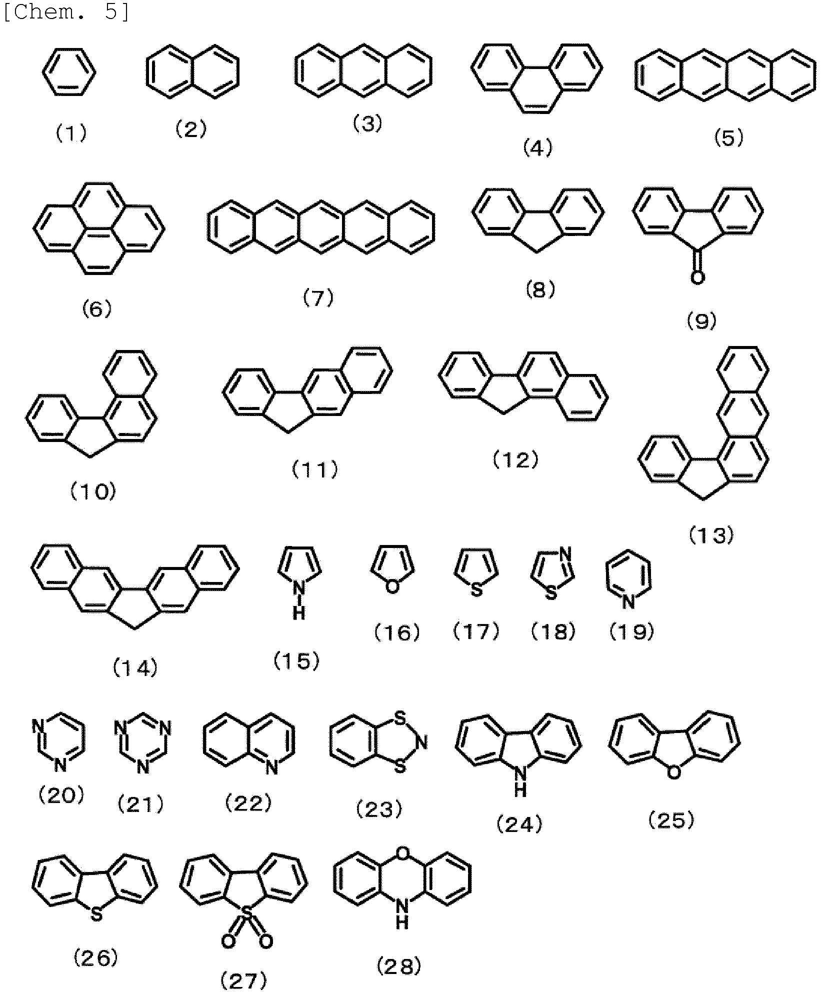

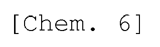

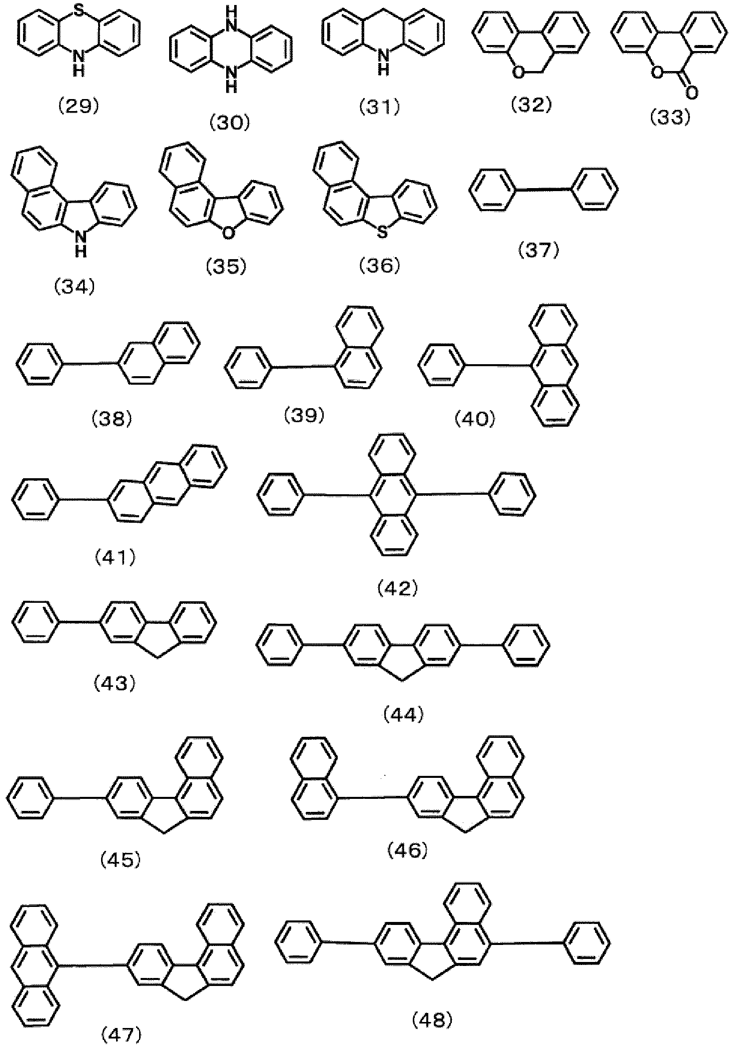

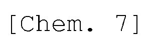

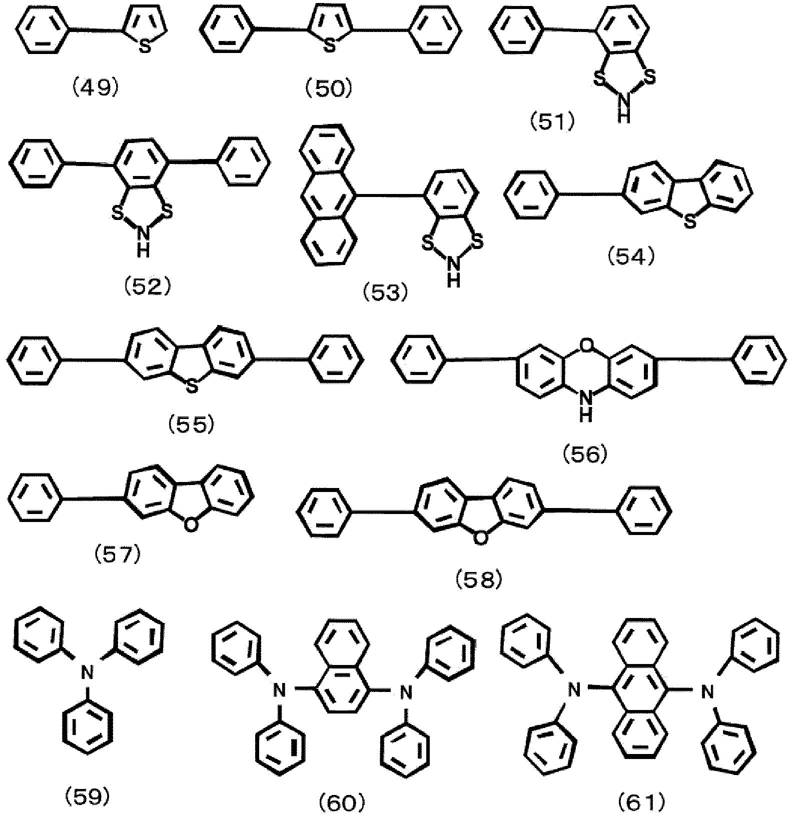

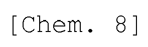

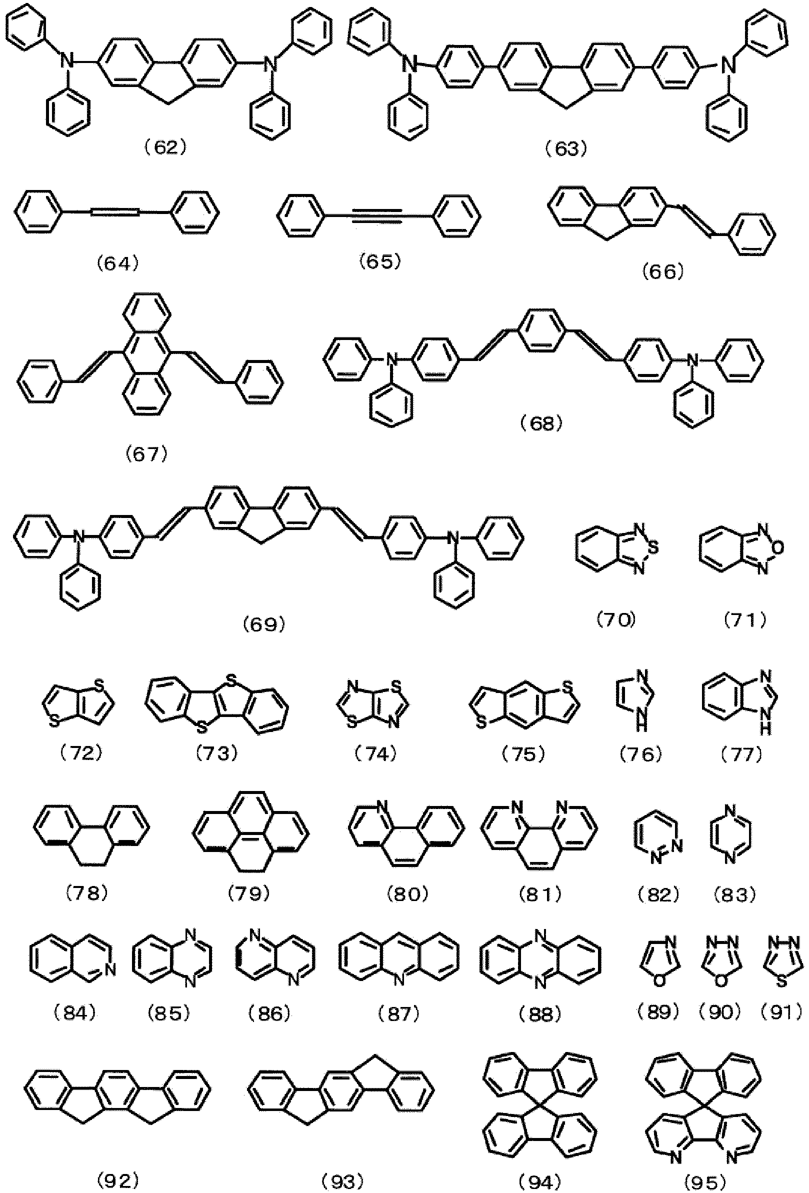

A hydrogen atom in the compound that has an aromatic ring may be substituted with a substituent.

Examples of the substituent may include a hydrocarbyl group optionally having a substituent, a mercapto group, a mercaptocarbonyl group, a mercaptothiocarbonyl group, a hydrocarbylthio group optionally having a substituent, a hydrocarbylthiocarbonyl group optionally having a substituent, a hydrocarbyldithio group optionally having a substituent, a hydroxyl group, a hydrocarbyloxy group optionally having a substituent, a carboxyl group, a hydrocarbylcarbonyl group optionally having a substituent, a cyano group, an amino group, a hydrocarbylamino group optionally having a substituent, a dihydrocarbylamino group optionally having a substituent, a phosphino group, a hydrocarbylphosphino group optionally having a substituent, a dihydrocarbylphosphino group optionally having a substituent, a group represented by formula: -P(=O)(OH)₂, a sulfo group, a monovalent heterocyclic group, a halogen atom, a formyl group, a hydrocarbyloxycarbonyl group optionally having a substituent, a hydrocarbylcarbonyloxy group optionally having a substituent, a nitro group, a group represented by formula: -OP(=O)(OH)₂, a carbamoyl group, a hydrocarbylcarbamoyl group optionally having a substituent, a dihydrocarbylcarbamoyl group optionally having a substituent, a group represented by formula:-C(=S)NR₂, a group represented by formula: -B(OH)₂, a group represented by formula: -BR₂, a boric acid ester residue, a group represented by formula: -Si(OR)₃, a hydrocarbylsulfo group optionally having a substituent, a hydrocarbylsulfonyl group optionally having a substituent, a sulfino group, a hydrocarbylsulfino group optionally having a substituent, a group represented by formula:-NRC(=O)OR, a group represented by formula: -NRC(=O)SR, a group represented by formula: -NRC(=S)OR, a group represented by formula: -NRC(=S)SR, a group represented by formula: -OC(=O)NR₂, a group represented by formula:-SC(=O)NR₂, a group represented by formula: -OC(=S)NR₂, a group represented by formula: -SC(=S)NR₂, a group represented by formula: -NRC(=O)NR₂, a group represented by formula: -NRC(=S)NR₂, a hydrocarbyl group having two or more ether bonds, a hydrocarbyl group having two or more ester bonds, a hydrocarbyl group having two or more amido bonds, a group represented by formula: -SM, a group represented by formula: -C(=O)SM, a group represented by formula: -CS₂M, a group represented by formula: -OM, a group represented by formula: -CO₂M, a group represented by formula: -NM₂, a group represented by formula: -NHM, a group represented by formula: -NRM, a group represented by formula: -PO₃M, a group represented by formula:-OP(=O)(OM)₂, a group represented by formula: -P(=O)(OM)₂, a group represented by formula: -C(=O)NM₂, a group represented by formula: -C(=O)NHM, a group represented by formula: -C(=O)NRM, a group represented by formula:-C(=S)NHM, a group represented by formula: -C(=S)NRM, a group represented by formula: -C(=S)NM₂, a group represented by formula: -B(OM)₂, a group represented by formula: -BR₃M, a group represented by formula: -B(OR)₃M, a group represented by formula: -SO₃M, a group represented by formula: -SO₂M, a group represented by formula: -NRC(=O)OM, a group represented by formula: -NRC(=O)SM, a group represented by formula: -NRC(=S)OM, a group represented by formula: -NRC(=S)SM, a group represented by formula:-OC(=O)NM₂, a group represented by formula: -OC(=O)NRM, a group represented by formula: -OC(=S)NM₂, a group represented by formula: -OC(=S)NRM, a group represented by formula: -SC(=O)NM₂, a group represented by formula:-SC(=O)NRM, a group represented by formula: -SC(=S)NM₂, a group represented by formula: -SC(=S)NRM, a group represented by formula: -NRC(=O)NM₂, a group represented by formula: -NRC(=O)NRM, a group represented by formula:-NRC(=S)NM₂, a group represented by formula: -NRC(=S)NRM, a group represented by formula: -NR₃M', a group represented by formula: -PR₃M', a group represented by formula: -OR₂M', a group represented by formula: -SR₂M', a group represented by formula: -IRM', and a heterocyclic group having a cationized nitrogen atom within a heterocycle. In the formulae, R represents a hydrogen atom, or a hydrocarbyl group (for example, an alkyl group, a cycloalkyl group, an aryl group, an aralkyl group; the same shall apply hereinafter) optionally having a substituent; M represents a metal cation or an ammonium cation optionally having a substituent; and M' represents an anion. Also, these substituents may be bonded together to form a ring together with a carbon atom, a nitrogen atom or the like to which each of these substituents bonds.

Preferred examples among the above substituents may include a halogen atom, a hydrocarbyl group optionally having a substituent, a mercapto group, a hydrocarbylthio group optionally having a substituent, a hydrocarbyldithio group optionally having a substituent, a hydroxyl group, a hydrocarbyloxy group optionally having a substituent, a carboxyl group, a hydrocarbylcarbonyl group optionally having a substituent, a cyano group, an amino group, a hydrocarbylamino group optionally having a substituent, a dihydrocarbylamino group optionally having a substituent, a group represented by formula: -OP(=O)(OH)₂, a group represented by formula: -P(=O)(OH)₂, a sulfo group, a monovalent heterocyclic group, a group represented by formula: -CO₂M, a group represented by formula: -PO₃M, a group represented by formula: -SO₃M, and a group represented by formula: -NR₃M'.

More preferred examples may include a halogen atom, a hydrocarbyl group optionally having a substituent, a mercapto group, a hydroxyl group, a carboxyl group, a cyano group, an amino group, a group represented by formula:-P(=O)(OH)₂, a sulfo group, a monovalent heterocyclic group, a group represented by formula: -CO₂M, a group represented by formula: -PO₃M, and a group represented by formula:-NR₃M'. Further preferred examples may include a hydrocarbyl group optionally having a substituent, a mercapto group, a carboxyl group, a pyridyl group optionally having a substituent, and a group represented by formula: -CO₂M.

In the present specification, the meaning that a certain group "optionally has a substituent" or "may be substituted" is that a certain group is an unsubstituted group or that a certain group is substituted. The term "unsubstituted" means that a hydrogen atom of the group stated immediately following the term is not substituted with a substituent. The term "substituted" immediately anterior to a group means that a part or all of hydrogen atoms of the group are each substituted with a substituent.

Examples of the substituent may include, unless otherwise stated, a halogen atom, a hydrocarbyl group having 1 to 30 carbon atoms, and a hydrocarbyloxy group having 1 to 30 carbon atoms. Among these, a halogen atom, a hydrocarbyl group having 1 to 18 carbon atoms, and a hydrocarbyloxy group having 1 to 18 carbon atoms are preferred; a halogen atom, a hydrocarbyl group having 1 to 12 carbon atoms, and a hydrocarbyloxy group having 1 to 12 carbon atoms are more preferred; a halogen atom and a hydrocarbyl group having 1 to 12 carbon atoms are further preferred; and a halogen atom and a hydrocarbyl group having 1 to 6 carbon atoms are particularly preferred.

Examples of the hydrocarbyl group and the hydrocarbyloxy group are the same as those of the alkyl group and the alkyloxy group described later, respectively. When a certain group is substituted, the number of substituents is usually 1 to 4, preferably 1 to 3, and more preferably 1 to 2.

Examples of the halogen atom as a substituent may include a fluorine atom, a chlorine atom, a bromine atom and an iodine atom. A fluorine atom, a chlorine atom or a bromine atom is preferred.

Examples of the hydrocarbyl group optionally having a substituent, as a substituent, may include an alkyl group having 1 to 50 carbon atoms such as a methyl group, an ethyl group, a propyl group, an isopropyl group, a butyl group, an isobutyl group, a sec-butyl group, a tert-butyl group, a pentyl group, a hexyl group, a nonyl group, a dodecyl group, a pentadecyl group, an octadecyl group, and a docosyl group; a cyclic saturated hydrocarbyl group having 3 to 50 carbon atoms such as a cyclopropyl group, a cyclobutyl group, a cyclobutyl group, a cyclopentyl group, a cyclohexyl group, a cyclononyl group, a cyclododecyl group, a norbornyl group, and an adamantyl group; an alkenyl group having 2 to 50 carbon atoms such as an ethenyl group, a propenyl group, a 3-butenyl group, a 2-butenyl group, a 2-pentenyl group, a 2-hexenyl group, a 2-nonenyl group, and a 2-dodecenyl group; an aryl group having 6 to 50 carbon atoms such as a phenyl group, a 1-naphthyl group, a 2-naphthyl group, a 2-methylphenyl group, a 3-methylphenyl group, a 4-methylphenyl group, a 4-ethylphenyl group, a 4-propylphenyl group, a 4-isopropylphenyl group, a 4-butylphenyl group, a 4-tert-butylphenyl group, a 4-hexylphenyl group, a 4-cyclohexylphenyl group, a 4-adamantylphenyl group, and a 4-phenylphenyl group; and an aralkyl group having 7 to 50 carbon atoms such as a phenylmethyl group, a 1-phenyleneethyl group, a 2-phenylethyl group, a 1-phenyl-1-propyl group, a 1-phenyl-2-propyl group, a 2-phenyl-2-propyl group, a 3-phenyl-1-propyl group, a 4-phenyl-1-butyl group, a 5-phenyl-1-pentyl group, and a 6-phenyl-1-hexyl group.

Among these, an alkyl group having 1 to 50 carbon atoms or an aryl group having 6 to 50 carbon atoms is preferred; an alkyl group having 1 to 12 carbon atoms or an aryl group having 6 to 18 carbon atoms is more preferred; and an alkyl group having 1 to 6 carbon atoms or an aryl group having 6 to 12 carbon atoms is further preferred.

The hydrocarbylthio group optionally having a substituent, the hydrocarbylthiocarbonyl group optionally having a substituent, the hydrocarbyldithio group optionally having a substituent, the hydrocarbyloxy group optionally having a substituent, the hydrocarbylcarbonyl group optionally having a substituent, the hydrocarbyloxycarbonyl group optionally having a substituent, and the hydrocarbylcarbonyloxy group optionally having a substituent, as a substituent, are a thio group, a thiocarbonyl group, a dithio group, an oxy group, a carbonyl group, an oxycarbonyl group, and a carbonyloxy group in which a part or all (particularly 1 to 3, more particularly 1 or 2) of hydrogen atoms constituting each group are substituted with the hydrocarbyl group.

The hydrocarbylamino group optionally having a substituent, the dihydrocarbylamino group optionally having a substituent, the hydrocarbylphosphino group optionally having a substituent, and the dihydrocarbylphosphino group optionally having a substituent, as a substituent, are an amino group and a phosphino group in which one or two of hydrogen atoms constituting each group are substituted with the hydrocarbyl group.

The hydrocarbylcarbamoyl group optionally having a substituent and the dihydrocarbylcarbamoyl group optionally having a substituent, as a substituent, are a carbamoyl group in which one or two of hydrogen atoms constituting each group are substituted with the hydrocarbyl group.

The group represented by formula: -BR₂ and the group represented by formula: -Si(OR)₃, as a substituent, are a group in which the R is a hydrogen atom or the hydrocarbyl group. Preferred examples of the hydrocarbyl group are the same as the above.

Examples of the boric acid ester residue as a substituent may include a group represented by any one of formulae below.

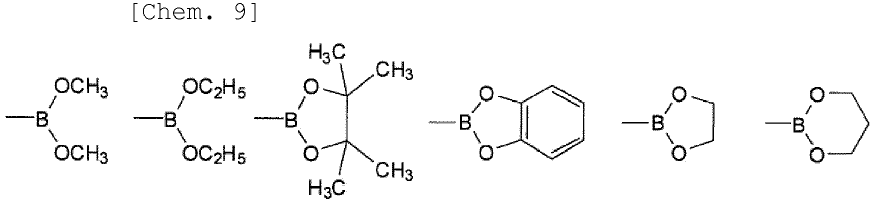

The hydrocarbylsulfo group optionally having a substituent, the hydrocarbylsulfonyl group optionally having a substituent, and the hydrocarbylsulfino group optionally having a substituent, as a substituent, are a sulfo group, a sulfonyl group and a sulfino group in which one or two of hydrogen atoms constituting each group are substituted with the hydrocarbyl group.

The group represented by formula: -C(=S)NR₂, the group represented by formula: -NRC(=O)OR, the group represented by formula: -NRC(=O)SR, the group represented by formula: -NRC(=S)OR, the group represented by formula:-NRC(=S)SR, the group represented by formula: -OC(=O)NR₂, the group represented by formula: -SC(=O)NR₂, the group represented by formula: -OC(=S)NR₂, the group represented by formula: -SC(=S)NR₂, the group represented by formula:-NRC(=O)NR₂, and the group represented by formula:-NRC(=S)NR₂, as a substituent, are a group in which the R is a hydrogen atom or the hydrocarbyl group. Preferred examples of the hydrocarbyl group are the same as the above.

The monovalent heterocyclic group as a substituent is an atomic group remaining after removing one hydrogen atom that is directly bonded to a carbon atom constituting a ring from a heterocyclic compound optionally having a substituent. Examples of the heterocycle of the heterocyclic compound may include a monocyclic heterocycle such as a pyridine ring, a 1,2-diazine ring, a 1,3-diazine ring, a 1,4-diazine ring, a 1,3,5-triazine ring, a furan ring, a pyrrole ring, a thiophene ring, a pyrazole ring, an imidazole ring, an oxazole ring, a thiazole ring, an oxadiazole ring, a thiadiazole ring and an azadiazole ring; a fused polycyclic heterocyle in which two or more rings selected from monocyclic aromatic rings are fused; and a bridged polycyclic aromatic ring having a structure in which two heterocycles, or one heterocycle and one aromatic ring are bridged through a divalent group such as a methylene group, an ethylene group and a carbonyl group. Among these, a pyridine ring, a 1,2-diazine ring, a 1,3-diazine ring, a 1,4-diazine ring or a 1,3,5-triazine ring is preferred; and a pyridine ring or a 1,3,5-triazine ring is more preferred.

Examples of the hydrocarbyl group having two or more ether bonds as a substituent may include a group represented by any one of formulae below.

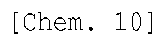

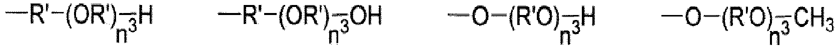

In the formulae, R' represents a hydrocarbondiyl group optionally having a substituent; a plurality of R' may be the same as or different from each other; and n³ is an integer of 2 or more.

Examples of the hydrocarbondiyl group optionally having a substituent (sometimes referred to as a "hydrocarbylene group") may include a C₁ to C₅₀ saturated hydrocarbondiyl group optionally having a substituent such as a methylene group, an ethylene group, a propylene group, a trimethylene group, a 1,2-butylene group, a 1,3-butylene group, a tetramethylene group, a pentamethylene group, a hexamethylene group, a nonamethylene group, a dodecamethylene group, and a group in which at least one hydrogen atom in these groups is substituted with a substituent; a C₂ to C₅₀ unsaturated hydrocarbondiyl group having or not having a substituent including a C₂ to C₅₀ alkenylene group optionally having a substituent such as an ethenylene group, a propenylene group, a 3-butenylene group, a 2-butenylene group, a 2-pentenylene group, a 2-hexenylene group, a 2-nonenylene group, a 2-dodecenylene group, and a group in which at least one hydrogen atom in these groups is substituted with a substituent, and an ethynylene group; a C₃ to C₅₀ saturated cyclic hydrocarbondiyl group optionally having a substituent such as a cyclopropylene group, a cyclobutylene group, a cyclopentylene group, a cyclohexylene group, a cyclononylene group, a cyclododecylene group, a norbonylene group, an adamantylene group, and a group in which at least one hydrogen atom in these groups is substituted with a substituent; and a C₆ to C₅₀ arylene group optionally having a substituent such as a 1,3-phenylene group, a 1,4-phenylene group, a 1,4-naphthylene group, a 1,5-naphthylene group, a 2,6-naphthylene group, a biphenyl-4,4'-diyl group, and a group in which at least one hydrogen atom in these groups is substituted with a substituent. When the hydrocarbyl group having an ether bond is plurally present, these groups may be bonded together to form a ring.

Examples of the hydrocarbyl group having two or more ester bonds as a substituent may include a group represented by any one of formulae below.

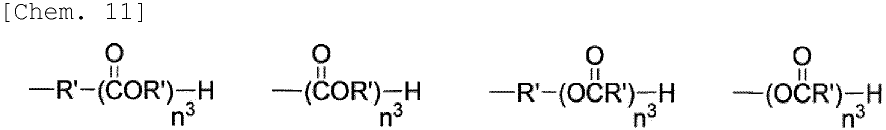

In the formulae, R' and n³ have the same meaning as the above.

Examples of the hydrocarbyl group having two or more amido bonds as a substituent may include a group represented by formulae below.

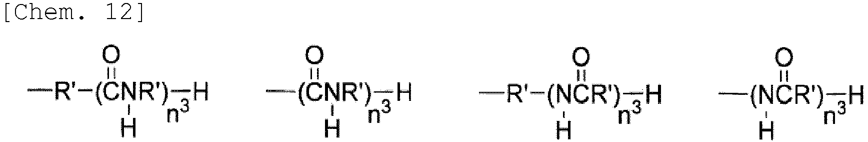

In the formulae, R' and n³ have the same meaning as the above.

In the group represented by formula: -SM, the group represented by formula: -C(=O)SM, the group represented by formula: -CS₂M, the group represented by formula: -OM, the group represented by formula: -CO₂M, the group represented by formula: -NM₂, the group represented by formula: -NHM, the group represented by formula: -NRM, the group represented by formula: -PO₃M, the group represented by formula: -OP(=O)(OM)₂, the group represented by formula: -P(=O)(OM)₂, the group represented by formula: -C(=O)NM₂, the group represented by formula: -C(=O)NHM, the group represented by formula: -C(=O)NRM, the group represented by formula: -C(=S)NHM, the group represented by formula: -C(=S)NRM, the group represented by formula:-C(=S)NM₂, the group represented by formula: -B(OM)₂, the group represented by formula: -BR₃M, the group represented by formula: -B(OR)₃M, the group represented by formula:-SO₃M, the group represented by formula: -SO₂M, the group represented by formula: -NRC(=O)OM, the group represented by formula: -NRC(=O)SM, the group represented by formula:-NRC(=S)OM, the group represented by formula: -NRC(=S)SM, the group represented by formula: -OC(=O)NM₂, the group represented by formula: -OC(=O)NRM, the group represented by formula: -OC(=S)NM₂, the group represented by formula:-OC(=S)NRM, the group represented by formula: -SC(=O)NM₂, the group represented by formula: -SC(=O)NRM, the group represented by formula: -SC(=S)NM₂, the group represented by formula: -SC(=S)NRM, the group represented by formula:-NRC(=O)NM₂, the group represented by formula: -NRC(=O)NRM, the group represented by formula: -NRC(=S)NM₂, and the group represented by formula: -NRC(=S)NRM, M represents a metal cation or an ammonium cation optionally having a substituent, and R represents a hydrogen atom or the hydrocarbyl group optionally having a substituent.

The metal cation is preferably a monovalent, divalent, or trivalent ion. Examples thereof may include an ion of a metal such as Li, Na, K, Cs, Be, Mg, Ca, Ba, Ag, Al, Bi, Cu, Fe, Ga, Mn, Pb, Sn, Ti, V, W, Y, Yb, Zn and Zr. Among them, an ion of Li, Na, K or Cs is preferred.

Examples of the substituent that the ammonium cation may have may include an alkyl group having 1 to 10 carbon atoms such as a methyl group, an ethyl group, a propyl group, an isopropyl group, a butyl group, an isobutyl group, a sec-butyl group, and a tert-butyl group.

In the group represented by formula: -SM, the group represented by formula: -C(=O)SM, the group represented by formula: -CS₂M, the group represented by formula: -OM, the group represented by formula: -CO₂M, the group represented by formula: -NM₂, the group represented by formula: -NHM, the group represented by formula: -NRM, the group represented by formula: -PO₃M, the group represented by formula: -OP(=O)(OM)₂, the group represented by formula: -P(=O)(OM)₂, the group represented by formula: -C(=O)NM₂, the group represented by formula: -C(=O)NHM, the group represented by formula: -C(=O)NRM, the group represented by formula: -C(=S)NHM, the group represented by formula: -C(=S)NRM, the group represented by formula:-C(=S)NM₂, the group represented by formula: -B(OM)₂, the group represented by formula: -BR₃M, the group represented by formula: -B(OR)₃M, the group represented by formula:-SO₃M, the group represented by formula: -SO₂M, the group represented by formula: -NRC(=O)OM, the group represented by formula: -NRC(=O)SM, the group represented by formula:-NRC(=S)OM, the group represented by formula: -NRC(=S)SM, the group represented by formula: -OC(=O)NM₂, the group represented by formula: -OC(=O)NRM, the group represented by formula: -OC(=S)NM₂, the group represented by formula:-OC(=S)NRM, the group represented by formula: -SC(=O)NM₂, the group represented by formula: -SC(=O)NRM, the group represented by formula: -SC(=S)NM₂, the group represented by formula: -SC(=S)NRM, the group represented by formula:-NRC(=O)NM₂, the group represented by formula: -NRC(=O)NRM, the group represented by formula: -NRC(=S)NM₂, and the group represented by formula: -NRC(=S)NRM, a metal cation other than M may be included, or an anion may be included so that the charge of the entire group is neutralized. In this case, the metal cation other than M is the same as the above mentioned metal cations.

Examples of the anion may include F⁻, Cl⁻, Br⁻, I⁻ , OH⁻, ClO⁻, ClO₂⁻, ClO₃⁻, ClO₄⁻, SCN⁻, CN⁻, NO₃⁻, SO₄²⁻, HSO₄⁻, PO₄³⁻, HPO₄²⁻, H₂PO₄⁻, BF₄⁻, PF₆⁻, CH₃SO₃⁻, CF₃SO₃⁻, [(CF₃SO₂)₂N]⁻ , tetrakis(imidazolyl)borate anion, 8-quinolinolato anion, 2-methyl-8-quinolinolato anion, and 2-phenyl-8-quinolinolato anion.

In the group represented by formula: -NR₃M', the group represented by formula: -PR₃M', the group represented by formula: -OR₂M', the group represented by formula:-SR₂M', and the group represented by formula: -IRM', R represents a hydrogen atom or the hydrocarbyl group optionally having a substituent, and M' represents an anion. This anion is the same as the above.

The ammonium cation optionally having a substituent indicated by M includes an ammonium cation having a cationized nitrogen atom within a heterocycle. Examples thereof may include an atomic group remaining after removing a hydrogen atom from a heterocycle represented by any one of Formulae (n-1) to (n-13) below. These heterocycles may have a substituent. Examples of the substituent may include those described above with respect to Ar¹ and Ar².

For easy synthesis, a heterocycle represented by Formula (n-1), (n-5), (n-7), (n-9), (n-11) or (n-13) is preferred; a heterocycle represented by Formula (n-1), (n-5), (n-11) or (n-13) is more preferred; and a heterocycle represented by Formula (n-1), (n-5) or (n-13) is further preferred.

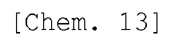

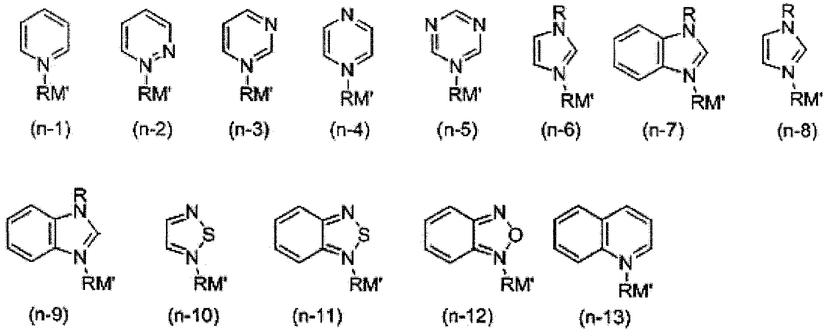

In Formulae, R represents a hydrogen atom or a hydrocarbyl group optionally having a substituent, and M' represents an anion. R and M' are the same as the above.)

Because good adsorptivity and good dispersibility in a solvent are obtained, a hetero atom-containing group represented by X¹ and X² in Formulae (I) and (II) is preferably a monovalent group containing at least one hetero atom selected from the group consisting of a sulfur atom, an oxygen atom, a nitrogen atom and a phosphorus atom; more preferably a monovalent group selected from the group (referred to as "Group 1a") consisting of a mercapto group, a mercaptocarbonyl group, a mercaptothiocarbonyl group, a hydrocarbylthio group optionally having a substituent, a hydrocarbylthiocarbonyl group optionally having a substituent, a hydrocarbyldithio group optionally having a substituent, a hydroxyl group, a hydrocarbyloxy group optionally having a substituent, a carboxyl group, a hydrocarbylcarbonyl group optionally having a substituent, a cyano group, an amino group, a hydrocarbylamino group optionally having a substituent, a dihydrocarbylamino group optionally having a substituent, a phosphino group, a hydrocarbylphosphino group optionally having a substituent, a dihydrocarbylphosphino group optionally having a substituent, a group represented by formula: -P(=O)(OH)₂, a sulfo group, and a monovalent heterocyclic group; further preferably a mercapto group, a hydrocarbylthio group optionally having a substituent, a hydrocarbyldithio group optionally having a substituent, a hydroxyl group, a hydrocarbyloxy group optionally having a substituent, a carboxyl group, a hydrocarbylcarbonyl group optionally having a substituent, a cyano group, an amino group, a hydrocarbylamino group optionally having a substituent, a dihydrocarbylamino group optionally having a substituent, a group represented by formula: -P(=O)(OH)₂, a sulfo group, or a monovalent heterocyclic group; particularly preferably a mercapto group, a hydroxyl group, a carboxyl group, a cyano group, an amino group, a group represented by formula: -P(=O)(OH)₂, a sulfo group, or a monovalent heterocyclic group; and more particularly preferably a mercapto group, a carboxyl group or a pyridyl group is more particularly preferred. These groups may be bonded together to form a ring.

Also, a preferred group in terms of adsorptivity and dispersibility in a solvent may be a monovalent group selected from the group (referred to as "Group 1b") consisting of a halogen atom, a formyl group, a hydrocarbyloxycarbonyl group optionally having a substituent, a hydrocarbylcarbonyloxy group optionally having a substituent, a nitro group, a group represented by formula: -OP(=O)(OH)₂, a carbamoyl group, a hydrocarbylcarbamoyl group optionally having a substituent, a dihydrocarbylcarbamoyl group optionally having a substituent, a group represented by formula: -C(=S)NR₂, a group represented by formula: -B(OH)₂, a group represented by formula: -BR₂, a boric acid ester residue, a group represented by formula: -Si(OR)₃, a hydrocarbylsulfo group optionally having a substituent, a hydrocarbylsulfonyl group optionally having a substituent, a sulfino group, a hydrocarbylsulfino group optionally having a substituent, a group represented by formula: -NRC(=O)OR, a group represented by formula: -NRC(=O)SR, a group represented by formula: -NRC(=S)OR, a group represented by formula:-NRC(=S)SR, a group represented by formula: -OC(=O)NR₂, a group represented by formula: -SC(=O)NR₂, a group represented by formula: -OC(=S)NR₂, a group represented by formula: -SC(=S)NR₂, a group represented by formula:-NRC(=O)NR₂, and a group represented by formula:-NRC(=S)NR₂.

These two groups (Group 1a and Group 1b), to which a preferred groups belong in terms of adsorptivity and dispersibility in a solvent, are collectively referred to as Group 1.

Because a metallic composite having excellent electrical conductivity and charge injection property is obtained, a hetero atom-containing group represented by X¹ and X² is preferably a monovalent group selected from the group (referred to as "Group 2") consisting of a hydrocarbyl group having two or more ether bonds, a hydrocarbyl group having two or more ester bonds, a hydrocarbyl group having two or more amido bonds, a group represented by formula: -SM, a group represented by formula: -C(=O)SM, a group represented by formula: -CS₂M, a group represented by formula: -OM, a group represented by formula: -CO₂M, a group represented by formula: -NM₂, a group represented by formula: -NHM, a group represented by formula: -NRM, a group represented by formula: -PO₃M, a group represented by formula: -OP(=O)(OM)₂, a group represented by formula: -P(=O)(OM)₂, a group represented by formula: -C(=O)NM₂, a group represented by formula:-C(=O)NHM, a group represented by formula: -C(=O)NRM, a group represented by formula: -C(=S)NHM, a group represented by formula: -C(=S)NRM, a group represented by formula: -C(=S)NM₂, a group represented by formula:-B(OM)₂, a group represented by formula: -BR₃M, a group represented by formula: -B(OR)₃M, a group represented by formula: -SO₃M, a group represented by formula: -SO₂M, a group represented by formula: -NRC(=O)OM, a group represented by formula: -NRC(=O)SM, a group represented by formula: -NRC(=S)OM, a group represented by formula:-NRC(=S)SM, a group represented by formula: -OC(=O)NM₂, a group represented by formula: -OC(=O)NRM, a group represented by formula: -OC(=S)NM₂, a group represented by formula: -OC(=S)NRM, a group represented by formula:-SC(=O)NM₂, a group represented by formula: -SC(=O)NRM, a group represented by formula: -SC(=S)NM₂, a group represented by formula: -SC(=S)NRM, a group represented by formula: -NRC(=O)NM₂, a group represented by formula:-NRC(=O)NRM, a group represented by formula: -NRC(=S)NM₂, a group represented by formula: -NRC(=S)NRM, a group represented by formula: -NR₃M', a group represented by formula: -PR₃M', a group represented by formula: -OR₂M', a group represented by formula: -SR₂M', a group represented by formula: -IRM', and a heterocyclic group having a cationized nitrogen atom within a heterocycle. These groups may be bonded together to form a ring. Among these, a group represented by formula: -OM, a group represented by formula: -CO₂M, a group represented by formula: -PO₃M₂, a group represented by formula: -SO₃M, or a group represented by formula: -NR₃M' is more preferred; a group represented by formula: -CO₂M, a group represented by formula: -PO₃M₂, a group represented by formula: -SO₃M, or a group represented by formula: -NR₃M' is further preferred; a group represented by formula: -CO₂M, a group represented by formula: -PO₃M₂, or a group represented by formula: -NR₃M' is particularly preferred; and a group represented by formula: -CO₂M is more particularly preferred.

Here, M, R and M' have the same meaning as the above.

Examples of an (m¹+1) valent group represented by R¹ in Formula (I) may include an atomic group remaining after removing m¹ hydrogen atoms from the hydrocarbyl group optionally having a substituent or from the monovalent heterocyclic group, and a group represented by formula -O-(R'O)ₘ-, wherein m¹ = 1.

The (m¹+1) valent group represented by R¹ is preferably an atomic group remaining after removing m¹ hydrogen atoms from an alkyl group optionally having a substituent, an atomic group remaining after removing m¹ hydrogen atoms from an aryl group optionally having a substituent, an atomic group remaining after removing m¹ hydrogen atoms from a monovalent heterocyclic group, an atomic group remaining after removing m¹ hydrogen atoms from an alkyl group substituted with a monovalent heterocyclic group, or an atomic group remaining after removing m¹ hydrogen atoms from an aryl group substituted with a monovalent heterocyclic group; more preferably an atomic group remaining after removing m¹ hydrogen atoms from an alkyl group having 1 to 6 carbon atoms, an atomic group remaining after removing m¹ hydrogen atoms from a phenyl group, an atomic group remaining after removing m¹ hydrogen atoms from a triazinyl group, an atomic group remaining after removing m¹ hydrogen atom from an alkyl group substituted with a triazinyl group, or an atomic group remaining after removing m¹ hydrogen atoms from an aryl group substituted with a triazinyl group; and further preferably an atomic group remaining after removing m¹ hydrogen atoms from a hexyl group, an atomic group remaining after removing m¹ hydrogen atoms from a phenyl group, or an atomic group remaining after removing m¹ hydrogen atoms from a phenyl group substituted with a triazinyl group.

Examples of an (m²+1) valent group represented by R² in Formula (II) may include an atomic group remaining after removing m² hydrogen atoms from the hydrocarbyl group optionally having a substituent or from the monovalent heterocyclic group, and a group represented by formula -O-(R'O)ₘ-, wherein m² = 1. The (m²+1) valent group represented by R² is preferably an atomic group remaining after removing m² hydrogen atoms from an alkyl group optionally having a substituent, an atomic group remaining after removing m² hydrogen atoms from an aryl group optionally having a substituent, an atomic group remaining after removing m² hydrogen atoms from a monovalent heterocyclic group, an atomic group remaining after removing m² hydrogen atoms from an alkyl group substituted with a monovalent heterocyclic group, or an atomic group remaining after removing m² hydrogen atoms from an aryl group substituted with a monovalent heterocyclic group; more preferably an atomic group remaining after removing m² hydrogen atoms from an alkyl group having 1 to 6 carbon atoms, an atomic group remaining after removing m² hydrogen atoms from a phenyl group, an atomic group remaining after removing m² hydrogen atoms from a triazinyl group, an atomic group remaining after removing m² hydrogen atoms from an alkyl group substituted with a triazinyl group, or an atomic group remaining after removing m² hydrogen atoms from an aryl group substituted with a triazinyl group; and further preferably an atomic group remaining after removing m² hydrogen atoms from a hexyl group, an atomic group remaining after removing m² hydrogen atoms from a phenyl group, or an atomic group remaining after removing m² hydrogen atoms from a phenyl group substituted with a triazinyl group.

In the above formulae, the definition, specific examples and preferred examples of R' are as described above. m represents an integer of 1 or more, preferably 1 to 20, more preferably 3 to 20, further preferably 3 to 15, and still further preferably 6 to 10.

The conjugated compound preferably has at least one group selected from the Group 1 and at least one group selected from the Group 2.

The conjugated compound preferably has at least one group selected from the Group 1 or at least one repeating unit having a group selected from the Group 1, and at least one group selected from the Group 2 or at least one repeating unit having a group selected from the Group 2.

In particular, the conjugated compound preferably has at least one repeating unit having a group selected from the Group 1, and at least one repeating unit having a group selected from the Group 2.

Specific examples of the conjugated compound used in the present invention may include a conjugated compound having one or more repeating units selected from the group consisting of repeating units (divalent groups) represented by Formulae (a-1) to (a-35), (b-1) to (b-39), (c-1) to (c-37), (d-1) to (d-47), (e-1) to (e-16), (f-1) to (f-35), and (g-1) to (g-24) below. In these Formulae, n³ represents an integer of 2 or more, preferably an integer of 2 to 30, more preferably an integer of 2 to 20, and further preferably an integer of 6 to 10. n⁴ represents an integer of 1 or more, preferably an integer of 1 to 10, and more preferably an integer of 2 to 6. In these Formulae, R represents a hydrogen atom, or the above-described hydrocarbyl group optionally having a substituent, and is preferably an alkyl group having 1 to 6 carbon atoms, and more preferably a methyl group, an ethyl group, a propyl group or a butyl group.

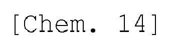

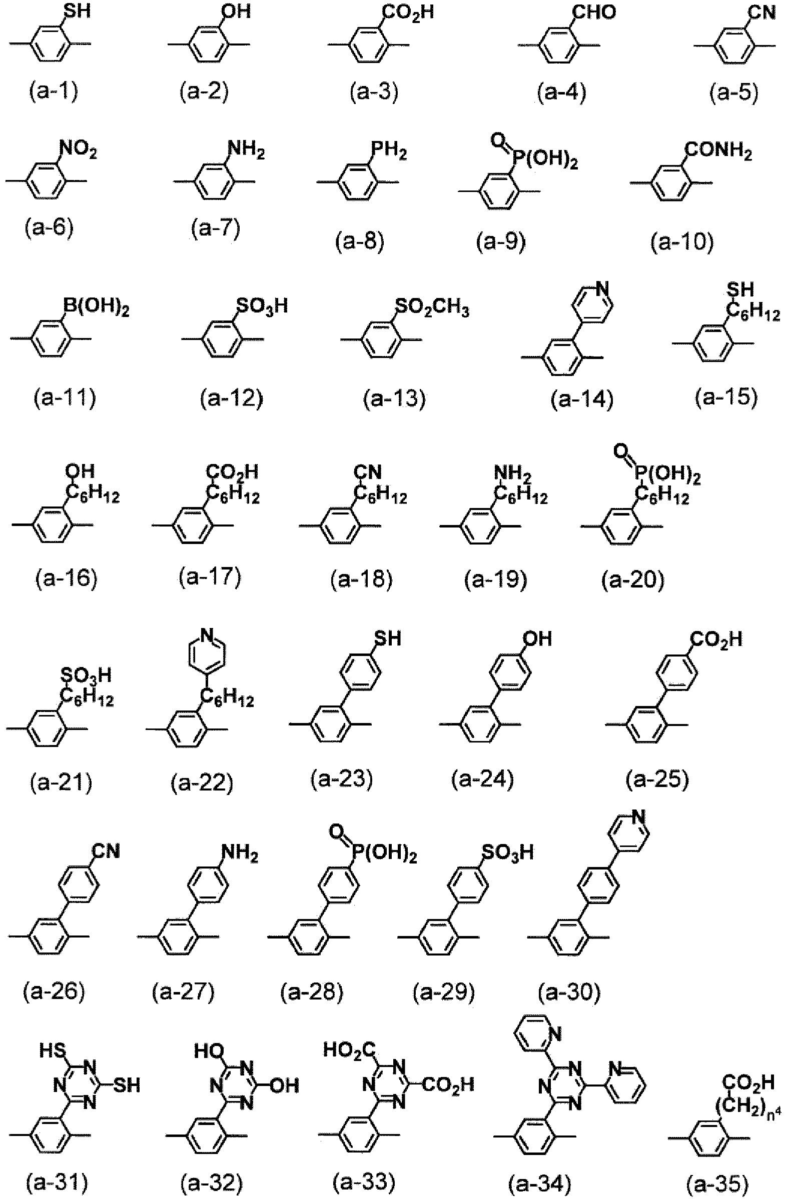

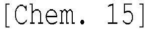

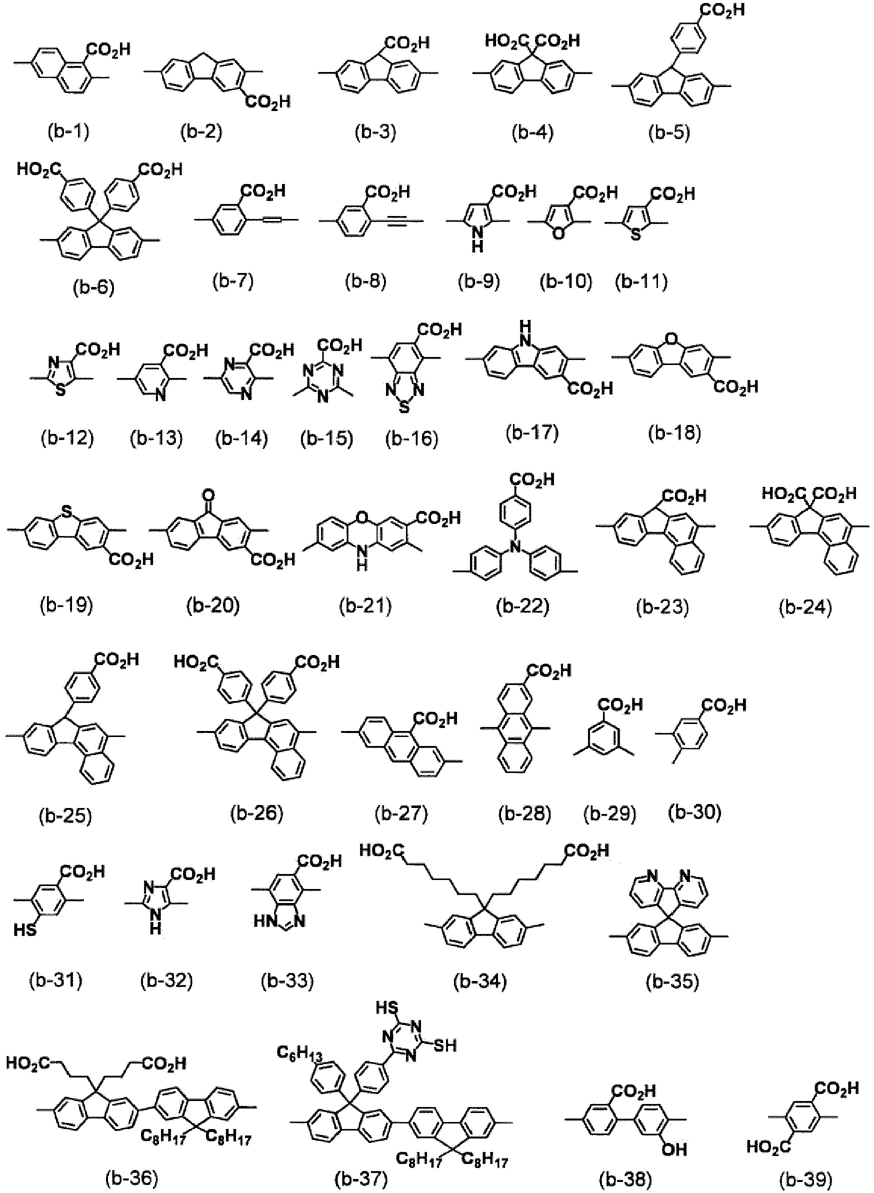

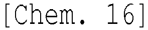

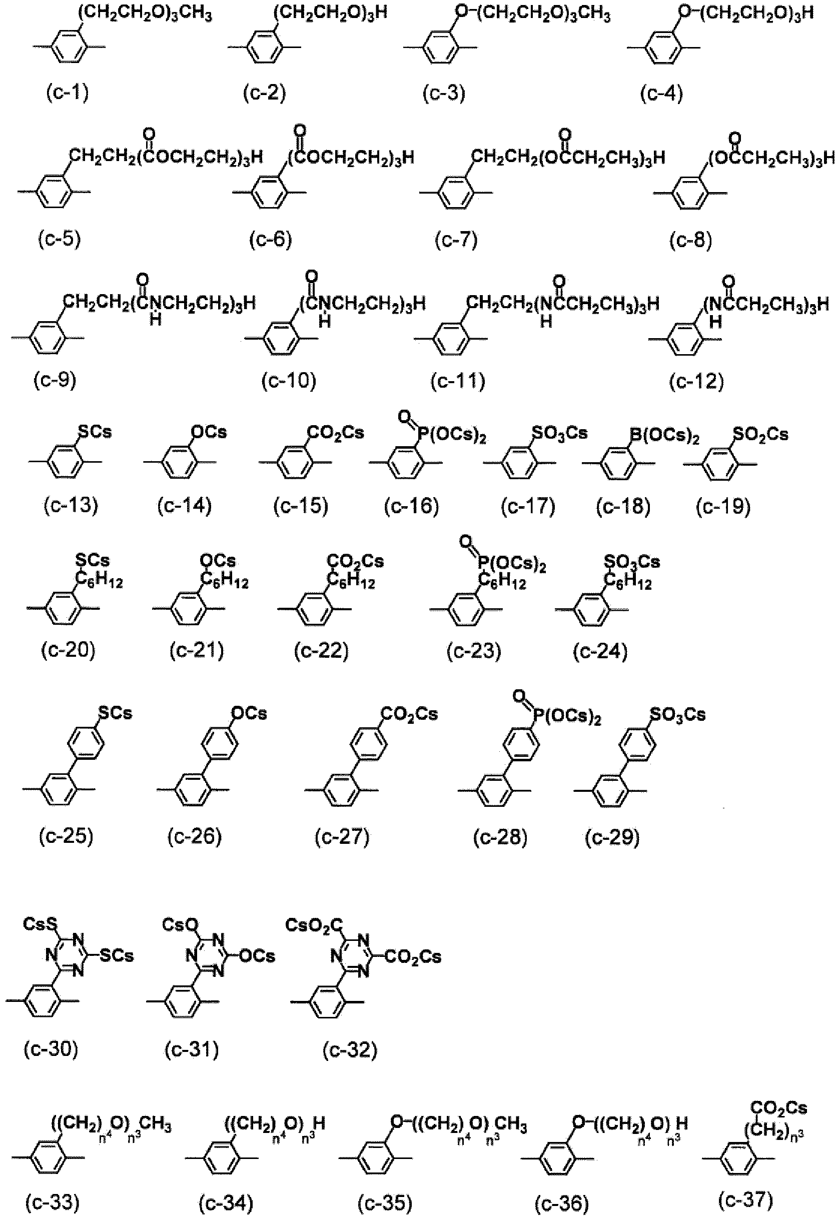

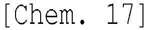

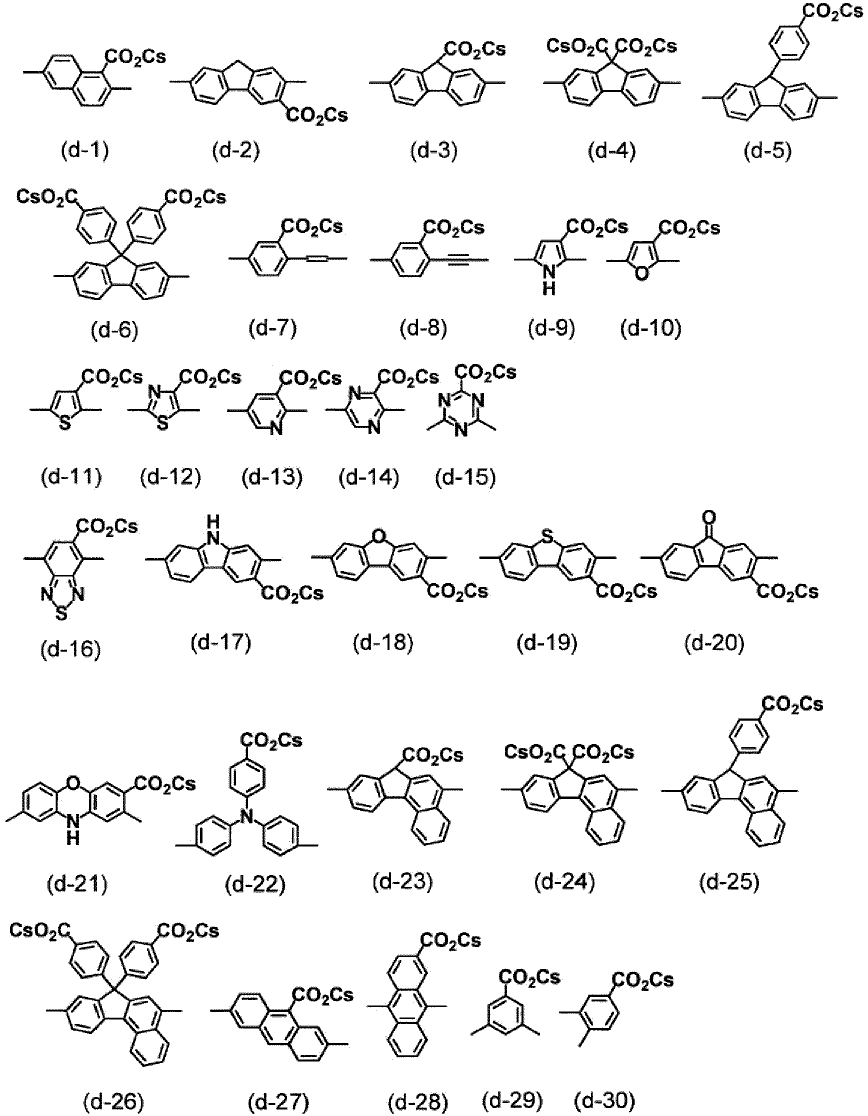

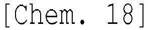

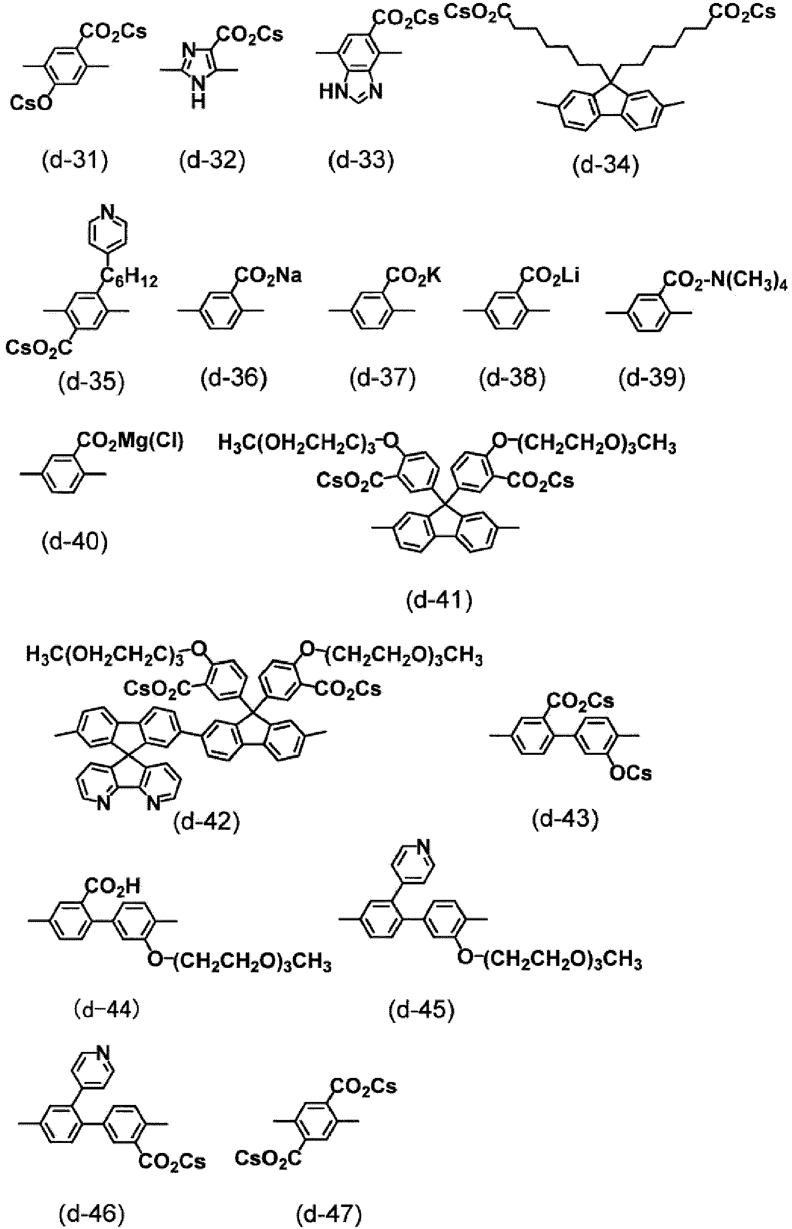

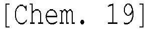

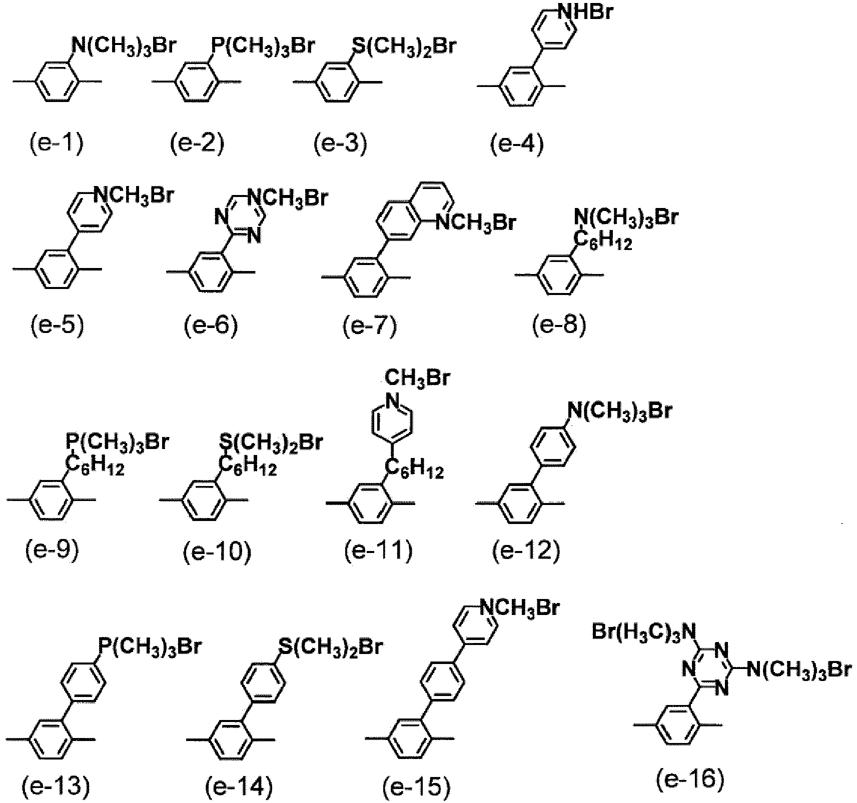

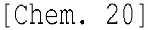

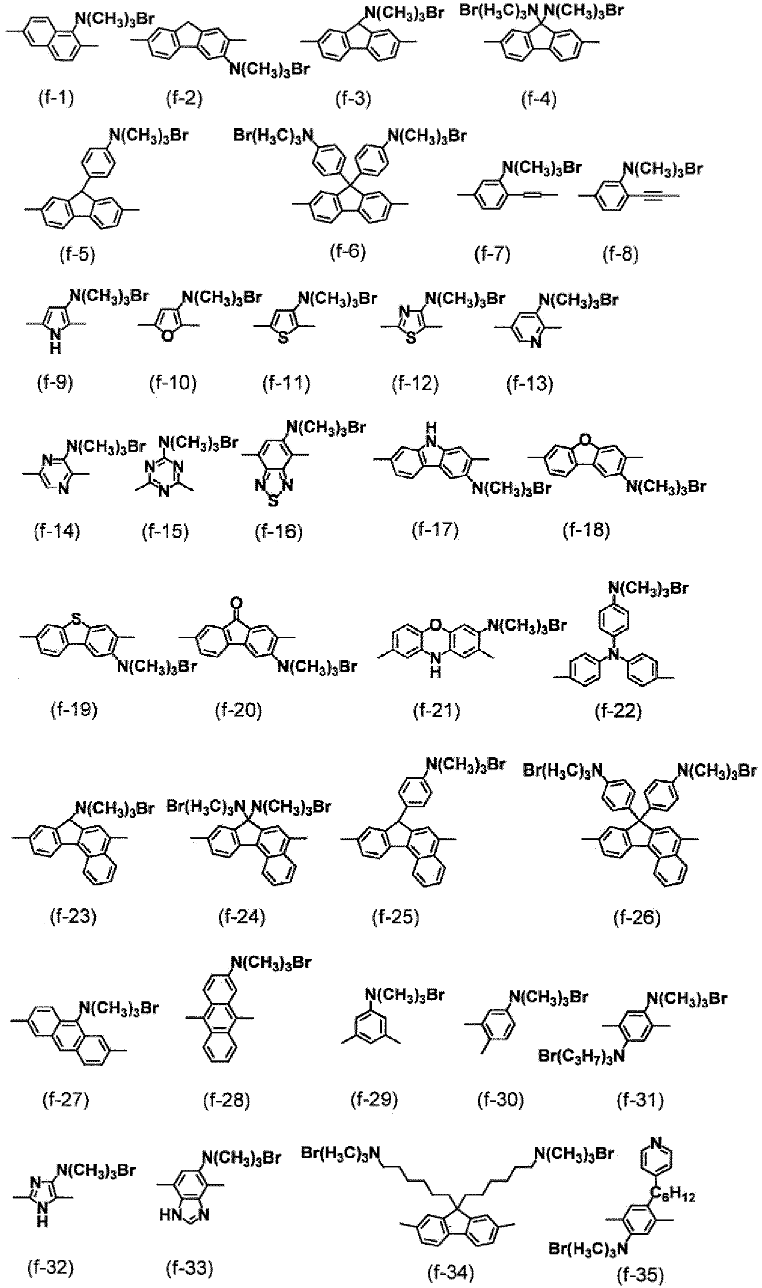

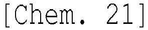

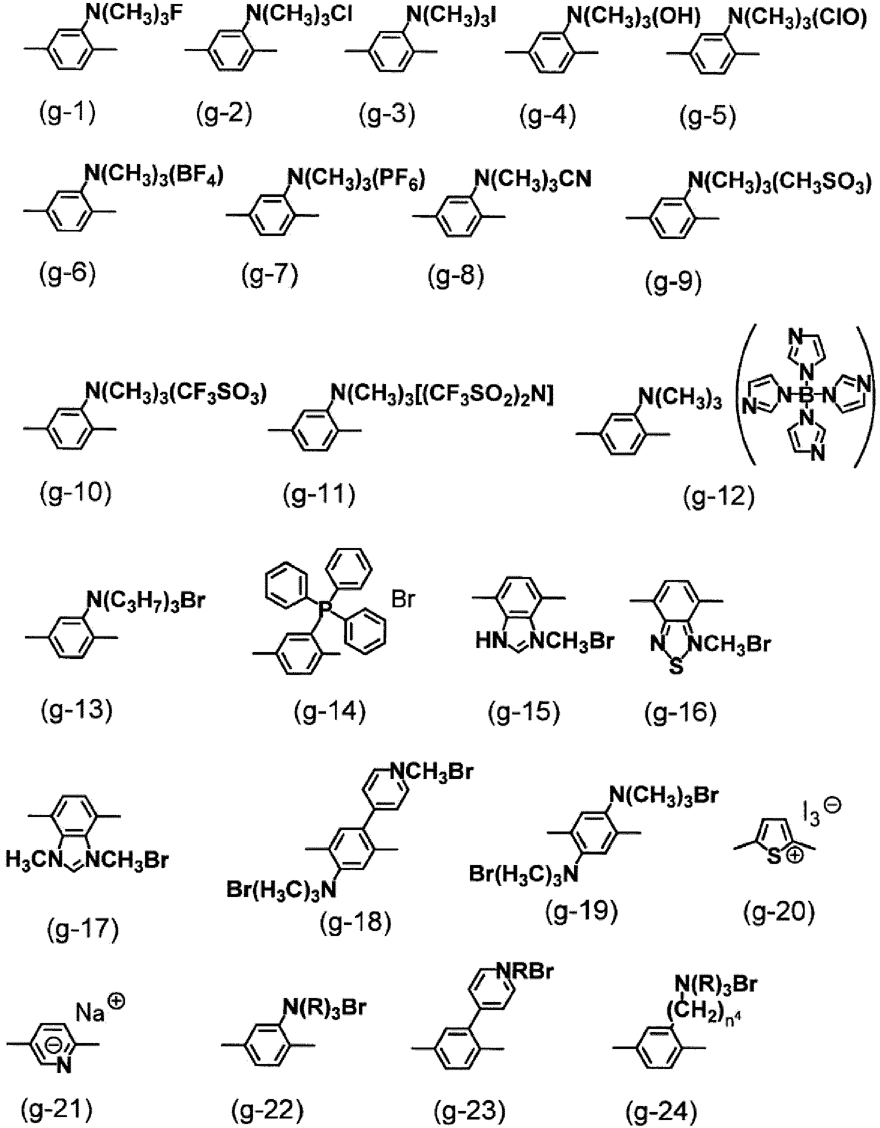

Because good adsorptivity, dispersibility in a solvent, electrical conductivity and charge injection property are obtained, the conjugated compound is preferably a conjugated compound having one or more repeating units selected from the group consisting of repeating units represented by Formulae (a-1) to (a-7), (a-10) to (a-19), (a-21) to (a-27), (a-29) to (a-35), (b-1) to (b-6), (b-9), (b-11) to (b-16), (b-22), (b-31) to (b-39), (c-1) to (c-15), (c-17), (c-20) to (c-22), (c-24) to (c-27), (c-29), (c-30) to (c-37), (d-1) to (d-6), (d-9), (d-11) to (d-16), (d-22), (d-31) to (d-39), (d-41) to (d-47), (e-1) to (e-3), (e-5) to (e-16), (f-1) to (f-6), (f-9), (f-11) to (f-16), (f-22), (f-31) to (f-35), (g-1) to (g-13), and (g-16) to (g-24); more preferably a conjugated compound having one or more repeating units selected from the group consisting of repeating units represented by Formulae (a-1) to (a-3), (a-5), (a-7), (a-10), (a-12), (a-14) to (a-19), (a-21) to (a-27), (a-29) to (a-33), (b-1) to (b-6), (b-9), (b-11), (b-13), (b-15), (b-16), (b-22), (b-34) to (b-39), (c-1) to (c-15), (c-17), (c-20) to (c-22), (c-24) to (c-27), (c-29) to (c-32), (c-34) to (c-37), (d-1) to (d-6), (d-9), (d-11), (d-13), (d-15), (d-16), (d-22), (d-31) to (d-39), (d-41), (d-42), (d-47), (e-1), (e-5) to (e-8), (e-11), (e-12), (e-15), (e-16), (f-1) to (f-6), (f-9), (f-11), (f-13), (f-15), (f-16), (f-22), (f-31), (f-34), (f-35), (g-1) to (g-3), (g-6) to (g-13), and (g-16) to (g-24); further preferably a conjugated compound having one or more repeating units selected from the group consisting of repeating units represented by Formulae (a-1), (a-3), (a-7), (a-10), (a-14), (a-15), (a-17), (a-19), (a-22), (a-23), (a-25) to (a-27), (a-30), (a-31), (b-1), (b-2), (b-5), (b-6), (b-9), (b-11), (b-13), (b-22), (b-34) to (b-39), (c-1) to (c-4), (c-13)(c-15), (c-20) to (c-22), (c-25) to (c-27), (c-30) to (c-32), (d-1), (d-2), (d-5), (d-6), (d-9), (d-11), (d-13), (d-22), (d-31) to (d-38), (d-41), (d-42), (d-47), (e-1), (e-5), (e-7), (e-8), (e-11), (e-12), (e-15), (e-16), (f-1), (f-2), (f-5), (f-6), (f-9), (f-11), (f-13), (f-22), (f-31), (f-34), (f-35), (g-1) to (g-3), (g-6), (g-7), (g-9) to (g-13), and (g-18) to (g-21); particularly preferably a conjugated compound having one or more repeating units selected from the group consisting of repeating units represented by Formulae (a-3), (a-14), (a-22), (a-17), (a-25), (a-30), (a-31), (b-6), (b-22), (b-34) to (b-37), (b-39), (c-1) to (c-4), (c-15), (c-22), (c-27), (d-6), (d-22), (d-34) to (d-38), (d-41), (d-42), (e-1), (e-5), (e-8), (e-12), (e-15), (f-6), (f-34), (g-2), (g-6), (g-7), (g-10) to (g-12), and (g-18) to (g-21); more particularly preferably a conjugated compound having one or more repeating units selected from the group consisting of repeating units represented by Formulae (b-6), (b-34), (b-35), (b-37), (c-1) to (c-4), (d-6), (d-34), (d-36) to (d-38), (d-41), (d-42), (f-6), (f-34), (g-2), and (g-10) to (g-12); and still further preferably a conjugated compound having one or more repeating units selected from the group consisting of repeating units represented by Formulae (b-6), (b-34), (b-37), (c-1) to (c-4), (d-38), (d-41), and (d-42) .

Examples of the group represented by Formula (I) may include a group in which one of two bonds in the above example of a repeating unit is substituted with a hydrogen atom.

When the conjugated compound is a compound that has a group represented by Formula (I), or a repeating unit represented by Formula (II), or both of them, the conjugated compound may further have other repeating unit than the repeating unit represented by Formula (II).

Examples of the other repeating unit may include an atomic group remaining after removing two hydrogen atoms that are directly bonded to carbon atoms constituting a ring from the compound having an aromatic ring (the above Formulae (1) to (95)), an atomic group remaining after removing one hydrogen atom from the hydrocarbyl group, and an atomic group remaining after removing one hydrogen atom that is directly bonded to a carbon atom constituting a ring from the monovalent heterocyclic group. The other repeating unit is preferably an atomic group remaining after removing two hydrogen atoms that are directly bonded to carbon atoms constituting a ring from the compound having an aromatic ring, or an atomic group remaining after removing one hydrogen atom from the hydrocarbyl group; and more preferably an atomic group remaining after removing two hydrogen atoms that are directly bonded to carbon atoms constituting a ring from the compound having an aromatic ring. These atomic groups may have a substituent. The repeating unit represented by Formula (II) may be bonded via a divalent group represented by any one of Formulae (h-1) to (h-19) below.

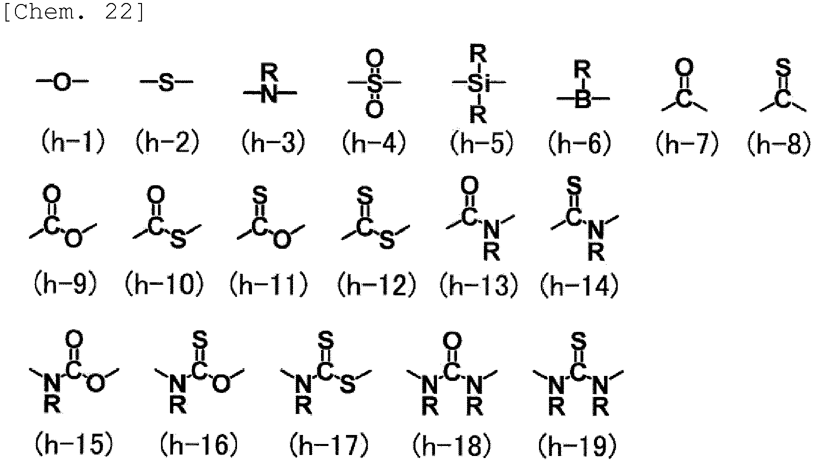

In Formulae, R represents a hydrogen atom, or the hydrocarbyl group optionally having a substituent.

A substituent that the atomic group of the other repeating unit may have may be the same group as the substituent that the compound having an aromatic ring may have.

When the other repeating unit is included, it is preferable that the other repeating unit is introduced within a range of not inhibiting conjugation of the conjugated compound.

Preferred aspects of the conjugated compound are 1. to 3. below.
1. A compound in which a bonding hand of Ar₁ in a group represented by Formula (I) is bonded to a hydrogen atom or a halogen atom
2. A compound having a repeating unit represented by Formula (II)
3. A compound in which a group represented by Formula (I) is bonded to a repeating unit represented by Formula (II)

Among these, the conjugated compound of the above 1. or 2. is more preferred, and the conjugated compound of the above 2. is further preferred.

A dopant can be doped in the conjugated compound used in the present invention. The dopant is preferably used in a proportion of 1 to 50 parts by weight per 100 parts by weight of the conjugated compound.

Examples of the dopant may include halogens, halogen compounds, Lewis acids, protonic acids, nitrile compounds, organic metal compounds, alkali metals and alkaline earth metals.

Examples of the halogens may include chlorine, bromine and iodine. Examples of the halogen compounds may include iodine chloride, iodine bromide and iodine fluoride. Examples of the Lewis acids may include phosphorus pentafluoride, arsenic pentafluoride, antimony pentafluoride, boron trifluoride, boron trichloride, boron tribromide and anhydrous sulfuric acid. Examples of the protonic acids may include: inorganic acids such as hydrochloric acid, sulfuric acid, nitric acid, phosphoric acid, fluoroboric acid, hydrofluoric acid and perchloric acid; and organic acids such as carboxylic acid and sulfonic acid. The organic carboxylic acid may be any of aliphatic carboxylic acid, aromatic carboxylic acid and cycloaliphatic carboxylic acid. Examples thereof may include formic acid, acetic acid, oxalic acid, benzoic acid, phthalic acid, maleic acid, fumaric acid, malonic acid, tartaric acid, citric acid, lactic acid, succinic acid, monochloroacetic acid, dichloroacetic acid, trichloroacetic acid, trifluoroacetic acid, nitroacetic acid and triphenylacetic acid. The organic sulfonic acid may be any of aliphatic sulfonic acid, aromatic sulfonic acid and cycloaliphatic sulfonic acid. Examples thereof may include: a sulfonic acid compound containing one sulfo group in the molecule thereof, such as benzenesulfonic acid, p-toluenesulfonic acid, xylenesulfonic acid, naphthalenesulfonic acid, decylbenzensulfonic acid, dodecylbenzenesulfonic acid, pentadecylbenzenesulfonic acid, methanesulfonic acid, ethanesulfonic acid, 1-propanesulfonic acid, 1-butanesulfonic acid, 1-hexanesulfonic acid, 1-heptanesulfonic acid, 1-octanesulfonic acid, 1-nonanesulfonic acid, 1-decanesulfonic acid, 1-dodecanesulfonic acid, vinylsulfonic acid, styrenesulfonic acid and allylsulfonic acid; and a sulfonic acid compound containing a plurality of sulfo groups in the molecule thereof, such as ethanedisulfonic acid, butanedisulfonic acid, pentanedisulfonic acid, decanedisulfonic acid, benzenedisulfonic acid, naphthalenedisulfonic acid, toluenedisulfonic acid, dimethylbenzenedisulfonic acid, diethylbenzenedisulfonic acid, methylnaphthalenedisulfonic acid and ethylnaphthalenedisulfonic acid.

For the dopant used in the present invention, the organic acid may be a polymer acid. Examples of the polymer acid may include polyvinylsulfonic acid, polystyrenesulfonic acid, sulfonated styrene-butadiene copolymer, polyallylsulfonic acid, polymethallylsulfonic acid, poly-2-acrylamide-2-methylpropanesulfonic acid and polyisoprenesulfonic acid. The nitrile compounds may be a compound containing two or more cyano groups in a conjugated bond. Examples of such a compound may include tetracyanoethylene, tetracyanoethylene oxide, tetracyanobenzene, tetracyanoquinodimethane and tetracyanoazanaphthalene. Examples of the organic metal compounds may include tris(4-bromophenyl)ammonium hexachloroantimonate, bis(dithiobenzyl)nickel, bis(tetrabutylammonium)bis(1,3-dithiol-2-thion-4,5-dithiolato)zinc complex, and tetrabutylammonium bis(1,3-dithiol-2-thion-4,5-dithiolato)nickel(III) complex. Examples of the alkali metals may include Li, Na, K, Rb and Cs. Examples of the alkaline earth metals may include Be, Mg, Ca, Sr and Ba.

In the metallic composite used in the present invention, an adsorbed conjugated compound can be detected by performing an analysis such as a spectroscopic analysis, a thermal analysis, a mass analysis and an elemental analysis.

Examples of the spectroscopic analysis may include nuclear magnetic resonance spectrometry, infrared spectroscopy, Raman spectroscopy, atomic absorption spectrometry, arc discharge emission spectrometry, spark discharge optical emission spectrometry, inductively coupled plasma emission spectrometry, X-ray photoelectron spectroscopy, fluorescent X-ray spectroscopy, ultraviolet-visible spectroscopy and fluorescence spectrometry. Examples of the thermal analysis may include thermogravimetry, differential thermal analysis and differential scanning calorimetry. Examples of the mass analysis may include mass spectrometry using various ionization methods. The conjugated compound adsorbed to the metallic composite can be detected by performing an analysis such as the above-described spectroscopic analysis, thermal analysis, mass analysis and elemental analysis.

In the metallic composite used in the present invention, it is preferable that a peak measured by X-ray photoelectron spectroscopy for one or more atoms existing in the metallic composite comprises a peak attributed to an atom in the conjugated compound having a polystyrene equivalent number average molecular weight of 1.0 x 10³ to 5.0 x 10⁶ as measured by gel permeation chromatography. Here, a peak position of an atom measured by X-ray photoelectron spectroscopy is calibrated based on a peak position of a metal element of a metallic nanostructure that forms the metallic composite. For example, when the metallic nanostructure is a silver nanostructure, a peak position of Ag3d is used as a basis of calibration. The peak attributed to an atom in the conjugated compound means a peak attributed to an atom other than an atom existing in the metallic nanostructure and in a precursor of the metallic nanostructure. Here, the precursor of the metallic nanostructure means a compound in which a compound other than the conjugated compound is adsorbed to the metallic nanostructure. Examples of the precursor of the metallic nanostructure may include a metallic nanostructure having polyvinylpyrrolidone adsorbed thereto.

Prior to a measurement of a metallic composite by X-ray photoelectron spectroscopy, the metallic composite is washed five or more times with a solvent capable of dissolving the conjugated compound weakly attaching to the surface of the metallic composite and a solvent capable of dissolving other compound adsorbed to the metallic nanostructure. The washing can be performed by adding various solvents to the metallic composite, and then performing treatments such as stirring, shaking, ultrasonic dispersion, centrifugation, decantation, re-dispersion, dialysis, filtration and heating.

The conjugated compound used in the present invention has an orbital energy of a highest occupied molecular orbital (also referred to as a "HOMO") measured using a photoelectron spectrometer in the atmosphere of usually -4.5 eV or less, preferably -4.8 eV or less, more preferably -5.0 eV or less, further preferably -5.2 eV or less, and particularly preferably -5.3 eV or less. The HOMO can be measured by, for example, the method described in Examples shown later.

The orbital energy of a highest occupied molecular orbital is a value obtained by attaching "-(minus)" to a value of an ionization potential of the conjugated compound measured using a photoelectron spectrometer in the atmosphere.

The conjugated compound used in the present invention has an orbital energy of a lowest unoccupied molecular orbital (also referred to as a "LUMO") of usually -3.5 eV or more, preferably -3.2 eV or more, more preferably -2.9 eV or more, further preferably -2.8 eV or more, and particularly preferably -2.7 eV or more.

The orbital energy of a lowest unoccupied molecular orbital can be calculated by adding a value of a difference between the orbital energy (eV) of a highest occupied molecular orbital and the orbital energy (eV) of a lowest unoccupied molecular orbital, that can be obtained from a value at an absorption edge in a longer wavelength side of an absorption spectrum measured by an ultraviolet-visible-near-infrared spectrophotometer, to a value of the orbital energy (eV) of a highest occupied molecular orbital. The value of a difference between the orbital energy (eV) of a highest occupied molecular orbital and the orbital energy (eV) of a lowest unoccupied molecular orbital can be measured by, for example, the method described in Examples shown later.

The metallic composite used in the present invention is manufactured by, for example, a method including a step of mixing, in a solvent, a metallic nanostructure having an aspect ratio of 1.5 or more with the conjugated compound (hereinafter referred to as a "mixing step").

Alternatively, the metallic composite used in the present invention can be manufactured by producing a metallic nanostructure in the presence of the conjugated compound having a polystyrene equivalent number average molecular weight of 1.0 x 10³ to 5.0 x 10⁶ as measured by gel permeation chromatography.

As the metallic nanostructure for manufacturing the metallic composite used in the present invention, a metallic nanostructure of high purity may be used, or a metallic nanostructure to which a compound such as an inorganic porous material, polyacrylamide, polyvinylpyrrolidone and polyacrylic acid is adsorbed may be used. In the latter case, these compounds may be replaced with a conjugated compound having a polystyrene equivalent number average molecular weight of 1.0 x 10³ to 5.0 x 10⁶ as measured by gel permeation chromatography.

The solvent used for manufacturing the metallic composite used in the present invention is usually a solvent capable of dissolving the conjugated compound and not dissolving the metallic nanostructure. Specific examples of the solvent may include methanol, ethanol, benzyl alcohol, acetone, methylethylketone, dimethylformamide, dimethyl sulfoxide, ethyl acetate, toluene, xylene, orthodichlorobenzene, chloroform, tetrahydrofuran, hexane, benzene, diethyl ether, acetonitrile, acetic acid, water, propanol, butanol and N-methyl-2-pyrrolidone. Because the conjugated compound can be well dissolved therein, the solvent is preferably methanol, ethanol, benzyl alcohol, acetone, methylethylketone, dimethylformamide, dimethyl sulfoxide, ethyl acetate, toluene, xylene, chloroform, tetrahydrofuran, benzene, acetonitrile, propanol, butanol or N-methyl-2-pyrrolidone. The solvent may be used alone or in combination of two or more types thereof.

In the method for manufacturing the metallic composite, the mixing step is preferably performed by stirring, shaking, mechanical mixing, or a combination thereof.

Examples of the mechanical mixing applicable to the mixing step may include a method using a mixing-stirring apparatus, an ultrasonic disperser, and an ultrasonic washer, which are generally used. As the mixing-stirring apparatus, an apparatus in any type of pressure-type, shearing-type, ultrasonic-type, beads-type, rotor-type and the like may be used.

Because the solubility of the conjugated compound and the dispersibility of the metallic nanostructure are excellent, the concentration of the metallic nanostructure in a solvent during the mixing step in the method for manufacturing the metallic composite is set such that, when a solution obtained in the mixing step is 100 parts by weight, the content of the metallic nanostructure is preferably 0.0001 to 75 parts by weight, more preferably 0.001 to 50 parts by weight, further preferably 0.005 to 30 parts by weight, and particularly preferably 0.005 to 10 parts by weight.

Because the solubility of the conjugated compound and the dispersibility of the metallic nanostructure are excellent, the concentration of the conjugated compound in a solvent during the mixing step is set such that, when a solution obtained in the mixing step is 100 parts by weight, the content of the conjugated compound is preferably 0.0001 to 75 parts by weight, more preferably 0.001 to 50 parts by weight, further preferably 0.05 to 30 parts by weight, and particularly preferably 0.05 to 10 parts by weight.

Because the solubility and temperature stability of the conjugated compound are excellent, the temperature during the mixing step is preferably -78 to 200°C, more preferably 0 to 100°C, further preferably 10 to 80°C, and particularly preferably 20 to 60°C.

Because the affinity between the conjugated compound and the metallic nanostructure is excellent, the time of the mixing step is preferably within 1000 minutes, more preferably 1 to 1000 minutes, further preferably 10 to 900 minutes, and particularly preferably 30 to 800 minutes. When using a conjugated compound and a metallic nanostructure which have high affinity therebetween, the time of the mixing step becomes further shortened.

The method for manufacturing the metallic composite may include a step of purifying the metallic composite obtained in the mixing step (hereinafter referred to as a "purification step"), after the mixing step. The purification step can be performed by treatments such as ultrasonic dispersion, centrifugation, decantation, redispersion, dialysis, filtration, washing, heating and drying.

When the stability of the metallic nanostructure is sufficient, it is preferable that treatments of solvent addition, ultrasonic dispersion, centrifugation and decantation are conducted repeatedly in the purification step.

When the stability of the metallic nanostructure is low, it is preferable that treatments of solvent addition, and filtration and/or dialysis are conducted repeatedly in the purification step.

When the metallic composite is in a state of a dispersion liquid, the method for manufacturing the metallic composite may include a recovery step for obtaining the metallic composite in a solid state by treatments such as centrifugation, filtration and evaporation, after the mixing step.

In the mixing step and the purification step described above, additives such as a dispersion stabilizer, a surfactant, a viscosity modifier and a corrosion inhibitor may be further added.

The metallic composite composition used in the present invention contains an ionic compound in addition to the metallic composite. When the ionic compound is a conjugated compound, the molecular weight of the conjugated compound as an ionic compound is less than 200.

The ionic compound has a structure represented by Composition Formula (hh-1) below:

M^{m'+}ₐX'^{n'-}_{b} (hh-1)

wherein
M^{m'+} represents an alkali metal cation,
X'^{n'-} represents an anion,
a and b are each independently an integer of 1 or more, and when each of M^{m'+} and X'^{n'-} is plurally present, they each may be the same as or different from each other.

The ionic compound represented by Formula (hh-1) may contain hydration water, a ligand and the like.

In Formula (hh-1), a and b are, each independently, preferably an integer of 1 to 3, and more preferably 1 or 2. However, a combination of a and b does not create an imbalance in a charge of the whole compound represented by Formula (hh-1).

In Formula (hh-1), m' represents an integer of 1 or more. Examples of the alkali metal cation M^{m'+} may include Li⁺, Na⁺, K⁺, Rb⁺, Cs⁺ and Fr⁺. Among them, Li⁺, Na⁺, K⁺, Rb⁺ or Cs⁺ is preferred, and Cs⁺ is more preferred..

In Formula (hh-1), n' represents an integer of 1 or more. Examples of the anion X'^{n'}- may include F⁻, Cl⁻, Br⁻, I⁻, OH⁻, CN⁻, NO₃⁻, NO₂⁻, ClO⁻, ClO₂⁻, ClO₃⁻, ClO₄⁻, CrO₄²⁻, HSO₄⁻, SCN⁻, BF₄⁻, PF₆⁻, R³O⁻ (here, R³ represents a hydrocarbyl group optionally having a substituent), R⁴COO⁻ (here, R⁴ represents a hydrocarbyl group optionally having a substituent), R⁵SO₃⁻ (here, R⁵ represents a hydrocarbyl group optionally having a substituent), R⁶OCO₂⁻ (here, R⁶ represents a hydrocarbyl group optionally having a substituent), R⁷SO₂⁻ (here, R⁷ represents a hydrocarbyl group optionally having a substituent), R⁸S⁻ (here, R⁸ represents a hydrocarbyl group optionally having a substituent), B(R⁹)₄⁻ (here, R⁹ represents a hydrocarbyl group optionally having a substituent), CO₃²⁻, S²⁻, SO₄²⁻, S₂O₃²⁻, PO₄³⁻ and O²⁻. Among these, F⁻, Cl⁻, Br⁻, I⁻, OH⁻, NO₃⁻ , BF₄⁻, PF₆⁻, R³O⁻, R⁴COO⁻, R⁵O₃⁻, R⁶CO₃⁻, R⁷SO₂⁻, CO₃²⁻, SO₄²⁻ or PO₄³⁻ is preferred; F⁻, Cl⁻, Br⁻, I⁻, OH⁻, NO₃⁻, BF₄⁻, PF₆⁻, R³O⁻, R⁴COO⁻, R⁵O₃⁻, CO₃²⁻ or SO₄²⁻ is more preferred; F⁻, Cl⁻, Br⁻, I⁻, OH⁻, NO₃⁻, BF₄⁻, PF₆⁻, R⁴COO⁻, R⁵O₃⁻, CO₃²⁻ or SO₄²⁻ is further preferred; and F⁻, OH⁻, NO₃⁻, R⁴COO⁻ or CO₃²⁻ is particularly preferred..

When an ionic compound contains hydration water, the ionic compound preferably has a structure represented by Formula (hh-2) below.

M^{m'+}ₐX'^{n'-}_{b}·n"(H₂O) (hh-2)

In Formula (hh-2), n" represents an integer of 1 or more. The definition, specific examples and preferred examples of M^{m'+}, X'^{n'-}, a and b are as described above.

Examples of the ionic compound may include lithium fluoride, sodium fluoride, potassium fluoride, cesium fluoride, lithium hydroxide, sodium hydroxide, potassium hydroxide, cesium hydroxide, calcium hydroxide, lithium hydrogen carbonate, potassium hydrogen carbonate, cesium hydrogen carbonate, lithium carbonate, sodium carbonate, potassium carbonate, cesium carbonate, lithium acetate, sodium acetate, potassium acetate, cesium acetate lithium sulfate, sodium sulfate, potassium sulfate, cesium sulfate, potassium sulfite, sodium thiosulfate, lithium nitrate, potassium nitrate, sodium nitrate, cesium nitrate, potassium nitrite, lithium phosphate, tripotassium phosphate, trisodium phosphate, sodium hydrogen phosphate, sodium dihydrogen phosphate, potassium perchlorate, potassium permanganate, potassium chromate, potassium cyanate, potassium thiocyanate, sodium tetrafluoroborate, sodium hexafluorophosphate, lithium stearate, sodium stearate, cesium stearate, sodium myristate, disodium glutarate, dicesium glutarate, sodium 6-aminohexanoate, sodium thiomalate, cesium thiomalate, sodium 4-aminocyclohexanecarboxylate, cesium 4-aminocyclohexanecarboxylate, cesium 6-aminohexanoate, cesium 4-aminobenzenecarboxylate, sodium linoleate, sodium glutamate, lithium benzoate, sodium benzoate, potassium benzoate, cesium benzoate, lithium terephthalate, sodium terephthalate, potassium terephthalate, cesium terephthalate, lithium pyridinecarboxylate, sodium pyridinecarboxylate, potassium pyridinecarboxylate, cesium pyridinecarboxylate, cesium pyridinedicarboxylate, and cesium 2-2'-bipyridine-4-4'-dicarboxylate, .

Among these, lithium fluoride, sodium fluoride, potassium fluoride, cesium fluoride, lithium hydroxide, sodium hydroxide, potassium hydroxide, cesium hydroxide, sodium carbonate, potassium carbonate, cesium carbonate, lithium acetate, sodium acetate, potassium acetate, cesium acetate, lithium benzoate, sodium benzoate, potassium benzoate, cesium benzoate, lithium terephthalate, sodium terephthalate, cesium terephthalate, lithium pyridinecarboxylate, sodium pyridinecarboxylate, potassium pyridinecarboxylate, or cesium pyridinecarboxylate, , is preferred;
lithium fluoride, sodium fluoride, potassium fluoride, cesium fluoride, lithium hydroxide, sodium hydroxide, potassium hydroxide, cesium hydroxide, sodium carbonate, potassium carbonate, cesium carbonate, lithium acetate, sodium acetate, potassium acetate, cesium acetate, lithium benzoate, sodium benzoate, cesium benzoate, cesium terephthalate, or cesium pyridinecarboxylate is more preferred;
cesium fluoride, cesium hydroxide, cesium acetate, cesium benzoate, or cesium pyridinecarboxylate is further preferred; and
cesium hydroxide is particularly preferred.

These ionic compounds may contain hydration water and/or a neutral ligand.

Examples of the compound represented by Formula (hh-2) may include cesium hydroxide monohydrate, sodium sulfate decahydrate, sodium carbonate decahydrate, and sodium carbonate monohydrate. Among these, cesium hydroxide monohydrate is preferred.

The ionic compound may be used alone or in combination of two or more types thereof.

The ionic compound has a molecular weight of less than 500.

In the metallic composite composition, the added amount of an ionic compound is 1 to 50 parts by weight, with respect to 100 parts by weight of the metallic composite.

The metallic composite composition used in the present invention may be used as a material of electrode cathode as it is, or may be dispersed in a solvent to be used as a dispersion liquid. Specific examples of the solvent may include the same as those used in the production of a metallic composite. The concentration of the metallic composite in a dispersion liquid is preferably 0.01 to 75 parts by weight, more preferably 0.05 to 50 parts by weight, and further preferably 0.1 to 30 parts by weight, when the dispersion liquid is 100 parts by weight. In a dispersion liquid of the metallic composite composition, the concentration of the ionic compound is preferably 0.0001 to 20 parts by weight, more preferably 0.0001 to 10 parts by weight, further preferably 0.0001 to 1 part by weight, particularly preferably 0.001 to 1 part by weight, and still further preferably 0.001 to 0.1 parts by weight, when the dispersion liquid is 100 parts by weight. The dispersion liquid may contain additives such as a dispersion stabilizer, a surfactant, a viscosity modifier and a corrosion inhibitor, in addition to the metallic composite composition.

The dispersion liquid is useful as an electrically conductive paint, a thermally conductive paint, an adhesive, a bond or a functional coating material.

Also disclosed herein is a mixture which includes the metallic composite composition and a conjugated compound having a polystyrene equivalent number average molecular weight of 1.0 x 10³ to 5.0 x 10⁶ as measured by gel permeation chromatography. The definition, specific examples and preferred examples of the conjugated compound which is contained in the mixture disclosed herein and is a component other than the metallic composite composition, are similar to those of the conjugated compound adsorbed to the metallic nanostructure. The mixture disclosed herein can be obtained by, in the method for manufacturing a metallic composite, adding an ionic compound after the mixing step and evaporating a solvent, or further mixing a conjugated compound to the metallic composite composition. It is preferable that the conjugated compound includes a hetero atom or a hetero atom-containing group.

Examples of the hetero atom or the hetero atom-containing group contained in the conjugated compound may include a halogen atom, a hydrocarbyl group optionally having a substituent, a mercapto group, a mercaptocarbonyl group, a mercaptothiocarbonyl group, a hydrocarbylthio group optionally having a substituent, a hydrocarbylthiocarbonyl group optionally having a substituent, a hydrocarbyldithio group optionally having a substituent, a hydroxyl group, a hydrocarbyloxy group optionally having a substituent, a carboxyl group, a formyl group, a hydrocarbylcarbonyl group optionally having a substituent, a hydrocarbyloxycarbonyl group optionally having a substituent, a hydrocarbylcarbonyloxy group optionally having a substituent, a cyano group, a nitro group, an amino group, a hydrocarbylamino group optionally having a substituent, a dihydrocarbylamino group optionally having a substituent, a phosphino group, a hydrocarbylphosphino group optionally having a substituent, a dihydrocarbylphosphino group optionally having a substituent, a group represented by formula: -OP(=O)(OH)₂, a group represented by formula: -P(=O) (OH)₂, a carbamoyl group, a hydrocarbyl carbamoyl group optionally having a substituent, a dihydrocarbylcarbamoyl group optionally having a substituent, a group represented by formula: - C(=S)NR₂, a group represented by formula: -B(OH)₂, a group represented by formula: -BR₂, a boric acid ester residue, a group represented by formula: -Si(OR)₃, a sulfo group, a hydrocarbylsulfo group optionally having a substituent, a hydrocarbylsulfonyl group optionally having a substituent, a sulfino group, a hydrocarbylsulfino group optionally having a substituent, a group represented by formula: - NRC(=O)OR, a group represented by formula: -NRC(=O)SR, a group represented by formula: -NRC(=S)OR, a group represented by formula: -NRC(=S)SR, a group represented by formula: -OC(=O)NR₂, a group represented by formula: - SC(=O)NR₂, a group represented by formula: -OC(=S)NR₂, a group represented by formula: -SC(=S)NR₂, a group represented by formula: -NRC(=O)NR₂, a group represented by formula: -NRC(=S)NR₂, a monovalent heterocyclic group, a hydrocarbyl group having two or more ether bonds, a hydrocarbyl group having two or more ester bonds, a hydrocarbyl group having two or more amido bonds, a group represented by formula: -SM, a group represented by formula: -C(=O)SM, a group represented by formula: -CS₂M, a group represented by formula: -OM, a group represented by formula: -CO₂M, a group represented by formula: -NM₂, a group represented by formula: -NHM, a group represented by formula: -NRM, a group represented by formula: -PO₃M, a group represented by formula: -OP(=O)(OM)₂, a group represented by formula: -P(=O)(OM)₂, a group represented by formula: -C(=O)NM₂, a group represented by formula: - C(=O)NHM, a group represented by formula: -C(=O)NRM, a group represented by formula: -C(=S)NHM, a group represented by formula: -C(=S)NRM, a group represented by formula: -C(=S)NM₂, a group represented by formula: - B(OM)₂, a group represented by formula: -BR₃M, a group represented by formula: -B(OR)₃M, a group represented by formula: -SO₃M, a group represented by formula: -SO₂M, a group represented by formula: -NRC(=O)OM, a group represented by formula: -NRC(=O)SM, a group represented by formula: -NRC(=S)OM, a group represented by formula: - NRC(=S)SM, a group represented by formula: -OC(=O)NM₂, a group represented by formula: -OC(=O)NRM, a group represented by formula: -OC(=S)NM₂, a group represented by formula: -OC(=S)NRM, a group represented by formula: - SC(=O)NM₂, a group represented by formula: -SC(=O)NRM, a group represented by formula: -SC(=S)NM₂, a group represented by formula: -SC(=S)NRM, a group represented by formula: -NRC(=O)NM₂, a group represented by formula: - NRC(=O)NRM, a group represented by formula: -NRC(=S)NM₂, a group represented by formula: -NRC(=S)NRM, a group represented by formula: -NR₃M', a group represented by formula: -PR₃M', a group represented by formula: -OR₂M', a group represented by formula: -SR₂M', a group represented by formula: -IRM', and a heterocyclic group having a cationized nitrogen atom within a heterocycle.

In the formulae, R represents a hydrogen atom or a hydrocarbyl group optionally having a substituent, M represents a metal cation or an ammonium cation optionally having a substituent, and M' represents an anion.

Among these, a hydrocarbyl group having two or more ether bonds, a group represented by formula: -CO₂M, a group represented by formula: -SO₃M, or a group represented by formula: -NR₃M' is more preferred; a group represented by formula: -CO₂M or a group represented by formula: -NR₃M' is particularly preferred; and a group represented by formula: -CO₂M is more particularly preferred. Here, details of each atom and group described above as examples of the hetero atom or the hetero atom-containing group contained in the conjugated compound are the same as those described above. Also, details of M and M' are the same as those described above.

The mixture disclosed herein contains usually 1 to 99 parts by weight of a metallic composite composition and 1 to 99 parts by weight of a conjugated compound having a molecular weight of 200 or more, and preferably 1 to 50 parts by weight of a metallic composite composition and 50 to 99 parts by weight of a conjugated compound having a polystyrene equivalent number average molecular weight of 1.0 x 10³ to 5.0 x 10⁶ as measured by gel permeation chromatography, when the mixture is 100 parts by weight.

The mixture disclosed herein may contain two or more types of metallic composites, two or more types of ionic compounds, and two or more types of conjugated compounds having a polystyrene equivalent number average molecular weight of 1.0 x 10³ to 5.0 x 10⁶ as measured by gel permeation chromatography. The mixture may further contain a metal particle, a metal oxide, a metallic nanostructure, a surfactant, a viscosity modifier, a corrosion inhibitor or the like.

The mixture disclosed herein is useful as an electrically conductive paint, a thermally conductive paint, a wiring material, an adhesive, a bond, a functional coating material, an electromagnetic wave shielding material, a sensor, an antenna, an antistatic agent, a fiber, a packaging material, an antimicrobial agent, a deodorant, a heating device, a radiator or a medical material.

A thin film containing the metallic composite composition disclosed herein (hereinafter, merely referred to as "the metallic composite composition and the like ") has electrical conductivity. Furthermore, in a preferred embodiment, the thin film containing the metallic composite composition and the like has optical transparency. Therefore, the thin film is useful as a flat liquid crystal display, a touch panel, a light-emitting device, a photovoltaic cell, an antistatic layer or an electromagnetic wave shielding layer.

The conductivity of the thin film disclosed herein can be evaluated by sheet resistance. The preferred value of the sheet resistance varies depending on the intended use. When the thin film is used for a material of a light-emitting device, the sheet resistance is preferably 10000 Ω/□ or less, more preferably 1000 Ω/□ or less, and further preferably 100 Ω/□ or less.

A substrate for supporting the thin film may be any substrate that does not change chemically during the formation of the thin film. For example, the substrate is made of a material such as glass, plastic, silicon, a macromolecular film, and the like.

The material containing the metallic composite composition and the like is a material having electrical conductivity, and is useful as an electrically conductive material, an electrode material, or a wiring material.

The metallic composite composition and the like can be used for a layered structure, and thus becomes a useful material for manufacturing an electronic device or the like. The layered structure includes a substrate and a layer containing the metallic composite composition formed on the substrate. For instance, in a light-emitting device, the substrate is a glass substrate, a polyethylene terephthalate substrate, a polyethylene substrate, a polypropylene substrate, a polycarbonate substrate or the like, and the layer containing the metallic composite composition is a cathode.

The metallic composite composition and the like have a structure of high anisotropy. Therefore, the metallic composite composition and the like can secure a contact point between constituent units contained in the metallic composite composition even without paving them. Also, the metallic composite composition and the like have excellent electrical conductivity. Therefore, the metallic composite composition and the like can be used as, for example, an electrode material.

When the metallic composite composition and the like are used for an electrically conductive paint, a patterned electrically conductive site can be produced as necessary by selecting an application method. Therefore, an electrode or the like can be produced without requiring a process such as vapor deposition, sputtering, etching and plating. In addition, the metallic composite composition and the like have a structure of high anisotropy. Therefore, the electrode thus obtained has both transparency and conductivity. This electrode is applied to an electronic device such as a light-emitting device (for example, an organic EL device), a transistor and a photovoltaic cell (for example, a solar cell).
Furthermore, the metallic composite composition and the like are applied to a flat liquid crystal display, a touch panel, a heating device, an electromagnetic wave shielding film, an antenna, an integrated circuit, an antistatic agent or the like.

The organic transistor has a source electrode, a drain electrode and an insulated gate electrode layer. The metallic composite composition and the like can be used for these electrodes. The organic transistor may further include a substrate, a semiconductor layer or the like.

The light-emitting device of the invention comprises an anode and a cathode, and a light-emitting layer provided between the anode and the cathode. The metallic composite composition and the like is used in the cathode. The light-emitting device may further include a substrate, a hole injection layer, an electron injection layer, a hole transport layer, an electron transport layer or the like.

A type of the light-emitting device of the present invention may be any one of a so-called bottom emission type in which light is emitted from a substrate side, a so-called top emission type in which light is emitted from an opposite side to the substrate, and a dual-sided emission type.

The light-emitting device of the present invention can include an additional component between the cathode and the light-emitting layer or between the anode and the light-emitting layer.

For example, the light-emitting device may include one or more of a hole injection layer and a hole transport layer between the anode and the light-emitting layer. When the hole injection layer is present, the light-emitting device may include one or more hole transport layers between the light-emitting layer and the hole injection layer.

On the other hand, the light-emitting device may include one or more of an electron injection layer and an electron transport layer between the cathode and the light-emitting layer. When the electron injection layer is present, the light-emitting device may include one or more electron transport layers between the light-emitting layer and the electron injection layer.

A layer containing the metallic composite composition and the like can also be used as a hole injection layer, a hole transport layer, an electron injection layer, an electron transport layer or the like.

The anode is an electrode that supplies a hole to a hole injection layer, a hole transport layer, a light-emitting layer or the like, and the cathode is an electrode that supplies an electron to an electron injection layer, an electron transport layer, a light-emitting layer or the like.

The light-emitting layer refers to a layer having: a function of receiving holes from an anode or a layer adjacent to the anode side while receiving electrons from a cathode or a layer adjacent to the cathode side when an electric field is applied; a function of moving received charges (electrons and holes) by a force of the electric field; and a function of providing a site where electrons and holes are recombined and thereby leading to light emission.

The electron injection layer is a layer adjacent to a cathode and having a function of receiving electrons from the cathode. The electron injection layer further has, as necessary, any one of a function of transporting electrons, a function of blocking holes injected from the anode, and a function of supplying electrons to the light-emitting layer. The electron transport layer is a layer mainly having a function of transporting electrons. The electron transport layer further has, as necessary, any one of a function of receiving electrons from the cathode, a function of blocking holes injected from the anode, and a function of supplying electrons to the light-emitting layer.

The hole injection layer is a layer adjacent to an anode and having a function of receiving holes from the anode. The hole injection layer further has, as necessary, any one of a function of transporting holes, a function of supplying holes to the light-emitting layer, and a function of blocking electrons injected from the cathode. The hole transport layer is a layer mainly having a function of transporting holes. The hole transport layer further has, as necessary, a function of receiving holes from an anode, a function of supplying holes to the light-emitting layer, and a function of blocking electrons injected from the cathode.

The electron transport layer and the hole transport layer may be collectively referred to as a charge transport layer. The electron injection layer and the hole injection layer may be collectively referred to as a charge injection layer.

That is, the light-emitting device of the present invention can have a layer structure (a) below. Alternatively, the light-emitting device can have a layer structure in which one or more of a hole injection layer, a hole transport layer, an electron transport layer and an electron injection layer are omitted from the layer structure (a). In the layer structure (a), a layer containing the metallic composite composition and the like is used in a cathode.
(a) Anode - (hole injection layer) - (hole transport layer) - light-emitting layer - (electron transport layer) - (electron injection layer) - cathode
   Here, the symbol "-" indicates that layers described on both sides of the symbol are adjacently stacked. The "(hole injection layer)" means a layer structure including one or more hole injection layers. The "(hole transport layer)" means a layer structure including one or more hole transport layers. The "(electron injection layer)" means a layer structure including one or more electron injection layers. The "(electron transport layer)" means a layer structure including one or more electron transport layers. The same shall apply to the descriptions of a layer structure below.
   Furthermore, the light-emitting device of the present invention may include two light-emitting layers in a single layered structure. In this case, the light-emitting device can have a layer structure (b) below. Alternatively, the light-emitting device can have a layer structure in which one or more of a hole injection layer, a hole transport layer, an electron transport layer, an electron injection layer and an electrode are omitted from the layer structure (b). In the layer structure (b), a layer containing the metallic composite composition and the like is used in a cathode.
(b) Anode - (hole injection layer) - (hole transport layer) - light-emitting layer - (electron transport layer) - (electron injection layer) - electrode - (hole injection layer) - (hole transport layer) - light-emitting layer - (electron transport layer) - (electron injection layer)- cathode
   Furthermore, the light-emitting device of the present invention may include three or more light-emitting layers in a single layered structure. In this case, the light-emitting device can have a layer structure (c) below. Alternatively, the light-emitting device can have a layer structure in which one or more of a hole injection layer, a hole transport layer, an electron transport layer, an electron injection layer and an electrode are omitted from layer structure (c). In the layer structure (c), a layer containing the metallic composite composition and the like is used in a cathode.
(c) Anode - (hole injection layer) - (hole transport layer) - light-emitting layer - (electron transport layer) - (electron injection layer) - repeating unit A - repeating unit A... - cathode

Here, the "repeating unit A" means a layer structure unit of electrode - (hole injection layer) - (hole transport layer) - light-emitting layer - (electron transport layer) - (electron injection layer).

Examples of a preferred layer structure of the light-emitting device of the present invention may include the structures below. In the layer structures below, a layer containing the metallic composite composition and the like is used as a cathode and optionally as one or more layers selected from the group consisting of an anode, a hole injection layer, a hole transport layer, an electron injection layer, and an electron transport layer.
(a') Anode - light-emitting layer - cathode
(b') Anode - hole injection layer - light-emitting layer - cathode
(c') Anode - light-emitting layer - electron injection layer - cathode
(d') Anode - hole injection layer - light-emitting layer - electron injection layer - cathode
(e') Anode - hole injection layer - hole transport layer - light emitting layer - cathode
(f') Anode - hole injection layer - hole transport layer - light-emitting layer - electron injection layer - cathode
(g') Anode - light-emitting layer - electron transport layer - electron injection layer - cathode
(h') Anode - hole injection layer - light-emitting layer - electron transport layer - electron injection layer - cathode
(i') Anode - hole injection layer - hole transport layer - light-emitting layer - electron transport layer - electron injection layer - cathode

The layer containing the metallic composite composition and the like is a cathode.

In the light-emitting device of the present invention, an insulating layer may further be provided adjacent to an electrode in order to enhance the adhesion with the electrode and to improve the injection of charges (i.e., holes and electrons) from the electrode. Also, a thin buffer layer may be inserted in the interface of a charge transport layer (i.e., a hole transport layer or an electron transport layer) or a light-emitting layer in order to enhance the adhesion of the interface and to prevent mixing at the interface. The order and the number of layers to be stacked, and the thickness of each layer can be determined in view of light-emitting efficiency and a device lifetime.

Next, a material and a forming method of each layer constituting the light-emitting device of the present invention will be described in more detail.

### -Substrate-

The light-emitting device of the present invention is usually formed using a substrate. The substrate may be any substrate that does not change chemically during the formation of an electrode and an organic layer. Examples of the substrate may include a glass substrate, a plastic substrate, a macromolecular film substrate, a metal film substrate, a silicon substrate, and a laminated substrate thereof. The substrate is commercially available, or can be manufactured by a publicly known method.

When the light-emitting device of the present invention constitutes a pixel of a display device, the circuit for driving a pixel may be provided on the substrate, or a planarized film may be provided on the driving circuit. When a planarized film is provided, it is preferable that the center line average roughness (Ra) of the planarized film satisfy Ra < 10 nm.

Ra can be measured based on JIS-B0601-2001 by referring to JIS-B0651 to JIS-B0656, JIS-B0671-1 and the like.

### -Anode-

Regarding an anode constituting the light-emitting device of the present invention, it is preferable that the light-emitting layer-side surface of the anode has a work function of 4.0 eV or more, for excellent properties of supplying holes to an organic semiconductor material used in the hole injection layer, the hole transport layer, the light-emitting layer and the like.

In the light-emitting device of the present invention, metals, alloys, metal oxides, electrically conductive compounds such as metal sulfides, and a mixture thereof can be used for an anode material other than the metallic composite composition and the like. Specific examples thereof may include electrically conductive metal oxides such as tin oxide, zinc oxide, indium oxide, indium tin oxide, indium zinc oxide and molybdenum oxide; metals such as gold, silver, chromium and nickel; and a mixture of these electrically conductive metal oxides and metals.

The anode may be a single-layer structure made of one or two or more types of these materials, or a multi-layer structure formed of a plurality of layers each having the same composition or a different composition. When the anode is a multi-layer structure, it is preferable that a material having a work function of 4.0 eV or more is used for a top surface layer on the light-emitting layer side.

As a method for manufacturing an anode, a publicly known method can be used. Examples thereof may include a vacuum deposition method, a sputtering method, an ion plating method, a plating method, and a method of forming a film from a solution (a mixed solution with macromolecular binders may be used).

The thickness of the anode is usually 10 nm to 10 µm, and preferably 40 nm to 500 nm.

The center line average roughness (Ra) of the light-emitting layer-side surface of the anode satisfies preferably Ra < 10 nm, and more preferably Ra < 5 nm, since defective electrical connection such as a short circuit can be efficiently prevented.

Furthermore, after being manufactured according to the above method, the anode may be subjected to a surface treatment using UV ozone, a silane coupling agent, a solution containing an electron accepting compound such as 2,3,5,6-tetrafluoro-7,7,8,8-tetracyanoquinodimethane, or the like. By performing the surface treatment, an electrical connection with the layer in contact with the anode is improved.

When an anode is used as a light reflecting electrode in the light-emitting device of the present invention, it is preferable that the anode has a multi-layer structure in which a light reflecting layer that is made of a high light reflecting metal and a high work function material layer that contains a material having a work function of 4.0 eV or more are combined.

Examples of a composition of such an anode may include (i) to (v) below.
(i) Ag - MoO₃
(ii) (Ag-Pd-Cu alloy) - (ITO and/or IZO)
(iii) (Al-Nd alloy) - (ITO and/or IZO)
(iv) (Mo-Cr alloy) - (ITO and/or IZO)
(v) (Ag-Pd-Cu alloy) - (ITO and/or IZO) - MoO₃

In order to have sufficient light reflectivity, a light reflecting layer made of a high light reflecting metal such as Al, Ag, Al alloys, Ag alloys and Cr alloys has a thickness of preferably 50 nm or more, and more preferably 80 nm or more. The thickness of the high work function material layer such as ITO, IZO and MoO₃ is usually in a range of 5 nm to 500 nm.

### -Hole injection layer-

In the light-emitting device of the present invention, preferred examples of a material for forming the hole injection layer other than the metallic composite composition and the like may include carbazole derivatives, triazole derivatives, oxazole derivatives, oxadiazole derivatives, imidazole derivatives, fluorene derivatives, polyarylalkane derivatives, pyrazoline derivatives, pyrazolone derivatives, phenylenediamine derivatives, arylamine derivatives, starburst-type amine, phthalocyanine derivatives, amino-substituted chalcone derivatives, styryl anthracene derivatives, fluorenone derivatives, hydrazone derivatives, stilbene derivatives, silazane derivatives, aromatic tertiary amine compounds, styryl amine compounds, aromatic dimethylidine-based compounds, porphyrin-based compounds, polysilane-based compounds, poly(N-vinylcarbazole) derivatives, organic silane derivatives, and a polymer containing these; electrically conductive metal oxides such as vanadium oxides, tantalum oxides, tungsten oxides, molybdenum oxides, ruthenium oxides and aluminum oxides; electrically conductive macromolecules and oligomers such as polyaniline, aniline-based copolymers, thiophene oligomers and polythiophene; electrically conductive organic materials such as poly(3,4-ethylenedioxythiophene)·polystyrenesulfonic acid and polypyrrole and a polymer containing these; amorphous carbon; acceptor organic compounds such as tetracyanoquinodimethane derivatives (for example, 2,3,5,6-tetrafluoro-7,7,8,8-tetracyanoquinodimethane), 1,4-naphthoquinone derivatives, diphenoquinone derivatives and polynitro compounds; and silane coupling agents such as octadecyltrimethoxysilane.

The material may be used alone or in combination of two or more types thereof. Also, the hole injection layer may be a single-layer structure made of only the above material, or a multi-layer structure formed of a plurality of layers each having the same composition or a different composition. Furthermore, the material described as examples of the hole transport layer material can be also used as a material of the hole injection layer.

As a method for manufacturing the hole injection layer, a publicly known method can be used. When a hole injection material used in the hole injection layer is an inorganic material, a vacuum deposition method, a sputtering method, an ion plating method or the like can be used. When the hole injection material is a low molecular organic material, a vacuum deposition method, a transfer method such as a laser transfer and a thermal transfer, or a method of forming a film from a solution (a mixed solution with macromolecular binders may be used) or the like can be used. When the hole injection material is a macromolecular organic material, a method of forming a film from a solution can be used.

When the hole injection material is a low molecular organic material such as pyrazoline derivatives, arylamine derivatives, stilbene derivatives and triphenyldiamine derivatives, it is preferable to form a hole injection layer using a vacuum deposition method.

Also, the hole injection layer can be formed using a mixed solution in which a macromolecular compound binder and the low molecular organic material are dispersed.

For the macromolecular compound binder to be mixed, a macromolecular compound binder that does not extremely inhibit the charge transport and does not strongly absorb visible light is preferred. Examples of the macromolecular compound binder may include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, poly(methyl acrylate), poly(methyl methacrylate), polystyrene, polyvinyl chloride and polysiloxane.

The solvent used for forming a film from a solution may be any solvent capable of dissolving the hole injection material. Examples of the solvent may include water; a chlorine-containing solvent such as chloroform, methylene chloride and dichloroethane; an ether solvent such as tetrahydrofuran; an aromatic hydrocarbon solvent such as toluene and xylene; a ketone solvent such as acetone and methyl ethyl ketone; an ester solvent such as ethyl acetate, butyl acetate and ethyl cellosolve acetate.

The method of forming a film from a solution may include an application method. Specific examples thereof may include a coating method such as a spin coating method, a casting method, a bar coating method, a roll coating method, a wire-bar coating method, a dip coating method, a slit coating method, a capillary coating method, a spray coating method and a nozzle coating method; and a printing method such as a microgravure printing method, a gravure printing method, a screen printing method, a flexographic printing method, an off-set printing method, a reverse printing method and an inkjet printing method.

For easy pattern formation, a printing method such as a gravure printing method, a screen printing method, a flexographic printing method, an off-set printing method, a reverse printing method and an inkjet printing method, as well as a nozzle coating method are preferred.

When forming an organic compound layer such as the hole transport layer and the light-emitting layer following to the hole injection layer, especially when forming both layers by an application method, a previously applied layer (hereinafter, also referred to as a "lower layer") might be dissolved in a solvent contained in a solution of a subsequently applied layer (hereinafter, also referred to as an "upper layer"), and thus a layered structure cannot be formed in some cases. In such a case, a method of insolubilizing a lower layer to a solvent can be used. Examples of the method of insolubilizing a lower layer to a solvent may include a method of introducing a crosslinking group into a macromolecular compound contained in a lower layer for crosslinking and insolubilization; a method of mixing a low molecular compound having a crosslinking group containing an aromatic ring typified by aromatic bisazide as a crosslinking agent for crosslinking and insolubilization; a method of mixing a low molecular compound having a crosslinking group not containing an aromatic ring typified by an acrylate group as a crosslinking agent for crosslinking and insolubilization; a method of exposing a lower layer to ultraviolet rays for crosslinking and insolubilization to an organic solvent used in manufacturing an upper layer; and a method of heating a lower layer for crosslinking and insolubilization to an organic solvent used in manufacturing an upper layer. The heating temperature when heating a lower layer is usually 100°C to 300°C, and the heating time is usually 1 minute to 1 hour.

As another method for stacking an upper layer without dissolving a lower layer, there may be a method of using solutions each having a different polarity in manufacturing adjacent layers. For example, there is a method of using a water soluble macromolecular compound for a lower layer and an oil-based solution containing an oil soluble macromolecular compound as a solution for an upper layer, so that the lower layer is not dissolved even when the upper layer is applied thereon.

An optimal value of the thickness of the hole injection layer varies depending on a material to be used, and may be determined so that a driving voltage and luminous efficiency have appropriate values. The thickness of the hole injection layer is usually 1 nm to 1 µm, preferably 2 nm to 500 nm, and more preferably 10 nm to 100 nm.

### -Hole transport layer-

In the light-emitting device of the present invention, preferred examples of a material constituting the hole transport layer other than the metallic composite composition and the like may include carbazole derivatives, triazole derivatives, oxazole derivatives, oxadiazole derivatives, imidazole derivatives, fluorene derivatives, polyarylalkane derivatives, pyrazoline derivatives, pyrazolone derivatives, phenylenediamine derivatives, arylamine derivatives, amino-substituted chalcone derivatives, styryl anthracene derivatives, fluorenone derivatives, hydrazone derivatives, stilbene derivatives, silazane derivatives, aromatic tertiary amine compounds, styryl amine compounds, aromatic dimethylidine-based compounds, porphyrin-based compounds, polysilane-based compounds, poly(N-vinylcarbazole) derivatives, organic silane derivatives, and a polymer thereof; electrically conductive macromolecules and oligomers such as aniline-based copolymers, thiophene oligomers and polythiophene; and electrically conductive organic materials such as polypyrrole.

The material may be used alone or in combination of two or more types thereof. Also, the hole transport layer may be a single-layer structure made of only the above material, or a multi-layer structure formed of a plurality of layers each having the same composition or a different composition. Furthermore, the material described as examples of the material of a hole injection layer can also be used as a material of a hole transport layer.

Other useful materials constituting the hole transport layer include compounds disclosed in JP 63-70257 A, JP 63-175860 A, JP 2-135359 A, JP 2-135361 A, JP 2-209988 A, JP 3-37992 A, JP 3-152184 A, JP 5-263073 A, and JP 6-1972 A, WO2005/52027, JP 2006-295203 A and the like. Among these, a polymer containing a divalent aromatic amine residue as a repeating unit is suitably used.

A film-forming method of the hole transport layer includes the same method as that of the hole injection layer. The method of forming a film from a solution may include an application method. Specific examples thereof may include a coating method such as a spin coating method, a casting method, a bar coating method, a slit coating method, a spray coating method and a nozzle coating method; and a printing method such as a gravure printing method, a screen printing method, a flexographic printing method and an inkjet printing method. When using a sublimable compound material, a vacuum deposition method or a transfer method may be used. The solvent used for forming a film from a solution may include the solvents described as examples in the film-forming method of the hole injection layer.

When forming an organic layer such as the light-emitting layer by an application method following to the hole transport layer, in the case of a lower layer being dissolved in a solvent contained in a solution of a subsequently applied layer, the lower layer can be insolubilized to the solvent by the same method as described in the film-forming method of the hole injection layer.

The thickness of the hole transport layer varies depending on a material to be used, and may be determined so that a driving voltage and luminous efficiency have appropriate values. The thickness of the hole transport layer is usually 1 nm to 1 µm, preferably 2 nm to 500 nm, and more preferably 5 nm to 100 nm.

### -Light-emitting layer-

When a light-emitting layer contains a macromolecular compound in the light-emitting device of the present invention, preferred examples of the macromolecular compound may include conjugated macromolecular compounds such as polyfluorene derivatives, polyparaphenylenevinylene derivatives, polyphenylene derivatives, polyparaphenylene derivatives, polythiophene derivatives, polydialkylfluorene, polyfluorenebenzothiadiazole and polyalkylthiophene.

Also, the light-emitting layer containing a macromolecular compound may contain macromolecular dye compounds such as perylene-based dyes, coumarin-based dyes and rhodamine-based dyes; and low molecular dye compounds such as rubrene, perylene, 9,10-diphenylanthracene, tetraphenylbutadiene, Nile red, coumarin 6 and quinacridone. Also, the light-emitting layer may contain naphthalene derivatives, anthracene and derivatives thereof, perylene and derivatives thereof, dyes such as polymethine dyes, xanthene dyes, coumarin dyes and cyanine dyes, metal complexes of 8-hydroxyquinoline and derivatives thereof, aromatic amine, tetraphenylcyclopentadiene and derivatives thereof, tetraphenylbutadiene and derivatives thereof, and phosphorescent metal complexes such as tris(2-phenylpyridine)iridium.

The light-emitting layer included in the light-emitting device of the present invention may be made of a material including a non-conjugated macromolecular compound and a light-emitting organic compound such as the organic dyes and the metal complexes. Examples of the non-conjugated macromolecular compound may include polyethylene, polyvinyl chloride, polycarbonate, polystyrene, poly(methyl methacrylate), poly(butyl methacrylate), polyester, polysulfone, polyphenylene oxide, polybutadiene, poly(N-vinylcarbazole), hydrocarbon resins, ketone resins, phenoxy resins, polyamide, ethyl cellulose, vinyl acetate, ABS resins, polyurethane, melamine resins, unsaturated polyester resins, alkyd resins, epoxy resins and silicon resins. The non-conjugated macromolecular compound may have, in its side chain, a structure of one or more derivatives or compounds selected from the group consisting of carbazole derivatives, triazole derivatives, oxazole derivatives, oxadiazole derivatives, imidazole derivatives, fluorene derivatives, polyarylalkane derivatives, pyrazoline derivatives, pyrazolone derivatives, phenylenediamine derivatives, arylamine derivatives, amino-substituted chalcone derivatives, styryl anthracene derivatives, fluorenone derivatives, hydrazone derivatives, stilbene derivatives, silazane derivatives, aromatic tertiary amine compounds, styryl amine compounds, aromatic dimethylidine compounds, porphyrin compounds and organic silane derivatives.

When the light-emitting layer contains a low molecular compound, examples of the low molecular compound may include low molecular dye compounds such as rubrene, perylene, 9,10-diphenylanthracene, tetraphenylbutadiene, Nile red, coumarin 6, carbazole and quinacridone, naphthalene derivatives, anthracene and derivatives thereof, perylene and derivatives thereof, dyes such as polymethine dyes, xanthene dyes, coumarin dyes, cyanine dyes and indigo dyes, metal complexes of 8-hydroxyquinoline and derivatives thereof, metal complexes of phthalocyanine and derivatives thereof, aromatic amine, tetraphenylcyclopentadiene and derivatives thereof, and tetraphenylbutadiene and derivatives thereof.

When the light-emitting layer contains a phosphorescent metal complex, examples of the metal complex may include tris(2-phenylpyridine)iridium, thienylpyridine ligand-containing iridium complexes, phenylquinoline ligand-containing iridium complexes, and triazacyclononane backbone-containing terbium complexes.

Examples of the macromolecular compound used in the light-emitting layer may include polyfluorene, derivatives and copolymers thereof, polyarylene, derivatives and copolymers thereof, polyarylenevinylene, derivatives and copolymers thereof, and (co)polymers of aromatic amine and derivatives thereof, disclosed in WO97/09394, WO98/27136, WO99/54385, WO00/22027, WO01/19834, GB2340304A, GB2348316, US573636, US5741921, US5777070, EP0707020, JP 9-111233 A, JP 10-324870 A, JP 2000-80167 A, JP 2001-123156 A, JP 2004-168999 A, and JP 2007-162009 A, "Development and Constituent Material of Organic EL Device" (CMC Publishing Co., Ltd., issued in 2006), and the like.

Examples of the low molecular compound may include compounds described in JP 57-51781 A, "Organic Thin Film Work Function Data Collection [2nd Edition]" (CMC Publishing Co., Ltd., issued in 2006), "Development and Constituent Material of Organic EL Device" (CMC Publishing Co., Ltd., issued in 2006), and the like.

The above-mentioned material may be used alone or in combination of two or more types thereof. Also, the light-emitting layer may be a single-layer structure made of one or two or more types of the above materials, or a multi-layer structure formed of a plurality of layers each having the same composition or a different composition.

Examples of the film-forming method of the light-emitting layer may include the same method as that of the hole injection layer. Examples of the method of forming a film from a solution may include an application method. Specific examples thereof may include a coating method such as a spin coating method, a casting method, a bar coating method, a slit coating method, a spray coating method and a nozzle coating method; and a printing method such as a gravure printing method, a screen printing method, a flexographic printing method and an inkjet printing method. When using a sublimable compound material, a vacuum deposition method, a transfer method or the like may be used.

Examples of the solvent used for forming a film from a solution may include the solvents described as examples in the film-forming method of the hole injection layer.

When forming an organic compound layer such as the electron transport layer by an application method following to the light-emitting layer, in the case of a lower layer being dissolved in a solvent contained in a solution of a subsequently applied layer, the lower layer can be insolubilized to the solvent by the same method as described in the film-forming method of the hole injection layer.

The thickness of the light-emitting layer varies depending on a material to be used, and may be determined so that a driving voltage and luminous efficiency have appropriate values. The thickness of the light-emitting layer is usually 5 nm to 1 µm, preferably 10 nm to 500 nm, and more preferably 30 nm to 200 nm.

### -Electron transport layer-

As a material constituting the electron transport layer other than the metallic composite composition and the like in the light-emitting device of the present invention, a publicly known material can be used. Examples thereof may include triazole derivatives, oxazole derivatives, oxadiazole derivatives, imidazole derivatives, fluorene derivatives, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, anthraquinodimethane derivatives, anthrone derivatives, thiopyran dioxide derivatives, carbodiimide derivatives, fluorenylidenemethane derivatives, distyrylpyrazine derivatives, tetracarboxylic anhydrides of aromatic ring such as naphthalene and perylene, phthalocyanine derivatives, metal complexes of 8-quinolinol derivatives and metal phthalocyanines, various metal complexes typified by a metal complex having benzoxazole or benzothiazole as a ligand, organic silane derivatives, metal complexes of 8-hydroxyquinoline and derivatives thereof, polyquinoline and derivatives thereof, polyquinoxaline and derivatives thereof, and polyfluorene and derivatives thereof. Among these, triazole derivatives, oxadiazole derivatives, benzoquinone and derivatives thereof, anthraquinone and derivatives thereof, metal complexes of 8-hydroxyquinoline and derivatives thereof, polyquinoline and derivatives thereof, polyquinoxaline and derivatives thereof, and polyfluorene and derivatives thereof are preferred.

The material may be used alone or in combination of two or more types thereof. Also, the electron transport layer may be a single-layer structure made of one or two or more types of the above materials, or a multi-layer structure formed of a plurality of layers each having the same composition or a different composition. Furthermore, the material described as examples of the material of an electron injection layer can also be used as a material of an electron transport layer.

The film-forming method of the electron transport layer includes the same method as that of the hole injection layer. The method of forming a film from a solution may include an application method. Specific examples thereof may include a coating method such as a spin coating method, a casting method, a bar coating method, a slit coating method, a spray coating method and a nozzle coating method; and a printing method such as a gravure printing method, a screen printing method, a flexographic printing method and an inkjet printing method. When using a sublimable compound material, a vacuum deposition method, a transfer method or the like may be used.

The solvent used for forming a film from a solution may include the solvents described as examples in the film-forming method of the hole injection layer.

When forming an organic compound layer such as the electron injection layer by an application method following to the electron transport layer, in the case of a lower layer being dissolved in a solvent contained in a solution of a subsequently applied layer, the lower layer can be insolubilized to the solvent by the same method as described in the film-forming method of the hole injection layer.

The thickness of the electron transport layer varies depending on a material to be used, and may be determined so that a driving voltage and luminous efficiency have appropriate values. The thickness of the electron transport layer is usually 1 nm to 1 µm, preferably 2 nm to 500 nm, and more preferably 5 nm to 100 nm.

### -Electron injection layer-

As a material constituting the electron injection layer other than the metallic composite composition and the like in the light-emitting device of the present invention, a publicly known compound can be used. Examples thereof may include triazole derivatives, oxazole derivatives, oxadiazole derivatives, imidazole derivatives, fluorene derivatives, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, anthraquinodimethane derivatives, anthrone derivatives, thiopyran dioxide derivatives, carbodiimide derivatives, fluorenylidenemethane derivatives, distyrylpyrazine derivatives, tetracarboxylic anhydrides of aromatic ring such as naphthalene and perylene, phthalocyanine derivatives, metal complexes of 8-quinolinol derivatives and metal phthalocyanines, various metal complexes typified by a metal complex having benzoxazole or benzothiazole as a ligand, and organic silane derivatives.

The material may be used alone or in combination of two or more types thereof. Also, the electron injection layer may be a single-layer structure made of only the above material, or a multi-layer structure formed of a plurality of layers each having the same composition or a different composition. Furthermore, the material described as examples of the material of an electron transport layer can also be used as a material of an electron injection layer.

The film-forming method of the electron injection layer includes the same method as that of the hole injection layer. The method of forming a film from a solution may include an application method. Specific examples thereof may include a coating method such as a spin coating method, a casting method, a bar coating method, a slit coating method, a spray coating method and a nozzle coating method; and a printing method such as a gravure printing method, a screen printing method, a flexographic printing method and an inkjet printing method. When using a sublimable compound material, a vacuum deposition method, a transfer method or the like may be used.

The solvent used for forming a film from a solution may include the solvents described as examples in the film-forming method of the hole injection layer.

The thickness of the electron injection layer varies depending on a material to be used, and may be determined so that a driving voltage and luminous efficiency have appropriate values. The thickness of the electron injection layer is usually 1 nm to 1 µm, preferably 2 nm to 500 nm, and more preferably 5 nm to 100 nm.

### -Cathode-

In the light-emitting device of the present invention, the cathode may be a single-layer structure made of a single material or a plurality of materials, or may be a multi-layer structure formed of a plurality of layers. When the cathode is a single-layer structure, examples of a material of the cathode other than the metallic composite composition and the like in the light-emitting device of the present invention may include low electrical resistance metals such as gold, silver, copper, aluminum, chromium, tin, lead, nickel and titanium and alloys thereof; electrically conductive metal oxides such as tin oxide, zinc oxide, indium oxide, indium tin oxide, indium zinc oxide and molybdenum oxide; and mixtures of these conductive metal oxides and metals. When the cathode is a multi-layer structure, a two-layer structure including a first cathode layer and a cover cathode layer, or a three-layer structure including a first cathode layer, a second cathode layer and a cover cathode layer is preferred. Here, the first cathode layer refers to a layer closest to the light-emitting layer side of the cathode. The cover cathode layer refers to a layer covering the first cathode layer in a case of the two-layer structure, and a layer covering the first cathode layer and the second cathode layer in a case of the three-layer structure. For excellent electron-supplying abilities, it is preferable that the material of the first cathode layer have a work function of 3.5 eV or less. Oxides, fluorides, carbonates, complex oxides and the like of a metal having a work function of 3.5 eV or less is also suitably used as a material of the first cathode layer. As a material of the cover cathode layer, a metal, a metal oxide and the like each having low electrical resistivity and high corrosion resistance to moisture is suitably used.

Examples of the material of the first cathode layer may include one or more materials selected from the group consisting of an alkali metal; an alkaline earth metal; an alloy containing one or more of alkali metals or alkaline earth metals; oxides, halides, carbonates and complex oxides of an alkali metal or an alkaline earth metal; and a mixture thereof. Examples of the alkali metal or the oxides, halides, carbonates and complex oxides thereof may include lithium, sodium, potassium, rubidium, cesium, lithium oxide, sodium oxide, potassium oxide, rubidium oxide, cesium oxide, lithium fluoride, sodium fluoride, potassium fluoride, rubidium fluoride, cesium fluoride, lithium carbonate, sodium carbonate, potassium carbonate, rubidium carbonate, cesium carbonate, potassium molybdate, potassium titanate, potassium tungstate and cesium molybdate. Examples of the alkaline earth metal or the oxides, halides, carbonates and complex oxides thereof may include magnesium, calcium, strontium, barium, magnesium oxide, calcium oxide, strontium oxide, barium oxide, magnesium fluoride, calcium fluoride, strontium fluoride, barium fluoride, magnesium carbonate, calcium carbonate, strontium carbonate, barium carbonate, barium molybdate and barium tungstate. Examples of the alloy containing one or more of alkali metals or alkaline earth metals may include Li-Al alloys, Mg-Ag alloys, Al-Ba alloys, Mg-Ba alloys, Ba-Ag alloys and Ca-Bi-Pb-Sn alloys. A material in which the material described as examples of the material of the first cathode layer and the material described as examples of the material constituting the electron injection layer are combined may also be used as a material of the first cathode layer. Examples of the material of the second cathode layer may include the same materials as those of the first cathode layer.

Examples of the material of the cover cathode layer may include low electrical resistance metals such as gold, silver, copper, aluminum, chromium, tin, lead, nickel and titanium and alloys containing these metals; metal nanoparticles; metal nanowires; electrically conductive metal oxides such as tin oxide, zinc oxide, indium oxide, indium tin oxide, indium zinc oxide and molybdenum oxide; mixtures of these electrically conductive metal oxides and metals; nanoparticles of electrically conductive metal oxides; and electrically conductive carbons such as graphene, fullerene and carbon nanotube.

When the cathode is a multi-layer structure, examples of the structure may include a two-layer structure having a first cathode layer and a cover cathode layer such as Mg/Al, Ca/Al, Ba/Al, NaF/Al, KF/Al, RbF/Al, CsF/Al, Na₂CO₃/Al, K₂CO₃/Al, and Cs₂CO₃/Al; and a three-layer structure having a first cathode layer, a second cathode layer and a cover cathode layer such as LiF/Ca/Al, NaF/Ca/Al, KF/Ca/Al, RbF/Ca/Al, CsF/Ca/Al, Ba/Al/Ag, KF/Al/Ag, KF/Ca/Ag, and K₂CO₃/Ca/Ag. Here, the symbol "/" indicates that layers described on both sides of the symbol are adjacently stacked. It is preferable that the material of the second cathode layer have a reduction effect on the material of the first cathode layer. Here, the existence and degree of the reduction effect between the materials can be estimated, for example, based on a bond dissociation energy (ΔrH°) between the compounds. That is, in a reduction reaction by the material constituting the second cathode layer to the material constituting the first cathode layer, when a combination of the materials produces positive bond dissociation energy, it can be said that the material of the second cathode layer has a reduction effect on the material of the first cathode layer. The bond dissociation energy can be referred in, for example, " Handbook of Electrochemistry, 5th edition" (Maruzen, issued in 2000) and "Thermodynamic Database MALT" (Kagaku Gijutsu-Sha, issued in 1992).

As the method for manufacturing the cathode, a publicly known method can be used. Examples thereof may include a vacuum deposition method, a sputtering method, an ion plating method, and a method of forming a film from a solution (a mixed solution with macromolecular binders may be used). When metals, metal oxides, fluorides or carbonates are used as a material of the cathode, a vacuum deposition method is suitably used. When metal oxides having a high boiling point, metal complex oxides or electrically conductive metal oxides such as indium tin oxide are used, a sputtering method and an ion plating method are suitably used. When a film is formed using in combination of two or more of metals, metal oxides, fluorides, carbonates, metal oxides having a high boiling point, metal complex oxides, and electrically conductive metal oxides, a co-vapor deposition method, a sputtering method and an ion plating method are used. When metal nanoparticles, metal nanowires, or electrically conductive metal oxide nanoparticles are used, a method of forming a film from a solution is suitably used. In particular, when forming a film with a material of combination of a low molecular organic compound and metals, metal oxides, fluorides or carbonates, a co-vapor deposition method is suitable.

An optimal value of the thickness of the cathode varies depending on a material and a layer structure to be used, and may be determined so that a driving voltage, luminous efficiency and a device lifetime have appropriate values. Usually, the thickness of a first cathode layer is 0.5 nm to 20 nm, and the thickness of a cover cathode layer is 10 nm to 1 µm. For example, when Ba or Ca is used in the first cathode layer, and Al is used in the cover cathode layer, it is preferable that the thickness of Ba or Ca is 2 nm to 10 nm, and the thickness of Al is 10 nm to 500 nm. When NaF or KF is used in the first cathode layer, and Al is used in the cover cathode layer, it is preferable that the thickness of NaF or KF is 1 nm to 8 nm, and the thickness of Al is 10 nm to 500 nm.

When a cathode is used as an optical transparent electrode in the light-emitting device of the present invention, the visible light transmittance of a cover cathode layer is preferably 40% or more, and more preferably 50% or more. This range of visible light transmittance can be achieved by using transparent and electrically conductive metal oxides such as indium tin oxide, indium zinc oxide and molybdenum oxide as a material of the cover cathode layer, or by providing a cover cathode layer which is made of low electrical resistance metals such as gold, silver, copper, aluminum, chromium, tin and lead and an alloy thereof and has a thickness of 30 nm or less.

Also, in order to improve light transmittance from the cathode side, an antireflective layer may be provided on the cover cathode layer of the cathode. The material used in the antireflective layer has a refractive index of preferably 1.8 to 3.0. Examples of the material satisfying this range of refractive index may include ZnS, ZnSe and WO₃. Although the thickness of an antireflective layer varies depending on a combination of the materials, it is usually 10 nm to 150 nm.

### -Insulating layer-

The light-emitting device of the present invention may include an insulating layer having a thickness of 5 nm or less as a layer having functions of, for example, improving adherence to an electrode, improving charge injection from an electrode, and inhibiting mixing with an adjacent layer. Examples of a material of the insulating layer may include metal fluorides, metal oxides and organic insulating materials (for example, poly(methyl methacrylate)). Examples of the light-emitting device provided with the insulating layer having a thickness of 5 nm or less may include a device provided with the insulating layer having a thickness of 5 nm or less adjacent to a cathode, and a device provided with the insulating layer having a thickness of 5 nm or less adjacent to an anode.

### -Other components-

The light-emitting device of the present invention may further include a sealing member on the opposite side to a substrate while interposing a light-emitting layer and the like therebetween. The light-emitting device of the present invention may include an optional component for constituting a display device, including a filter such as a color filter and a fluorescence conversion filter, and a circuit and wiring necessary for driving a pixel.

Although the metallic composite composition and the like are used in a cathode, it can also be used in other layers.

When the metallic composite composition and the like is formed into a film from a solution, an application method such as a spin coating method, a casting method, a micro-gravure coating method, a gravure coating method, a bar coating method, a roll coating method, a wire-bar coating method, a dip coating method, a spray coating method, a screen printing method, a flexographic printing method, an off-set printing method, an inkjet printing method, a capillary coating method and a nozzle coating method can be used.

For any intended use, the metallic composite composition and the like may be used alone or in combination of two or more types thereof.

### -Method for manufacturing light-emitting device-

In an embodiment, the light-emitting device of the present invention can be manufactured by, for example, sequentially stacking each layer on a substrate. Specifically, the light-emitting device can be manufactured by providing an anode on a substrate, providing layers such as a hole injection layer and a hole transport layer thereon, providing a light-emitting layer thereon, providing layers such as an electron transport layer and an electron injection layer thereon, and further stacking a cathode thereon.

In another embodiment, the light-emitting device of the present invention can be manufactured by providing a cathode on a substrate, providing layers such as an electron injection layer, an electron transport layer, a light-emitting layer, a hole transport layer and a hole injection layer thereon, and further stacking an anode thereon.

In yet another embodiment, the light-emitting device of the present invention can be manufactured by connecting an anode or an anode-side base material in which layers are stacked on an anode to a cathode or a cathode-side base material in which layers are stacked on a cathode, while facing each other.

### -Application of light-emitting device-

The light-emitting device of the present invention can be used to manufacture a display device. The display device includes a light-emitting device as one pixel unit. An aspect of the arrangement of pixel units may include an arrangement usually employed in a display device such as a TV set, in which a large number of pixels are arranged on a common substrate. In a display device, the pixels to be arranged on a substrate can be formed in a pixel area defined by a bank. Also, the light-emitting device of the present invention can be used in a lighting device having a planar or curved shape.

The photovoltaic cell includes electrodes comprised of an anode and a cathode, and an organic layer provided between the electrodes, and the metallic composite composition and the like are used in the electrodes. The photovoltaic cell may further include a substrate, a hole injection layer, an electron injection layer, a hole transport layer, an electron transport layer, a charge separation layer and the like.

It is preferable that the charge separation layer of the photovoltaic cell having a layer containing the metallic composite composition and the like contains an electron-donor compound and an electron-acceptor compound.

In the charge separation layer, the electron-donor compound may be contained alone or in combination of two or more types thereof, and the electron-acceptor compound may be contained alone or in combination of two or more types thereof. The electron-donor compound and the electron-acceptor compound are relatively determined based on the energy levels of these compounds.

Examples of the electron-donor compound may include pyrazoline derivatives, arylamine derivatives, stilbene derivatives, triphenyldiamine derivatives, and conjugated macromolecular compounds. Examples of the conjugated macromolecular compounds may include oligothiophene and derivatives thereof, polyfluorene and derivatives thereof, polyvinylcarbazole and derivatives thereof, polysilane and derivatives thereof, polysiloxane derivatives having an aromatic amine in their side chain or main chain, polyaniline and derivatives thereof, polypyrrole and derivatives thereof, polyphenylenevinylene and derivatives thereof, and polythienylenevinylene and derivatives thereof.

Examples of the electron-acceptor compound may include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as C₆₀ and derivatives thereof, phenanthrene derivatives such as bathocuproine, metal oxides such as titanium oxide, and carbon nanotubes. The electron-acceptor compound is preferably titanium oxides, carbon nanotubes, fullerenes or fullerene derivatives, and particularly preferably fullerenes or fullerene derivatives.

The thickness of the charge separation layer is usually 1 nm to 100 µm, more preferably 2 nm to 1000 nm, further preferably 5 nm to 500 nm, and more preferably 20 nm to 200 nm.

### <Method for manufacturing charge separation layer>

The method for manufacturing the charge separation layer may be any method. Examples thereof may include film formation from a solution, or a film-forming method by a vacuum deposition method.

For the film formation from a solution, there can be used an application method such as a spin coating method, a casting method, a micro-gravure coating method, a gravure coating method, a bar coating method, a roll coating method, a wire-bar coating method, a dip coating method, a spray coating method, a screen printing method, a gravure printing method, a flexographic printing method, an off-set printing method, an inkjet printing method, a dispenser printing method, a nozzle coating method and a capillary coating method. Among them, a spin coating method, a flexographic printing method, a gravure printing method, an inkjet printing method or a dispenser printing method is preferred.

The photovoltaic cell having a layer containing the metallic composite composition and the like is usually formed on a substrate. The substrate may be any substrate that does not change during the formation of an electrode and an organic layer. Examples of a material of the substrate may include glass, plastic, macromolecular films and silicon. When the substrate is opaque, it is preferable that an opposite electrode (i.e., an electrode having a longer distance from the substrate) is transparent or translucent.

Examples of a material of the transparent or translucent electrode may include electrically conductive metal oxide films and translucent metal thin films. Specifically, a film formed using an electrically conductive material made of indium oxide, zinc oxide, tin oxide and a complex thereof (for example, indium-tin-oxide, indium·zinc·oxide), NESA, gold, platinum, silver, copper and the like is used. Among them, a film formed using ITO, indium·zinc·oxide or tin oxide is preferred. Examples of the method for manufacturing the electrode may include a vacuum deposition method, a sputtering method, an ion plating method and a plating method. As a material of the electrode, a transparent and electrically conductive film of organic substance such as polyaniline and derivatives thereof, and polythiophene and derivatives thereof may be used. Furthermore, as a material of the electrode, metal, electrically conductive macromolecules and the like can be used. It is preferable that one of a pair of electrodes is made of a material having a low work function. Examples thereof may include metals such as lithium, sodium, potassium, rubidium, cesium, magnesium, calcium, strontium, barium, aluminum, scandium, vanadium, zinc, yttrium, indium, cerium, samarium, europium, terbium and ytterbium; an alloy made of two or more of the metals; an alloy of one or more of the metals, and one or more of gold, silver, platinum, copper, manganese, titanium, cobalt, nickel, tungsten and tin; and graphite or a graphite intercalation compound. Examples of the alloy may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

In order to improve photovoltaic efficiency, an additional intermediate layer other than the charge separation layer may be used in addition to a layer containing a macromolecular compound used in the present invention. As a material of the intermediate layer, for example, halides and oxides of alkali metal and alkaline earth metal such as lithium fluoride are used. Also, fine particles of an inorganic semiconductor such as titanium oxide, PEDOT (poly-3,4-ethylenedioxythiophene), and the like may be used.

The photovoltaic cell can be manufactured by, for example, sequentially stacking each layer described above on a substrate. Since the forming method of each layer other than the charge separation layer can be performed in a similar manner as the light-emitting device already described, detailed descriptions will be omitted.

Although the metallic composite composition and the like are preferably used in a cathode, it can also be used in other layers.

When the metallic composite composition and the like is formed into a film from a solution, there can be used an application method such as a spin coating method, a casting method, a micro-gravure coating method, a gravure coating method, a bar coating method, a roll coating method, a wire-bar coating method, a dip coating method, a spray coating method, a screen printing method, a flexographic printing method, an off-set printing method, an inkjet printing method, a capillary coating method and a nozzle coating method.

For any intended use, the metallic composite composition and the like may be used alone or in combination of two or more types thereof.

### <Use of device>

The photovoltaic cell having a layer containing the metallic composite composition and the like can be operated as an organic thin film solar cell when it is irradiated with light such as sunlight from transparent or translucent electrode to generate a photovoltaic force between the electrodes. It is also possible to use as an organic thin film solar cell module by integrating a plurality of organic thin film solar cells.

It is also possible to operate as an organic optical sensor when a photocurrent flows by irradiation with light from transparent or translucent electrode in a state where a voltage is applied or not applied between the electrodes. It is possible to use an organic image sensor by integrating a plurality of organic optical sensors.

### <Solar cell module>

When the photovoltaic cell disclosed herein is used as an organic thin film solar cell to form a solar cell module, the solar cell module can basically have a similar module structure to that of a conventional solar cell module. The solar cell module usually has a structure in which cells are formed on a supporting substrate, such as metal, and ceramic, and covered with a filler resin, a protective glass or the like, and thus light is captured from the opposite side of the supporting substrate. The solar cell module may also have a structure in which a transparent material such as a reinforced glass is used as the material of a supporting substrate and cells are formed thereon, and thus light is captured from the side of the transparent supporting substrate. Examples of a known structure of the solar cell module may include a module structure of a superstraight type, a substrate type, and a potting type, and a substrate-integrated module structure used in an amorphous silicon solar cell and the like. The structure of a solar cell module including the photovoltaic cell can also be appropriately selected from the above module structures depending on the intended purpose, place, environment, and the like.

In a solar cell module of superstraight type or substrate type which is a typical module structure, solar cells are spaced at certain intervals between a pair of supporting substrates. One or both of the supporting substrates are transparent, and have been subjected to an antireflective treatment. Solar cells adjacent to each other are electrically connected via wiring such as a metal lead and a flexible wire. A current collecting electrode is placed at an external peripheral portion of the module for extracting electric power generated in the solar cell to the exterior. Between the supporting substrate and the solar cell, in order to protect solar cells and improve current collecting efficiency, various types of plastic materials such as ethylene vinyl acetate (EVA) may be provided in a form of a film or a filler resin depending on the intended purpose. When the solar cell module is used at a place where the surface of the solar cell module needs not to be covered with a hard material, for example, at a place unlikely to suffer from impact from outside, one of the supporting substrates can be omitted by forming a surface protective layer with a transparent plastic film or curing the filler resin to impart a protective function. The periphery of the supporting substrate is usually fixed with a frame made of metal in a sandwich shape, and a space between the supporting substrate and the frame is sealed with a sealing material, in order to ensure sealing of the inside and rigidity of the module. The solar cell module can also be formed on a curved surface when a flexible material is used for the solar cell per se, the supporting substrate, the filler material and the sealing material.

When manufacturing a solar cell module using a flexible supporting body such as a polymer film as a supporting substrate, a solar cell module body can be manufactured by sequentially forming solar cells while feeding a roll-shaped flexible supporting body, cutting into a desired size, and then sealing a peripheral portion with a flexible and moisture-proof material. It is also possible to employ a module structure called "SCAF" described in Solar Energy Materials and Solar Cells, 48, p383-391. Furthermore, the solar cell module with the flexible supporting body can also be used in a state of being adhesively bonded to a curved glass or the like.

### Examples

The present invention will be described in detail with reference to examples and comparative examples below. Any examples falling outside the scope of the claims are included for reference purposes.

### <Analysis>

The weight average molecular weight (Mw) and the number average molecular weight (Mn) of a polymer were measured by a gel permeation chromatography (GPC) (manufactured by Tosoh Corporation; trade name: HLC-8220 GPC) as a polystyrene equivalent weight average molecular weight and a polystyrene equivalent number average molecular weight. A sample to be measured was dissolved in tetrahydrofuran so that the concentration of the sample became about 0.5% by weight, and was injected into a GPC in an amount of 50 µL. Furthermore, tetrahydrofuran was used as a mobile phase of GPC, and the mobile phase was flowed at a flow rate of 0.5 mL/min. The detection wavelength was set at 254 nm.

The structural analysis of a polymer was performed by ¹H NMR analysis using a 300 MHz NMR spectrometer (manufactured by Varian, Inc.). The measurement was performed by dissolving a sample in a deuterated solvent capable of dissolving the sample so that the concentration of the sample became 20 mg/mL.

The surface composition analysis of a composite prepared in Examples was performed by measuring an X-ray photoelectron spectrum using a scanning X-ray photoelectron spectrometer (manufactured by Ulvac-Phi, Inc., trade name: Quantera SXM). The analysis method was X-ray photoelectron spectrometry (hereinafter, referred to as "XPS") with an X-ray source of AlK α rays (1486.6 eV), an X-ray spot diameter of 100 µm, and a neutralization condition of using a neutralization electron gun and a low speed Ar ion gun. The sample was measured in a state where the sample was packed in a stainless-steel cup.

An orbital energy of a HOMO of a polymer was obtained from an ionization potential of the polymer. An orbital energy of a LUMO was obtained from the ionization potential and a difference between the orbital energy of a HOMO and the orbital energy of a LUMO. For measurement of the ionization potential, a photoelectron spectrometer (manufactured by Riken Keiki Co., Ltd.: AC-2) was used. The difference between the orbital energy of a HOMO and the orbital energy of a LUMO was obtained from an absorption edge of the absorption spectrum of a polymer measured using an ultraviolet-visible-near-infrared spectrophotometer (manufactured by Varian, Inc.: Cary SE). Specifically, the ionization potential of the obtained polymer was measured in the atmosphere. A sample to be measured was produced by preparing a 1% by weight solution of a polymer in chloroform, spin coating the solution on a quartz substrate at a revolution of 1000 rpm for 30 seconds, and drying the obtained product at 100°C for 15 minutes. The band gap of the obtained polymer was obtained from the absorption edge of the absorption spectrum of the polymer measured in the atmosphere using the same sample as that used in the measurement of an ionization potential.

The sheet resistance (Ω/□) of a thin film prepared in Examples was measured using a resistivity meter (Loresta GP MCP-T610 type manufactured by Mitsubishi Chemical Corporation).

The total light transmittance (%) of a thin film prepared in Examples was measured using a direct-reading haze meter (HGM-2DP manufactured by Suga Test Instruments Co., Ltd.).

### <Synthesis Example 1> (Synthesis of silver nanostructure A)

A 50 mL flask containing 5 mL of ethylene glycol was immersed in an oil bath at 150°C, and the ethylene glycol was pre-heated while bubbling with air for 60 minutes. After the pre-heating, the air was exchanged with a nitrogen gas, and bubbling was stopped. Next, in the resultant product, 1.5 mL of a 0.1 M silver nitrate-ethylene glycol solution, 1.5 mL of a 0.15 M polyvinylpyrrolidone (hereinafter referred to as "PVP") (weight average molecular weight: 5.5 × 10⁴)-ethylene glycol solution, and 40 µL of a 4 mM copper chloride dihydrate-ethylene glycol solution were added, and the mixture was stirred for 120 minutes. Thus, a dispersion liquid of a silver nanostructure was obtained. The obtained dispersion liquid was cooled to 40°C and then subjected to centrifugation to obtain a precipitate. The obtained precipitate was dried, thus obtaining a silver nanostructure (hereinafter referred to as "silver nanostructure A").

The obtained silver nanostructure A was subjected to visual observation with a photograph thereof by a scanning electron microscopy (manufactured by JEOL Ltd., trade name: JSM-5500) (hereinafter, referred to as "SEM"). Based on the observation, the silver nanostructure A had a wire shape with the shortest diameter of about 30 nm, and the longest diameter of about 15 µm. The average value of the aspect ratios for at least 10 silver nanostructures observed by the above method was about 500. It was confirmed by XPS measurement that PVP coexisted during the synthesis was adsorbed to the silver nanostructure A.

### <Synthesis Example 2> (Synthesis of conjugated compound P-1)

Into a 300 mL flask, 2,7-dibromo-9-fluorenone (52.5 g), ethyl salicylate (154.8 g), and mercaptoacetic acid (1.4 g) were charged, and a gas in the flask was purged with nitrogen. Thereto, methanesulfonic acid (630 mL) was added, and the mixture was stirred at 75°C overnight. The mixture was left to cool down, added into ice water and stirred for 1 hour. Thus, a solid was produced. The produced solid was filtrated, and washed with heated acetonitrile. The washed solid was dissolved in acetone, and a solid was re-crystallized from the obtained acetone solution, and filtrated. The obtained solid (62.7 g), 2-[2-(2-methoxyethoxy)ethoxy]ethoxy-p-toluenesufonate (86.3 g), potassium carbonate (62.6 g), and 1,4,7,10,13,16-hexaoxacyclooctadecane (sometimes referred to as "18-crown-6") (7.2 g) were dissolved in N,N-dimethylformamide (DMF) (670 mL), and the solution was transferred into a flask and stirred at 105°C overnight. The obtained mixture was left to cooled down to room temperature, added into ice water, and stirred for 1 hour. Then, chloroform was added to the reaction liquid, and separation-extraction was performed. The solution was concentrated, thus obtaining 2,7-dibromo-9,9-bis[3-ethoxycarbonyl-4-[2-[2-(2-methoxyethoxy)ethoxy]ethoxy]phenyl]-fluorene (compound D) (51.2 g).

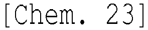

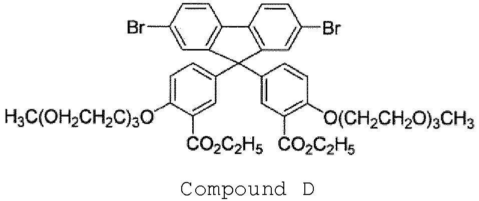

The inside of a flask was set under a nitrogen atmosphere. Then, the compound D (15 g), bis(pinacolato)diboron (8.9 g), [1,1'-bis(diphenylphosphino)ferrocene]dichloro palladium (II) dichloromethane complex (0.8 g), 1,1'-bis(diphenylphosphino)ferrocene (0.5 g), potassium acetate (9.4 g), and dioxane (400 mL) were mixed in the flask. The mixture was heated to 110°C, and subjected to heat-reflux for 10 hours. The reaction liquid was left to cool down, and then filtrated. The filtrate was concentrated under reduced pressure. The residue was washed with methanol three times, and dissolved in toluene. Activated carbon was added to the solution, and the resultant product was stirred. Then, filtration was performed, and the filtrate was concentrated under reduced pressure, thus obtaining 2,7-bis(4,4,5,5-tetramethyl-1,3,2-dioxaborolan-2-yl)-9,9-bis[3-ethoxycarbonyl-4-[2-[2-(2-methoxyethoxy)ethoxy]ethoxy]phenyl]-fluorene (compound E) (11.7 g).

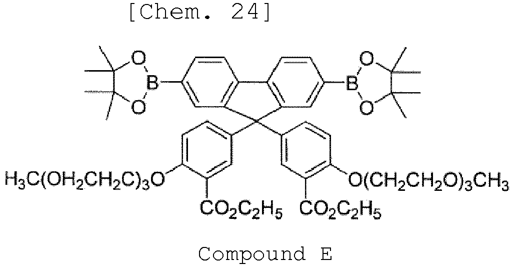

The inside of a flask was set under an inert gas atmosphere. Then, the compound D (0.55 g), the compound E (0.61 g), triphenylphosphine palladium (0.01 g), methyl trioctyl ammonium chloride (manufactured by Aldrich, trade name: Aliquat 336 (registered trade mark)) (0.20 g, manufactured by Aldrich), and toluene (10 mL) were mixed in the flask, and heated to 105°C. Into the reaction liquid, a 2 M aqueous solution of sodium carbonate (6 mL) was added dropwise, and the mixture was refluxed for 8 hours. Then, 4-tert-butylphenylboronic acid (0.01 g) was added into the reaction liquid, and the mixture was refluxed for 6 hours. Next, an aqueous solution of sodium diethyldithiacarbamate (10 mL, concentration: 0.05 g/mL) was added in the resultant product, and the mixture was stirred for 2 hours. The mixed solution was added dropwise into 300 mL of methanol, and the mixture was stirred for 1 hour. Then, the deposited precipitate was filtrated, dried under reduced pressure for 2 hours, and dissolved in 20 mL of tetrahydrofuran. The obtained solution was added dropwise into a mixed liquid of 120 mL of methanol and 50 mL of a 3% by weight aqueous solution of acetic acid, and the mixture was stirred for 1 hour. Then, the deposited precipitate was filtrated, and dissolved in 20 mL of tetrahydrofuran. The solution thus obtained was added dropwise into 200 mL of methanol, and the mixture was stirred for 30 minutes. Then, the deposited precipitate was filtrated, and a solid was obtained. The obtained solid was dissolved in tetrahydrofuran, and the solution was passed through an alumina column and a silica gel column for purification. The tetrahydrofuran solution recovered from the columns was concentrated, and then added dropwise into methanol. The deposited solid was filtrated, and dried. The yield of the obtained poly[9,9-bis[3-ethoxycarbonyl-4- [2-[2-(2-methoxyethoxy)ethoxy]ethoxy]phenyl]-fluorene] (compound F) was 520 mg.

The polystyrene equivalent number average molecular weight of compound F was 5.2 × 10⁴. From the result of NMR, compound F has a repeating unit represented by formula below.

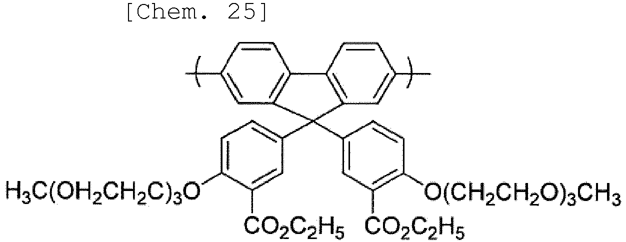

Compound F (200 mg) was charged into a 100 mL flask, and a gas in the flask was purged with a nitrogen gas. Tetrahydrofuran (20 mL) and ethanol (20 mL) were added in the mixture, and the temperature of the mixture was elevated to 55°C. Thereto, an aqueous solution in which cesium hydroxide (200 mg) was dissolved in water (2 mL) was added, and the mixture was stirred at 55°C for 6 hours. The mixture was cooled down to room temperature. Then, the reaction solvent was distilled off under reduced pressure, and thus a solid was formed. The formed solid was washed with water, and dried under reduced pressure, thus obtaining a pale yellow solid (150 mg, cesium salt of compound F, hereinafter referred to as "conjugated compound P-1") was obtained. By the NMR spectrum, it was confirmed that a signal attributed to an ethyl group at an ethyl ester moiety in compound F completely disappeared. Conjugated compound P-1 includes a repeating unit represented by formula below. The orbital energy of a HOMO of conjugated compound P-1 was -5.5 eV, and the orbital energy of a LUMO was -2.7 eV.

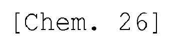

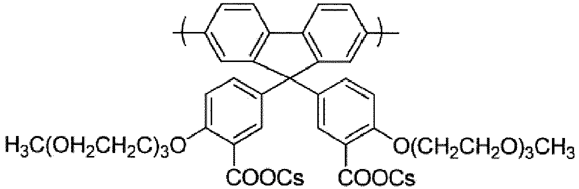

The polystyrene equivalent number average molecular weight of conjugated compound P-1 was approximately similar to that of compound F.

### <Synthesis example 3> (Synthesis of metallic composite C)

Into 10 mL of a methanol solution (100 µM based on a monomer of a repeating unit) of conjugated compound P-1, 40 mg of silver nanostructure A was added, and dispersed by ultrasonic waves. Thereafter, the resultant product was stirred for 2 hours, and then subjected to centrifugation. The supernatant was removed. Into the residue, 10 mL of a methanol solution (100 µM based on a monomer of a repeating unit) of conjugated compound P-1 was added, and the mixture was dispersed by ultrasonic waves, stirred for 2 hours, and subjected to centrifugation, and the supernatant was removed. This set of operations was repeated five times. Next, 20 mL of methanol was added in the resultant product, and dispersed by ultrasonic waves. Thereafter, the solution was stirred for 1 hour, and then subjected to centrifugation, and the supernatant was removed. Into the obtained product, 20 mL of methanol was added, dispersed by ultrasonic waves, stirred for 1 hour, and subjected to centrifugation, and the supernatant was removed. This set of operations was repeated five times, and the residue was dried. With respect to the obtained solid, a substance adsorbed to the surface of the silver nanostructure was measured using a scanning X-ray photoelectron spectrometer (manufactured by Ulvac-Phi, Inc., trade name: Quantera SXM). As a result, a peak of a cesium atom attributed to a Cs cation of conjugated compound P-1 was obtained. From this fact, it could be confirmed that the obtained product was a composite (hereinafter, referred to as "metallic composite C") in which conjugated compound P-1 was adsorbed to silver nanostructure A.

### <Synthesis example 4> (Synthesis of hole transport material B)

The inside of a flask was set under an inert gas atmosphere. Then, 2,7-dibromo-9,9-di(octyl)fluorene (1.4 g, 2.5 mmol), 2,7-bis(4,4,5,5-tetramethyl-1,3,2-dioxaborolane-2-yl)-9,9-di(octyl)fluorene (6.4 g, 10.0 mmol), N,N-bis(4-bromophenyl)-N',N'-bis(4-butylphenyl)-1,4-phenylenediamine (4.1 g, 6 mmol), bis(4-bromophenyl)benzocyclobuteneamine (0.6 g, 1.5 mmol), tetraethyl ammonium hydroxide (1.7 g, 2.3 mmol), palladium acetate (4.5 mg, 0.02 mmol), tri(2-methoxyphenyl)phosphine (0.03 g, 0.08 mmol), and toluene (100 mL) were mixed in the flask, and the mixture was heated and stirred at 100°C for 2 hours. Next, phenyl boronic acid (0.06 g, 0.5 mmol) was added, and the obtained mixture was stirred for 10 hours. The obtained product was left to cool down, and then the aqueous layer was removed. An aqueous solution of sodium diethyldithiocarbamate was added and the resultant mixture was stirred, and then the aqueous layer was removed. The organic layer was washed with water and 3% by weight aqueous acetic acid sequentially. The organic layer was poured in methanol to precipitate a polymer. The polymer was filtered out, and dissolved in toluene again. The solution was passed through a silica gel column and an alumina column. The eluted toluene solution containing a polymer was recovered, and the recovered toluene solution was poured in methanol to precipitate a polymer. The precipitated polymer was filtered out, and vacuum-dried at 50°C, thus obtaining a macromolecular compound that is hole transport material B (12.1 g) was obtained. According to gel permeation chromatography, the polystyrene equivalent weight average molecular weight of the obtained hole transport material B was 3.0 × 10⁵, and the molecular weight distribution index (Mw/Mn) thereof was 3.1.

Hole transport material B is a copolymer having a constitutional unit represented by the following formula: 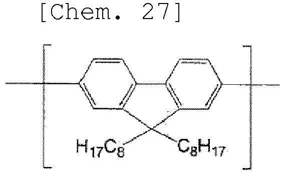 , a constitutional unit represented by the following formula: 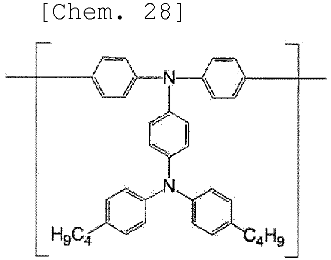 , and a constitutional unit represented by the following formula: 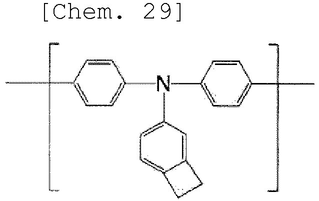 in a molar ratio of 62.5:30:7.5 (a theoretical value calculated from charged amounts of the raw materials).

### <Synthesis example 5> (Synthesis of light-emitting material B)

The inside of a flask was set under an inert gas atmosphere. Then, 2,7-dibromo-9,9-di(octyl)fluorene (9.0 g, 16.4 mmol), N,N'-bis(4-bromophenyl)-N,N'-bis(4-tert-butyl-2,6-dimethylphenyl)1,4-phenylenediamine (1.3 g, 1.8 mmol), 2,7-bis(4,4,5,5-tetramethyl-1,3,2-dioxaborolane-2-yl)-9,9-di(4-hexylphenyl)fluorene (13.4 g, 18.0 mmol), tetraethyl ammonium hydroxide (43.0 g, 58.3 mmol), palladium acetate (8 mg, 0.04 mmol), tri(2-methoxyphenyl)phosphine (0.05 g, 0.1 mmol), and toluene (200 mL) were mixed in the flask, and the mixture was heated and stirred at 90°C for 8 hours. Next, phenyl boronic acid (0.22 g, 1.8 mmol) was added, and the obtained mixture was stirred for 14 hours. The resultant product was left to cool down, and then the aqueous layer was removed. An aqueous solution of sodium diethyldithiocarbamate was added and the resultant mixture was stirred, and then the aqueous layer was removed. The organic layer was washed with water and 3% by weight aqueous acetic acid sequentially. The organic layer was poured in methanol to precipitate a polymer. The polymer was filtered out, and dissolved in toluene again. The solution was passed through a silica gel column and an alumina column. The eluted toluene solution containing a polymer was recovered, and the recovered toluene solution was poured in methanol to precipitate a polymer. The precipitated polymer was vacuum-dried at 50°C, thus obtaining a macromolecular compound that is light-emitting material B (12.5 g) was obtained. According to gel permeation chromatography, the polystyrene equivalent weight average molecular weight of the obtained light-emitting material B was 3.1 × 10⁵, and the molecular weight distribution index (Mw/Mn) thereof was 2.9.

Light-emitting material B is a copolymer having a constitutional unit represented by the following formula: 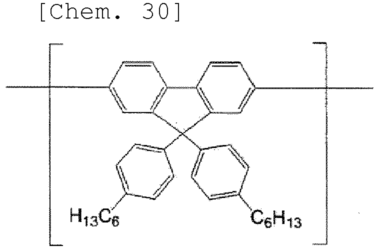 , a constitutional unit represented by the following formula: 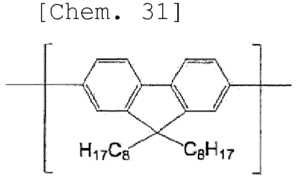 , and a constitutional unit represented by the following formula: 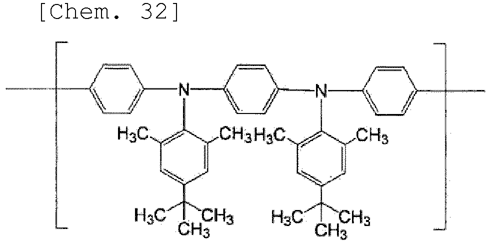 in a molar ratio of 50:45:5 (a theoretical value calculated from charged amounts of the raw materials).

### <Example 1> (Manufacture of light-emitting device k-1)

First, on ITO of a glass substrate having a film of ITO formed thereon as an anode, 0.5 mL of poly(3,4-ethylenedioxythiophene)/polystyrenesulfonic acid (manufactured by H. C. Starck GmbH, a PEDOT:PSS solution, trade name: CLEVIOS (registered trade mark) P VP Al 4083) as a solution of a hole injection material was applied, and a film was formed by a spin coating method so as to have a thickness of 70 nm. The obtained glass substrate having a film formed thereon was heated in air at 200°C for 10 minutes. Then, the substrate was allowed to cool down to room temperature, thus obtaining glass substrate A having a hole injection layer formed thereon.

Second, 5.2 mg of hole transport material B and 1 mL of xylene were mixed to prepare a composition for a hole transport layer having a content of the hole transporting material B of 0.6% by weight.

The composition for a hole transport layer was applied by a spin coating method onto glass substrate A having the hole injection layer formed thereon, to form a coating film having a thickness of 33 nm. The glass substrate on which the coating film was formed was heated under a nitrogen atmosphere at 200°C for 20 minutes to make the coating film insoluble, and thereafter allowed to cool down to room temperature, thus obtaining glass substrate B having a hole transport layer formed thereon.

Third, 11.3 mg of light-emitting material B and 1 mL of xylene were mixed to prepare a composition for a light-emitting layer having the content of the light-emitting material B of 1.3% by weight.

The composition for a light-emitting layer was applied by a spin coating method onto glass substrate B having the hole transport layer formed thereon, to form a coating film having a thickness of 99 nm. The substrate on which the coating film was formed was heated under a nitrogen atmosphere at 130°C for 15 minutes. Then, the solvent was evaporated. Thereafter, the substrate was allowed to cool down to room temperature, thus obtaining glass substrate C having a light-emitting layer formed thereon.

Fourth, about 0.2 parts by weight of conjugated compound P-1, about 0.07 parts by weight of cesium hydroxide monohydrate, and about 98.73 parts by weight of methanol were mixed into about 1.0 part by weight of silver nanowire A. The mixture was stirred for 1 hour, and thus a dispersion liquid of a metallic composite composition (100 parts by weight) was obtained. In this dispersion liquid, metallic composite C obtained in Synthesis example 3 (a composite in which conjugated compound P-1 was adsorbed to silver nanostructure A) and an ionic compound (cesium hydroxide monohydrate) are dispersed.

The dispersion liquid of the metallic composite composition was applied by a casting method onto glass substrate C having the light-emitting layer formed thereon, thus obtaining a layered structure m-1 including the metallic composite composition. Here, the metallic composite composition serves as a cathode.

Lastly, the layered structure m-1 in which a cathode was formed was sealed with sealing glass and a two-liquid mixing-type epoxy resin (manufactured by Robnor Resins Ltd., trade name: PX681C/NC) under a nitrogen atmosphere, thus manufacturing light-emitting device k-1.

A forward voltage of 12 V was applied to light-emitting device k-1, and a forward voltage of 12 V was applied again. Then, the light-emitting brightness was measured. As a result, a brightness of 77.8 cd/m² was obtained. Light-emitting device k-1 is a dual-sided light-emitting device. The light-emitting brightness of light-emitting device k-1 as a whole, which is obtained by adding the light-emitting brightness of a side closer to an anode and the light-emitting brightness of a side closer to a cathode, becomes about twice the above value.

### <Comparative example 1> (Manufacture of light-emitting device k-2)

A light-emitting device (hereinafter, referred to as "light-emitting device k-2") was manufactured in a similar manner as Example 1 except that a dispersion liquid (100 parts by weight) of a metallic composite obtained by mixing about 0.2 parts by weight of conjugated compound P-1 and about 98.8 parts by weight of methanol in about 1.0 part by weight of silver nanostructure A and stirring the mixture for 1 hour was used instead of the dispersion liquid of a metallic composite composition in Example 1. A forward voltage of 12 V was applied to light-emitting device k-2, and the light-emitting brightness was measured. As a result, a brightness of 1.1 cd/m² was obtained. Light-emitting device k-2 is a dual-sided light-emitting device. The light-emitting brightness of light-emitting device k-2 as a whole, which is obtained by adding the light-emitting brightness of a side closer to an anode and the light-emitting brightness of a side closer to a cathode, becomes about twice the above value.

### <Example 2> (Manufacture of light-emitting device k-3)

A light-emitting device (hereinafter, referred to as "light-emitting device k-3") was manufactured in a similar manner as Example 1 except that a dispersion liquid (100 parts by weight) of a metallic composite composition obtained by mixing about 0.2 parts by weight of conjugated compound P-1, about 0.01 parts by weight of cesium acetate, and about 98.79 parts by weight of methanol in about 1.0 part by weight of silver nanowire A and stirring the mixture for 1 hour was used instead of the dispersion liquid of a metallic composite composition in Example 1. A forward voltage of 15 V was applied to light-emitting device k-3. As a result, the light-emitting brightness was 370 cd/m².

### <Example 3> (Manufacture of light-emitting device k-4)

A light-emitting device (hereinafter, referred to as "light-emitting device k-4") was manufactured in a similar manner as Example 2 except that cesium benzoate was used instead of cesium acetate in Example 2. A forward voltage of 15 V was applied to light-emitting device k-4. As a result, the light-emitting brightness was 460 cd/m².

### <Example 4> (Manufacture of light-emitting device k-5)

A light-emitting device (hereinafter, referred to as "light-emitting device k-5") was manufactured in a similar manner as Example 2 except that cesium 4-pyridinecarboxylate was used instead of cesium acetate in Example 2. A forward voltage of 15 V was applied to light-emitting device k-5. As a result, the light-emitting brightness was 195 cd/m².

### <Evaluation>

The light-emitting devices including the metallic composite composition and the like are excellent in light-emitting brightness, compared to the light-emitting device not including the metallic composite composition and the like.

## Claims

1. A light-emitting device comprising an anode, a cathode, and a light-emitting layer provided between the anode and the cathode,
**characterized in that** the cathode comprises a metallic composite composition comprising:
(1) a metallic composite in which a conjugated compound having a polystyrene equivalent number average molecular weight of 1.0 x 10³ to 5.0 x 10⁶ as measured by gel permeation chromatography is adsorbed to a metallic nanostructure having the shape of a nanowire that is a metal or a metal oxide selected from the group consisting of indium oxide, zinc oxide, tin oxide, indium tin oxide, aluminum zinc oxide, indium zinc oxide, tin antimony oxide and NESA and having an aspect ratio of 1.5 or more; and
(2) an ionic compound, with the proviso that when the ionic compound is a conjugated compound, the ionic compound is a conjugated compound having a molecular weight of less than 200,
wherein the ionic compound is a compound having a structure represented by Formula (hh-1) below:
M^{m'+}ₐX^{'n'-}_{b} (hh - 1)
wherein
M^{m'+} represents an alkali metal cation,
X^{'n'-} represents an anion,
a and b each independently represent an integer of 1 or more, and
when each of M^{m'+} and X^{'n'-} is plurally present, they each may be the same as or different from each other, wherein the ionic compound is a compound having a molecular weight of less than 500, and the amount of the ionic compound is 1 to 50 parts by weight, with respect to 100 parts by weight of the metallic composite.

2. The light-emitting device of claim 1, wherein the conjugated compound having a polystyrene equivalent number average molecular weight of 1.0 x 10³ to 5.0 x 10⁶ is an aromatic compound, and the metallic nanostructure is a metallic nanostructure of a metal of Group 11 of the Periodic Table.

3. The light-emitting device of claim 2, wherein the conjugated compound having a polystyrene equivalent number average molecular weight of 1.0 x 10³ to 5.0 x 10⁶ is an aromatic compound having a hetero atom-containing group.

4. The light-emitting device of claim 3, wherein the hetero atom-containing group is a monovalent group selected from the group (Group 1) consisting of a mercapto group, a mercaptocarbonyl group, a mercaptothiocarbonyl group, a hydrocarbylthio group optionally having a substituent, a hydrocarbylthiocarbonyl group optionally having a substituent, a hydrocarbyldithio group optionally having a substituent, a hydroxyl group, a hydrocarbyloxy group optionally having a substituent, a carboxyl group, a hydrocarbylcarbonyl group optionally having a substituent, a cyano group, an amino group, a hydrocarbylamino group optionally having a substituent, a dihydrocarbylamino group optionally having a substituent, a phosphino group, a hydrocarbylphosphino group optionally having a substituent, a dihydrocarbylphosphino group optionally having a substituent, a group represented by formula: -P(=O)(OH)₂, a sulfo group, a monovalent heterocyclic group, a halogen atom, a formyl group, a hydrocarbyloxycarbonyl group optionally having a substituent, a hydrocarbylcarbonyloxy group optionally having a substituent, a nitro group, a group represented by formula: -OP(=O)(OH)₂, a carbamoyl group, a hydrocarbylcarbamoyl group optionally having a substituent, a dihydrocarbylcarbamoyl group optionally having a substituent, a group represented by formula:-C(=S)NR₂, a group represented by formula: -B(OH)₂, a group represented by formula: -BR₂, a boric acid ester residue, a group represented by formula: -Si(OR)₃, a hydrocarbylsulfo group optionally having a substituent, a hydrocarbylsulfonyl group optionally having a substituent, a sulfino group, a hydrocarbylsulfino group optionally having a substituent, a group represented by formula:-NRC(=O)OR, a group represented by formula: -NRC(=O)SR, a group represented by formula: -NRC(=S)OR, a group represented by formula: -NRC(=S)SR, a group represented by formula: -OC(=O)NR₂, a group represented by formula:-SC(=O)NR₂, a group represented by formula: -OC(=S)NR₂, a group represented by formula: -SC(=S)NR₂, a group represented by formula: -NRC(=O)NR₂, and a group represented by formula: -NRC(=S)NR₂, wherein R represents a hydrogen atom or a hydrocarbyl group optionally having a substituent.

5. The light-emitting device of claim 3, wherein the hetero atom-containing group is a monovalent group selected from the group (Group 2) consisting of a hydrocarbyl group having two or more ether bonds, a hydrocarbyl group having two or more ester bonds, a hydrocarbyl group having two or more amido bonds, a group represented by formula: -SM, a group represented by formula: -C(=O)SM, a group represented by formula: -CS₂M, a group represented by formula: -OM, a group represented by formula: -CO₂M, a group represented by formula: -NM₂, a group represented by formula: -NHM, a group represented by formula: -NRM, a group represented by formula: -PO₃M, a group represented by formula:-OP(=O)(OM)₂, a group represented by formula: -P(=O)(OM)₂, a group represented by formula: -C(=O)NM₂, a group represented by formula:
-C(=O)NHM, a group represented by formula: -C(=O)NRM, a group represented by formula: -C(=S)NHM, a group represented by formula: -C(=S)NRM, a group represented by formula: -C(=S)NM₂, a group represented by formula: -B(OM)₂, a group represented by formula: -BR₃M, a group represented by formula: -B(OR)₃M, a group represented by formula: -SO₃M, a group represented by formula: -SO₂M, a group represented by formula: -NRC(=O)OM, a group represented by formula:-NRC(=O)SM, a group represented by formula: -NRC(=S)OM, a group represented by formula: -NRC(=S)SM, a group represented by formula: -OC(=O)NM₂, a group represented by formula: -OC(=O)NRM, a group represented by formula: -OC(=S)NM₂, a group represented by formula: -OC(=S)NRM, a group represented by formula: -SC(=O)NM₂, a group represented by formula: -SC(=O)NRM, a group represented by formula: -SC(=S)NM₂, a group represented by formula:-SC(=S)NRM, a group represented by formula: -NRC(=O)NM₂, a group represented by formula: -NRC(=O)NRM, a group represented by formula: -NRC(=S)NM₂, a group represented by formula: -NRC(=S)NRM, a group represented by formula:-NR₃M', a group represented by formula: -PR₃M', a group represented by formula: -OR₂M', a group represented by formula: -SR₂M', a group represented by formula: -IRM', and a monovalent heterocyclic group having a cationized nitrogen atom within the heterocycle, wherein R represents a hydrogen atom or a hydrocarbyl group optionally having a substituent, M represents a metal cation or an ammonium cation optionally having a substituent, and M' represents an anion.

6. The light-emitting device of any one of claims 3 to 5, wherein the conjugated compound having a polystyrene equivalent number average molecular weight of 1.0 x 10³ to 5.0 x 10⁶ comprises at least one type of group selected from the Group 1 and at least one type of group selected from the Group 2.

7. The light-emitting device of any one of claims 1 to 6, wherein the conjugated compound having a polystyrene equivalent number average molecular weight of 1.0 x 10³ to 5.0 x 10⁶ comprises a group represented by Formula (I) below, or a repeating unit represented by Formula (II) below, or both of them: 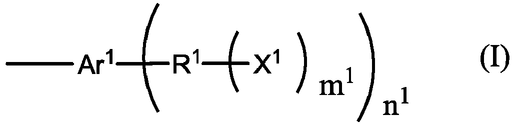 wherein
Ar¹ represents an (n¹+1) valent aromatic group,
R¹ represents a direct bond or an (m¹+1) valent group,
X¹ represents a hetero atom-containing group,
m¹ and n¹ each independently represent an integer of 1 or more, and
when each of R¹, X¹ and m¹ is plurally present, they each may be the same as or different from each other; 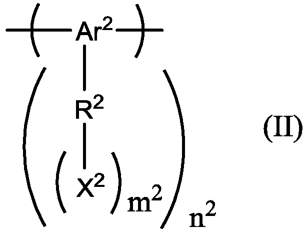
wherein
Ar² represents an (n²+2) valent aromatic group,
R² represents a direct bond or an (m²+1) valent group,
X² represents a hetero atom-containing group,
m² and n² each independently represent an integer of 1 or more, and
when each of R², X² and m² is plurally present, they each may be the same as or different from each other.

8. The light-emitting device of claim 7, wherein the (n¹+1) valent aromatic group represented by Ar¹ is a residue remaining after removing (n¹+1) hydrogen atoms directly bonding to carbon atoms that constitute a ring of an aromatic compound represented by any one of formulae below, the (n²+2) valent aromatic group represented by Ar² is a residue remaining after removing (n²+2) hydrogen atoms directly bonding to carbon atoms that constitute a ring of an aromatic compound represented by any one of formulae below, and the aromatic groups are optionally substituted.

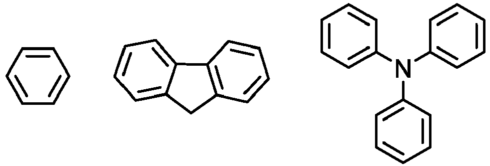

9. The light-emitting device of any one of claims 1 to 8, wherein the conjugated compound having a polystyrene equivalent number average molecular weight of 1.0 x 10³ to 5.0 x 10⁶ is a macromolecular compound having one or more repeating units selected from the group consisting of repeating units represented by the following formulae: 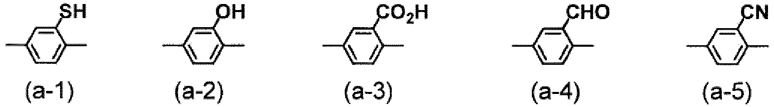 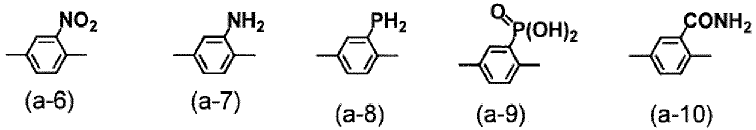 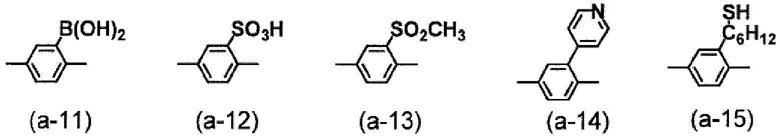 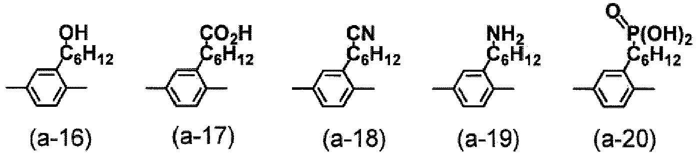 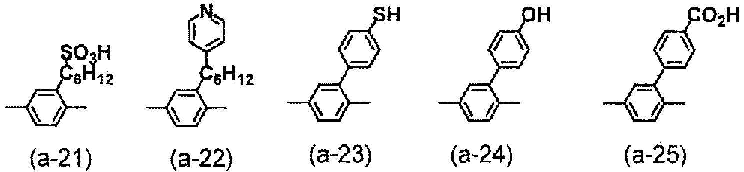 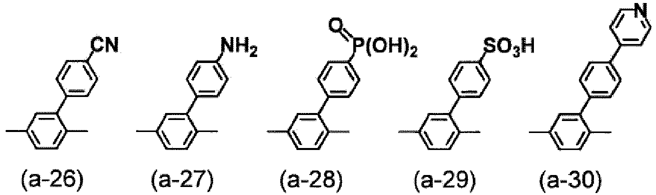 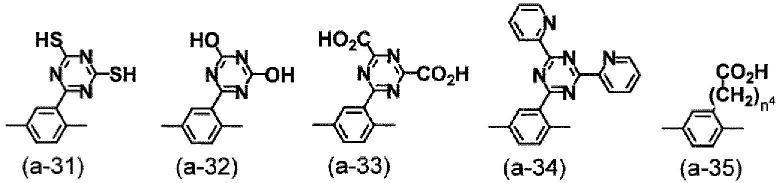 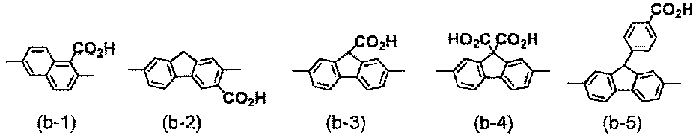 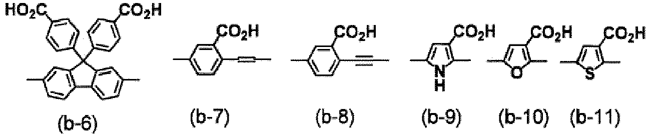 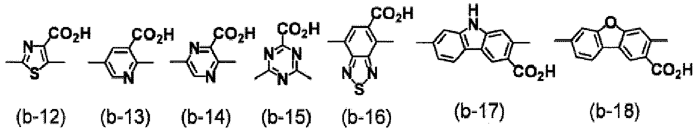 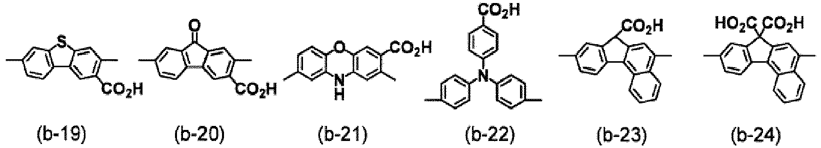 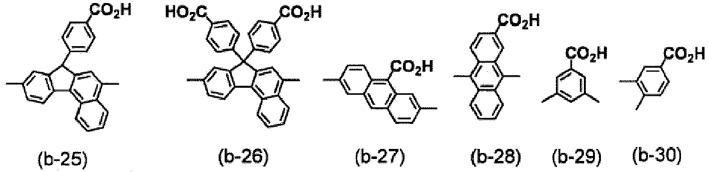 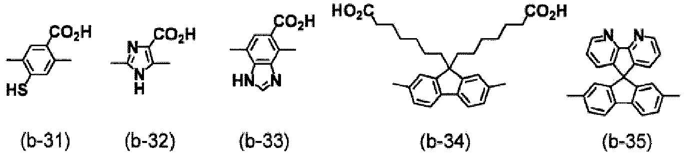 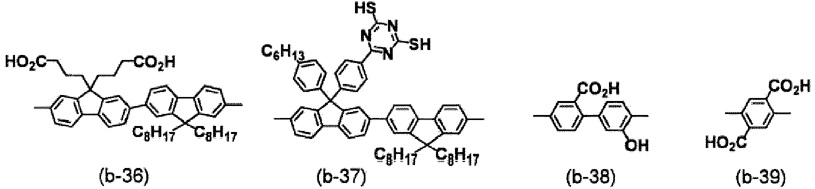 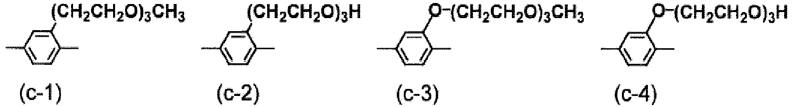 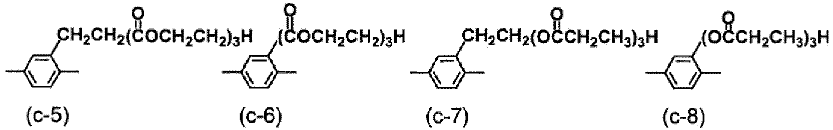 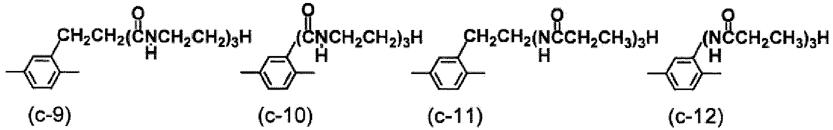 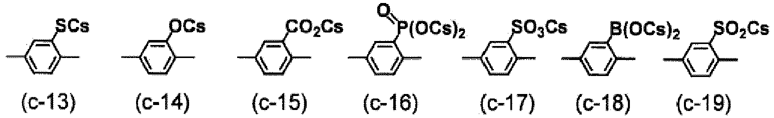 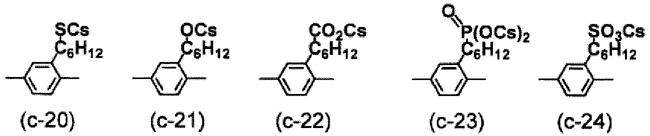 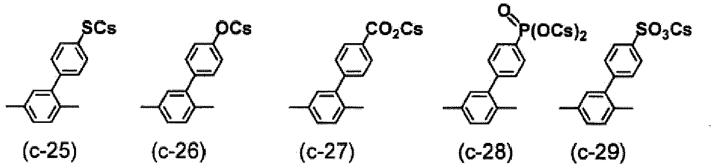 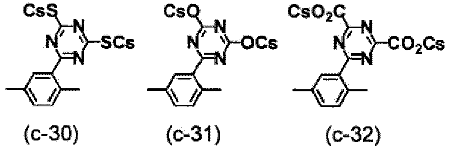 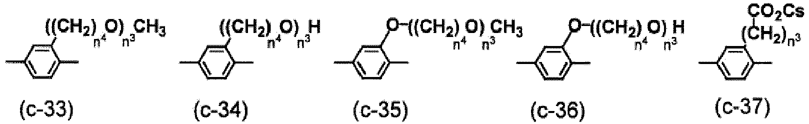 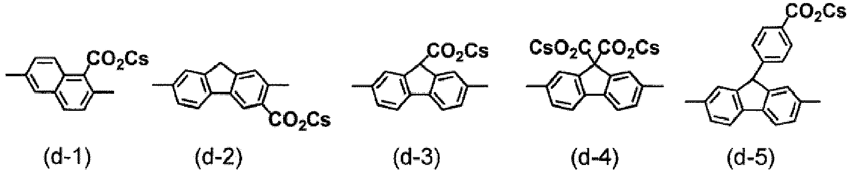 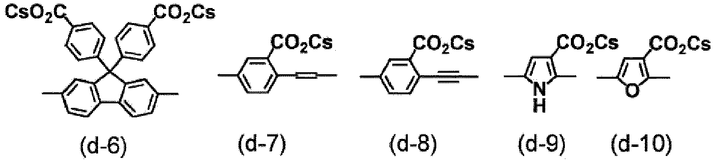 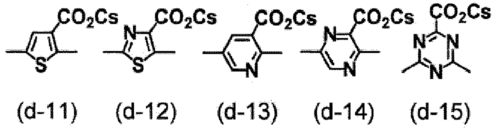 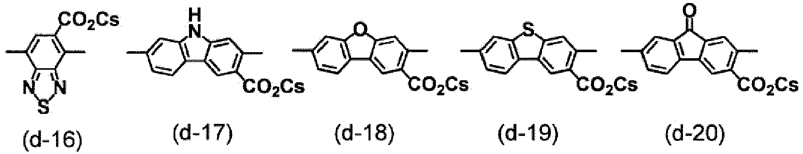 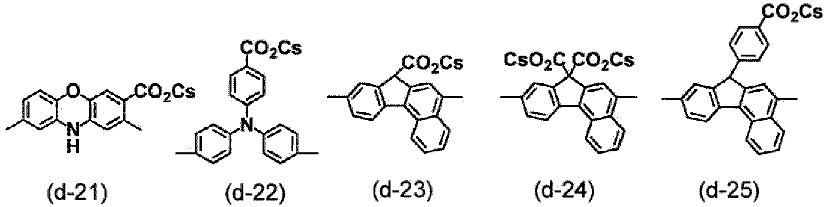 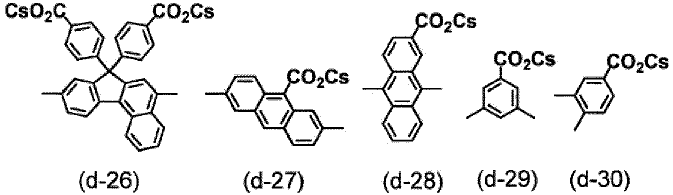 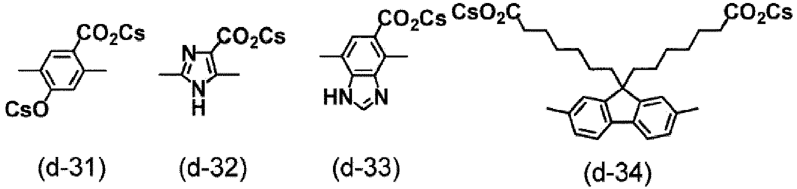 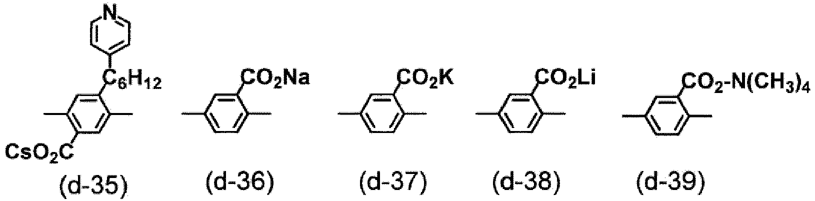 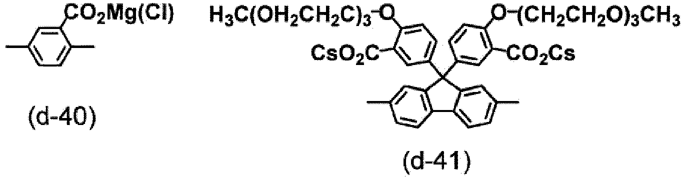 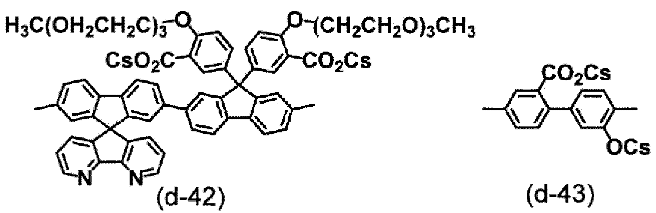 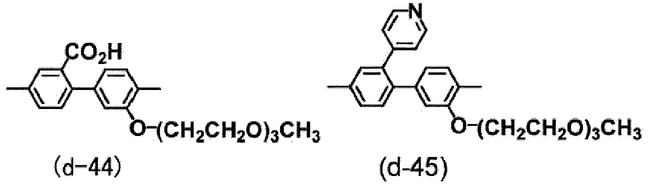 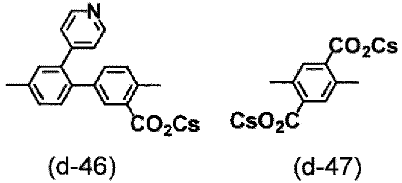 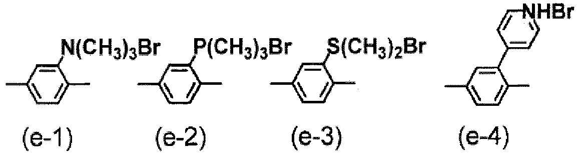 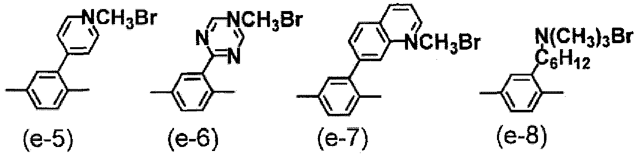 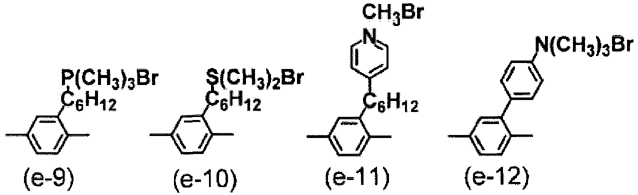 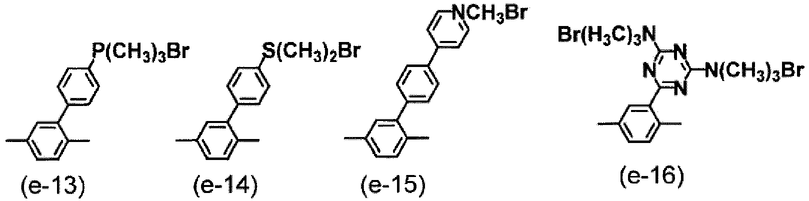 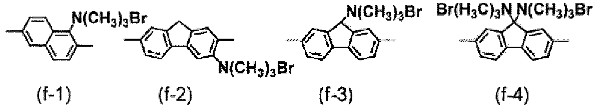 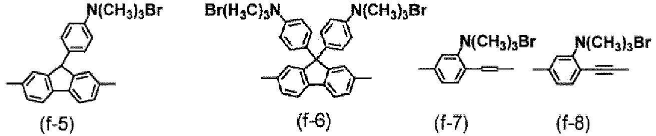 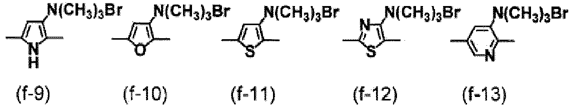 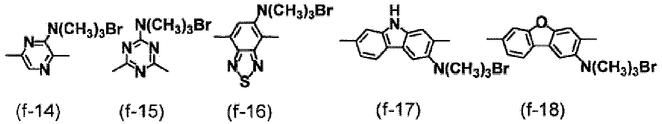 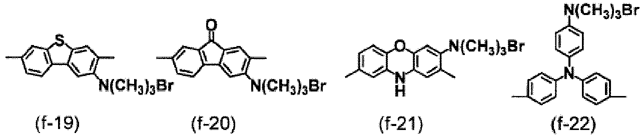 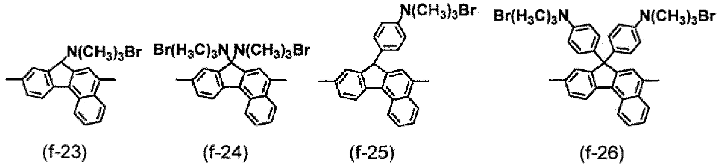 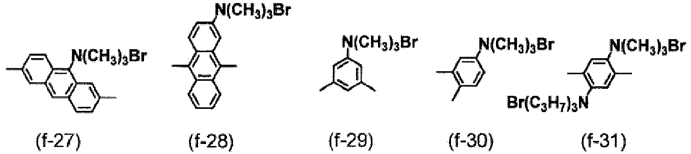 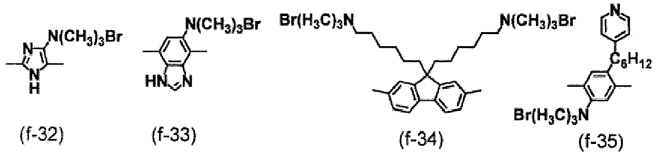 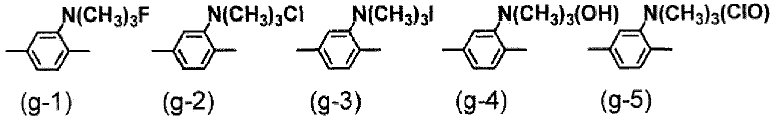 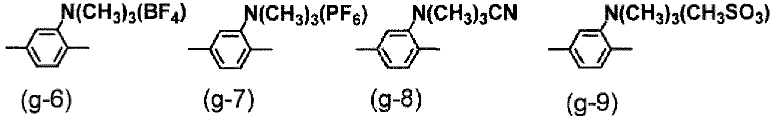 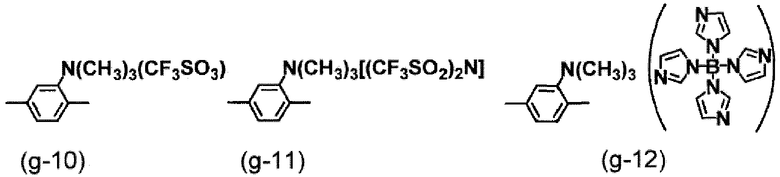 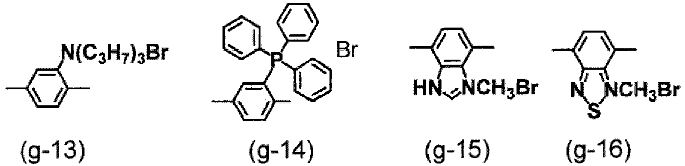 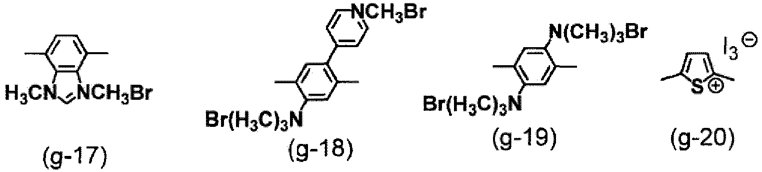 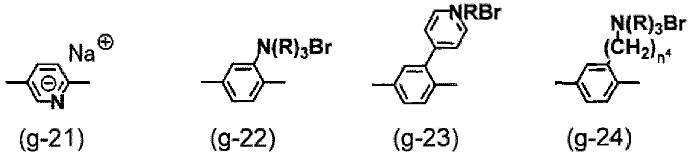 wherein n³ represents an integer of 2 or more, n⁴ represents an integer of 1 or more, and R represents a hydrogen atom or a hydrocarbyl group optionally having a substituent.

10. The light-emitting device of claim 9, wherein the conjugated compound having a polystyrene equivalent number average molecular weight of 1.0 x 10³ to 5.0 x 10⁶ is a macromolecular compound having one or more repeating units selected from the group consisting of repeating units represented by Formulae (b-6), (b-34), (b-37), (c-1), (c-2), (c-3), (c-4), (d-38), (d-41) and (d-42).

## Patentansprüche

1. Eine lichtemittierende Vorrichtung, umfassend eine Anode, eine Kathode und eine lichtemittierende Schicht, die zwischen der Anode und der Kathode bereitgestellt ist, **dadurch gekennzeichnet, dass** die Kathode eine metallische Verbundstoffzusammensetzung umfasst, umfassend:
(1) einen metallischen Verbundstoff, in dem eine konjugierte Verbindung mit einem Polystyrol-äquivalenten Zahlenmittel des Molekulargewichts von 1,0 x 10³ bis 5,0 x 10⁶, wie mittels Gelpermeationschromatographie gemessen, an eine metallische Nanostruktur mit der Form eines Nanodrahts, wobei es sich um ein Metall oder ein Metalloxid, ausgewählt aus der Gruppe bestehend aus Indiumoxid, Zinkoxid, Zinnoxid, Indium-Zinn-Oxid, Aluminium-Zink-Oxid, Indium-Zink-Oxid, Zinn-Antimon-Oxid und NESA, handelt und mit einem Seitenverhältnis von 1,5 oder mehr absorbiert wird; und
(2) eine ionische Verbindung, mit der Maßgabe, dass, wenn die ionische Verbindung eine konjugierte Verbindung ist, die ionische Verbindung eine konjugierte Verbindung mit einem Molekulargewicht von weniger als 200 ist,
wobei die ionische Verbindung eine Verbindung mit einer Struktur, dargestellt durch die nachstehende Formel (hh-1), ist:
M^{m'+}ₐX'^{n'-}_{b} (hh-1)
wobei
M^{m'+} ein Alkalimetallkation darstellt,
X^{'n'-} ein Anion darstellt,
a und b jeweils unabhängig eine ganze Zahl von 1 oder mehr darstellen, und
wenn jedes aus M^{m'+} und X^{'n'-} mehrfach vorhanden ist, sie jeweils gleich oder voneinander verschieden sein können,
wobei die ionische Verbindung eine Verbindung mit einem Molekulargewicht von weniger als 500 ist und die Menge der ionischen Verbindung 1 bis 50 Gewichtsteile, bezogen auf 100 Gewichtsteile des metallischen Verbundstoffs, ist.

2. Die lichtemittierende Vorrichtung nach Anspruch 1, wobei die konjugierte Verbindung mit einem Polystyrol-äquivalenten Zahlenmittel des Molekulargewichts von 1,0 x 10³ bis 5,0 x 10⁶ eine aromatische Verbindung ist, und die metallische Nanostruktur eine metallische Nanostruktur eines Metalls der Gruppe 11 des Periodensystems ist.

3. Die lichtemittierende Vorrichtung nach Anspruch 2, wobei die konjugierte Verbindung mit einem Polystyrol-äquivalenten Zahlenmittel des Molekulargewichts von 1,0 x 10³ bis 5,0 x 10⁶ eine aromatische Verbindung mit einer Heteroatom enthaltenden Gruppe ist.

4. Die lichtemittierende Vorrichtung nach Anspruch 3, wobei die Heteroatom enthaltende Gruppe eine einwertige Gruppe ist, ausgewählt aus der Gruppe (Gruppe 1) bestehend aus einer Mercaptogruppe, einer Mercaptocarbonylgruppe, einer Mercaptothiocarbonylgruppe, einer Hydrocarbylthiogruppe, die gegebenenfalls einen Substituenten aufweist, einer Hydrocarbylthiocarbonylgrupe, die gegebenenfalls einen Substituenten aufweist, einer Hydrocarbyldithiogruppe, die gegebenenfalls einen Substituenten aufweist, einer Hydroxylgruppe, einer Hydrocarbyloxygruppe, die gegebenenfalls einen Substituenten aufweist, einer Carboxylgruppe, einer Hydrocarbylcarbonylgruppe, die gegebenenfalls einen Substituenten aufweist, einer Cyanogruppe, einer Aminogruppe, einer Hydrocarbylaminogruppe, die gegebenenfalls einen Substituenten aufweist, einer Dihydrocarbylaminogruppe, die gegebenenfalls einen Substituenten aufweist, einer Phosphinogruppe, einer Hydrocarbylphosphinogruppe, die gegebenenfalls einen Substituenten aufweist, einer Dihydrocarbylphosphinogruppe, die gegebenenfalls einen Substituenten aufweist, einer Gruppe, dargestellt durch Formel: -P(=O)(OH)₂, einer Sulfogruppe, einer einwertigen heterocyclischen Gruppe, einem Halogenatom, einer Formylgruppe, einer Hydrocarbyloxycarbonylgruppe, die gegebenenfalls einen Substituenten aufweist, einer Hydrocarbylcarbonyloxygruppe, die gegebenenfalls einen Substituenten aufweist, einer Nitrogruppe, einer Gruppe, dargestellt durch Formel: -OP(=O)(OH)₂, einer Carbamoylgruppe, einer Hydrocarbylcarbamoylgruppe, die gegebenenfalls einen Substituenten aufweist, einer Dihydrocarbylcarbamoylgruppe, die gegebenenfalls einen Substituenten aufweist, einer Gruppe, dargestellt durch Formel: -C(=S)NR₂, einer Gruppe, dargestellt durch Formel: -B(OH)₂, einer Gruppe, dargestellt durch Formel: -BR₂, einem Borsäureesterrest, einer Gruppe, dargestellt durch Formel: -Si(OR)₃, einer Hydrocarbylsulfogruppe, die gegebenenfalls einen Substituenten aufweist, einer Hydrocarbylsulfonylgruppe, die gegebenenfalls einen Substituenten aufweist, einer Sulfinogruppe, einer Hydrocarbylsulfinogruppe, die gegebenenfalls einen Substituenten aufweist, einer Gruppe, dargestellt durch Formel: -NRC(=O)OR, einer Gruppe, dargestellt durch Formel: -NRC(=O)SR, einer Gruppe, dargestellt durch Formel: -NRC(=S)OR, einer Gruppe, dargestellt durch Formel: -NRC(=S)SR, einer Gruppe, dargestellt durch Formel: -OC(=O)NR₂, einer Gruppe, dargestellt durch Formel: -SC(=O)NR₂, einer Gruppe, dargestellt durch Formel: -OC(=S)NR₂, einer Gruppe, dargestellt durch Formel: -SC(=S)NR₂, einer Gruppe, dargestellt durch Formel: -NRC(=O)NR₂ und einer Gruppe, dargestellt durch Formel: -NRC(=S)NR₂, wobei R ein Wasserstoffatom oder eine Hydrocarbylgruppe, die gegebenenfalls einen Substituenten aufweist, darstellt.

5. Die lichtemittierende Vorrichtung nach Anspruch 3, wobei die Heteroatom enthaltende Gruppe eine einwertige Gruppe ist, ausgewählt aus der Gruppe (Gruppe 2) bestehend aus einer Hydrocarbylgruppe mit zwei oder mehr Etherbindungen, einer Hydrocarbylgruppe mit zwei oder mehr Esterbindungen, einer Hydrocarbylgruppe mit zwei oder mehr Amidobindungen, einer Gruppe, dargestellt durch die Formel: -SM, einer Gruppe, dargestellt durch die Formel: -C(=O)SM, einer Gruppe, dargestellt durch die Formel: -CS₂M, einer Gruppe, dargestellt durch die Formel: -OM, einer Gruppe, dargestellt durch die Formel: -CO₂M, einer Gruppe, dargestellt durch die Formel: -NM₂, einer Gruppe, dargestellt durch die Formel: -NHM, einer Gruppe, dargestellt durch die Formel: -NRM, einer Gruppe, dargestellt durch die Formel: -PO₃M, einer Gruppe, dargestellt durch die Formel: -OP(=O)(OM)₂, einer Gruppe, dargestellt durch die Formel: -P(=O)(OM)₂, einer Gruppe, dargestellt durch die Formel: -C(=O)NM₂, einer Gruppe, dargestellt durch die Formel: -C(=O)NHM, einer Gruppe, dargestellt durch die Formel: -C(=O)NRM, einer Gruppe, dargestellt durch die Formel: -C(=S)NHM, einer Gruppe, dargestellt durch die Formel: -C(=S)NRM, einer Gruppe, dargestellt durch die Formel: -C(=S)NM₂, einer Gruppe, dargestellt durch die Formel: -B(OM)₂, einer Gruppe, dargestellt durch die Formel: -BR₃M, einer Gruppe, dargestellt durch die Formel: -B(OR)₃M, einer Gruppe, dargestellt durch die Formel: -SO₃M, einer Gruppe, dargestellt durch die Formel: -SO₂M, einer Gruppe, dargestellt durch die Formel: -NRC(=O)OM, einer Gruppe, dargestellt durch die Formel: -NRC(=O)SM, einer Gruppe, dargestellt durch die Formel: -NRC(=S)OM, einer Gruppe, dargestellt durch die Formel: -NRC(=S)SM, einer Gruppe, dargestellt durch die Formel: -OC(=O)NM₂, einer Gruppe, dargestellt durch die Formel: -OC(=O)NRM, einer Gruppe, dargestellt durch die Formel: -OC(=S)NM₂, einer Gruppe, dargestellt durch die Formel: -OC(=S)NRM, einer Gruppe, dargestellt durch die Formel: -SC(=O)NM₂, einer Gruppe, dargestellt durch die Formel: -SC(=O)NRM, einer Gruppe, dargestellt durch die Formel: -SC(=S)NM₂, einer Gruppe, dargestellt durch die Formel: -SC(=S)NRM, einer Gruppe, dargestellt durch die Formel: -NRC(=O)NM₂, einer Gruppe, dargestellt durch die Formel: -NRC(=O)NRM, einer Gruppe, dargestellt durch die Formel: -NRC(=S)NM₂, einer Gruppe, dargestellt durch die Formel: -NRC(=S)NRM, einer Gruppe, dargestellt durch die Formel: -NR₃M', einer Gruppe, dargestellt durch die Formel: -PR₃M', einer Gruppe, dargestellt durch die Formel: -OR₂M', einer Gruppe, dargestellt durch die Formel: -SR₂M', einer Gruppe, dargestellt durch die Formel: -IRM' und einer einwertigen heterocyclischen Gruppe mit einem kationisierten Stickstoffatom innerhalb des Heterocyclus, wobei R ein Wasserstoffatom oder eine Hydrocarbylgruppe, die gegebenenfalls einen Substituenten aufweist, darstellt, M ein Metallkation oder ein Ammoniumkation, das gegebenenfalls einen Substituenten aufweist, darstellt und M' ein Anion darstellt.

6. Die lichtemittierende Vorrichtung nach einem der Ansprüche 3 bis 5, wobei die konjugierte Verbindung mit einem Polystyrol-äquivalenten Zahlenmittel des Molekulargewichts von 1,0 x 10³ bis 5,0 x 10⁶ mindestens eine Art einer Gruppe, ausgewählt aus Gruppe 1 und mindestens eine Art einer Gruppe, ausgewählt aus Gruppe 2, umfasst.

7. Die lichtemittierende Vorrichtung nach einem der Ansprüche 1 bis 6, wobei die konjugierte Verbindung mit einem Polystyrol-äquivalenten Zahlenmittel des Molekulargewichts von 1,0 x 10³ bis 5,0 x 10⁶ eine Gruppe, dargestellt durch die nachstehende Formel (I) oder eine Wiederholungseinheit, dargestellt durch die nachstehende Formel (II) oder beide umfasst: 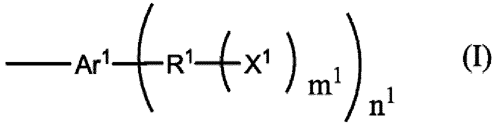 wobei
Ar¹ eine (n¹+1)-wertige aromatische Gruppe darstellt,
R¹ eine direkte Bindung oder eine (m¹+1)-wertige Gruppe darstellt,
X¹ eine Heteroatom enthaltende Gruppe darstellt,
m¹ und n¹ jeweils unabhängig eine ganze Zahl von 1 oder mehr darstellen, und
wenn jedes aus R¹, X¹ und m¹ mehrfach vorhanden ist, sie jeweils gleich oder voneinander verschieden sein können; 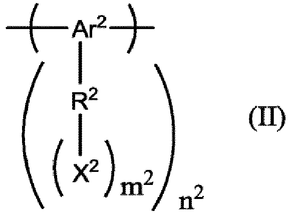
wobei
Ar² eine (n²+2)-wertige aromatische Gruppe darstellt,
R² eine direkte Bindung oder eine (m²+1)-wertige Gruppe darstellt,
X² eine Heteroatom enthaltende Gruppe darstellt,
m² und n² jeweils unabhängig eine ganze Zahl von 1 oder mehr darstellen, und
wenn jedes aus R², X² und m² mehrfach vorhanden ist, sie jeweils gleich oder voneinander verschieden sein können.

8. Die lichtemittierende Vorrichtung nach Anspruch 7, wobei die (n¹+1)-wertige aromatische Gruppe, dargestellt durch Ar¹, ein Rest ist, der nach Entfernung von (n¹+1)-Wasserstoffatomen, die direkt an Kohlenstoffatome binden, welche einen Ring einer aromatischen Verbindung, dargestellt durch eine der nachstehenden Formeln bilden, übrigbleibt, die (n²+2)-wertige aromatische Gruppe, dargestellt durch Ar², ein Rest ist, der nach Entfernung von (n²+2)-Wasserstoffatomen, die direkt an Kohlenstoffatome binden, welche einen Ring einer aromatischen Verbindung, dargestellt durch eine der nachstehenden Formeln bilden, übrigbleibt und die aromatischen Gruppen gegebenenfalls substituiert sind.

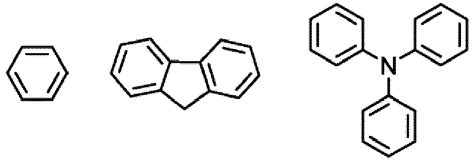

9. Die lichtemittierende Vorrichtung nach einem der Ansprüche 1 bis 8, wobei die konjugierte Verbindung mit einem Polystyrol-äquivalenten Zahlenmittel des Molekulargewichts von 1,0 x 10³ bis 5,0 x 10⁶ eine makromolekulare Verbindung mit einer oder mehreren Wiederholungseinheiten, ausgewählt aus der Gruppe bestehend aus Wiederholungseinheiten, dargestellt durch die nachstehenden Formeln, ist: 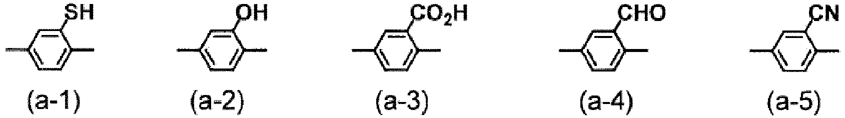 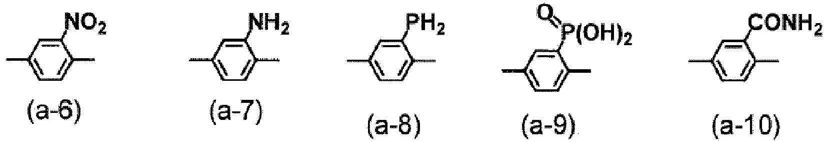 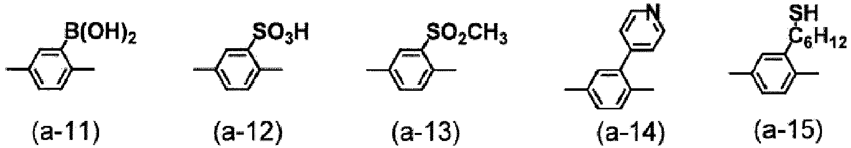 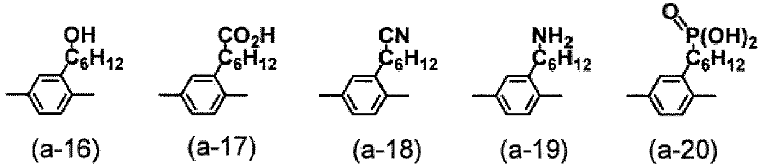 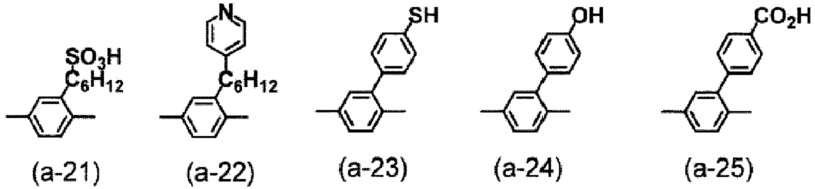 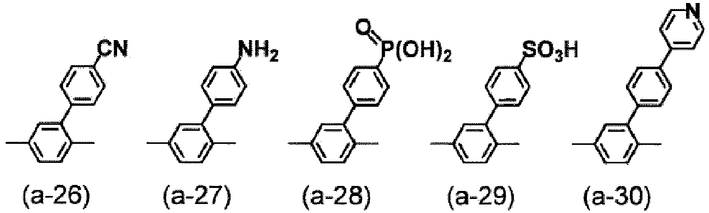 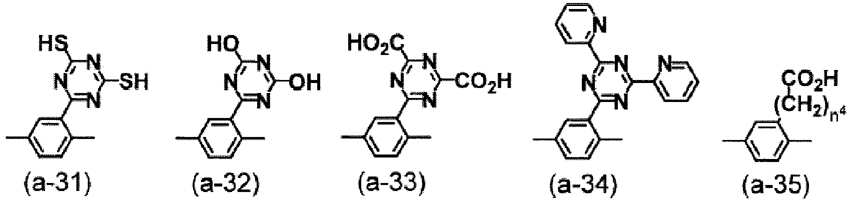 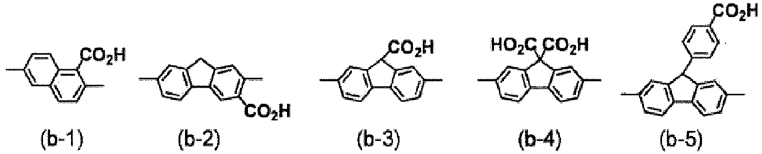 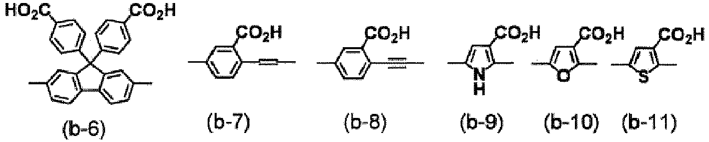 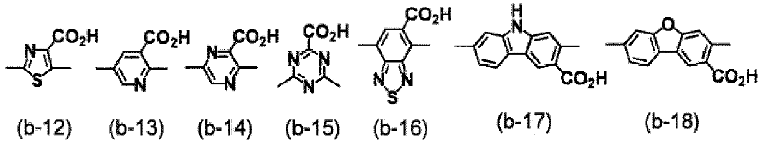 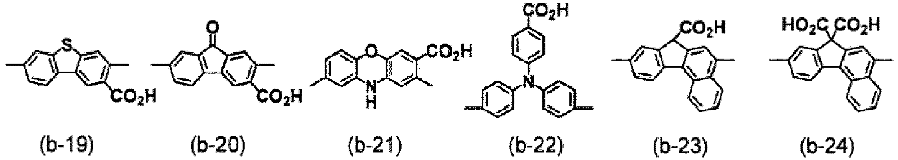 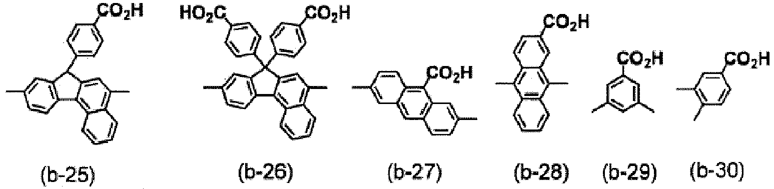 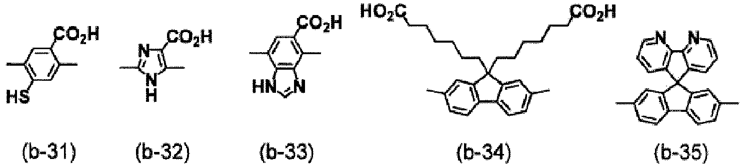 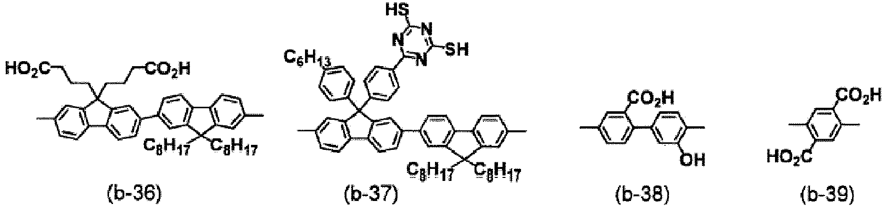 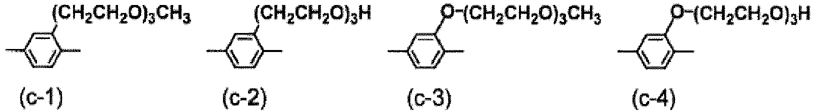 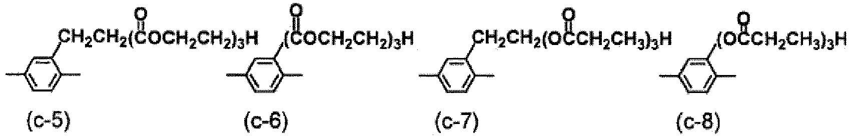 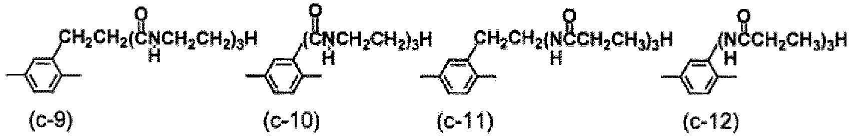 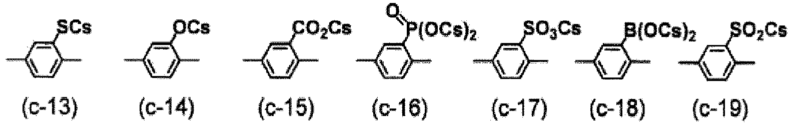 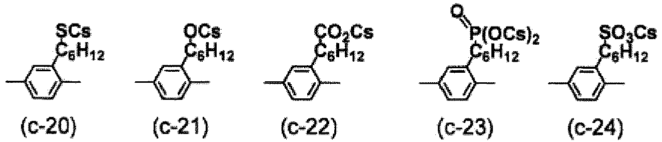 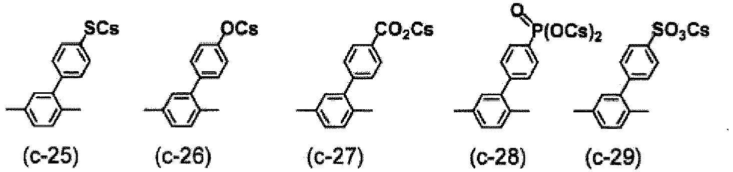 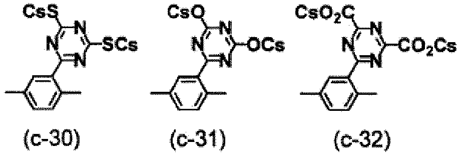 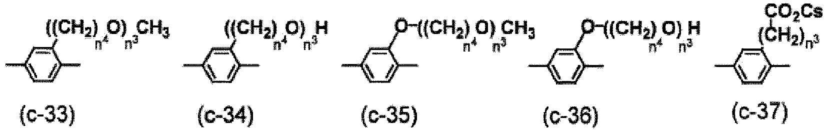 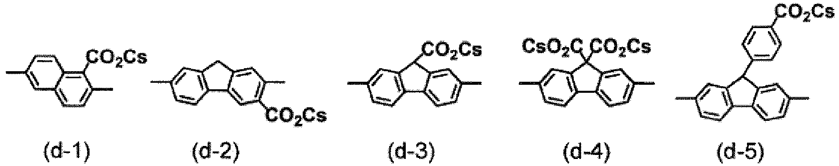 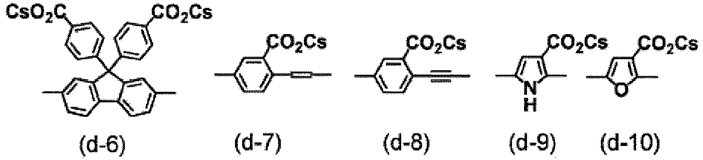 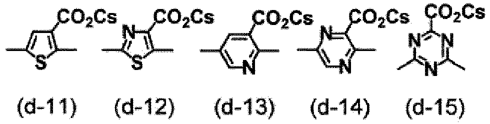 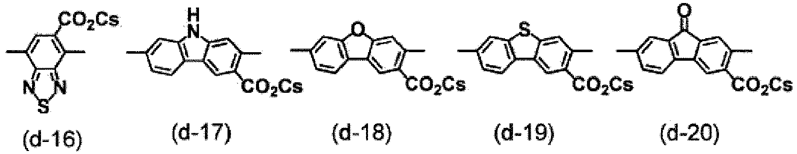 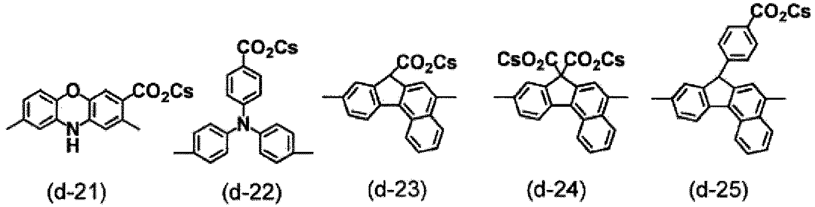 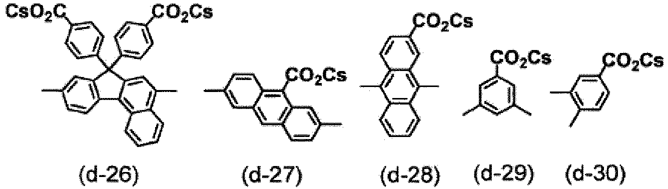 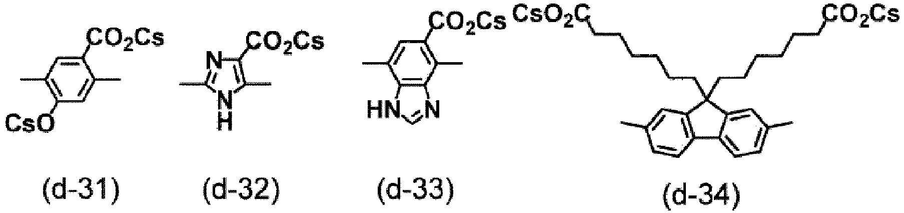 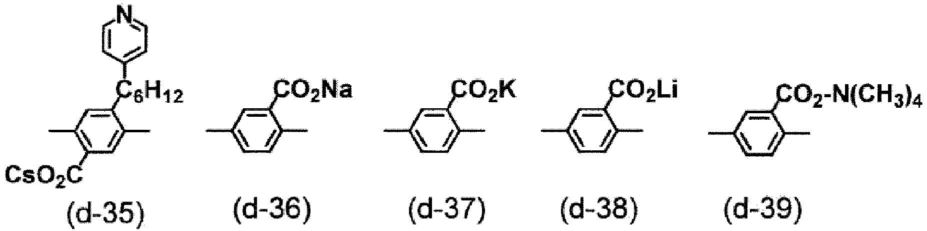 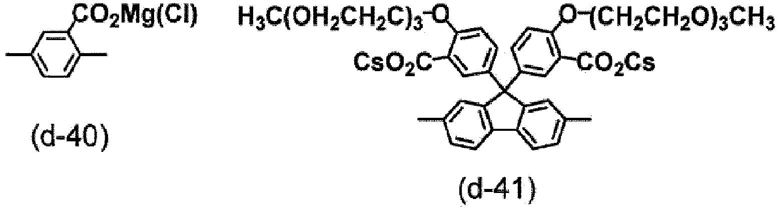 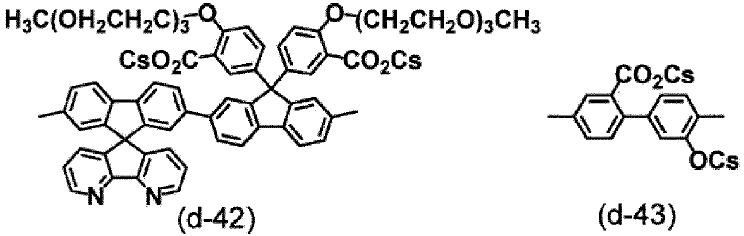 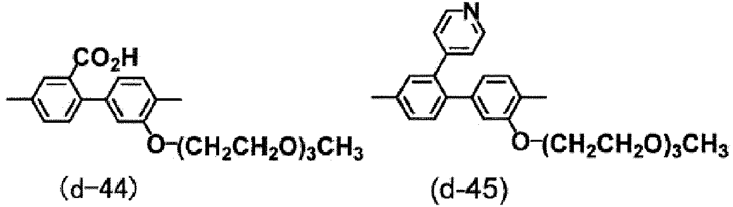 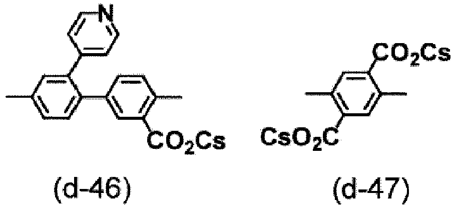 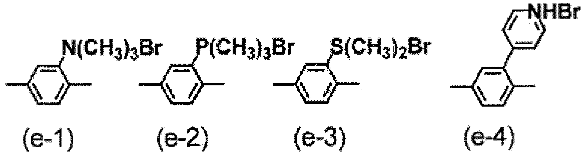 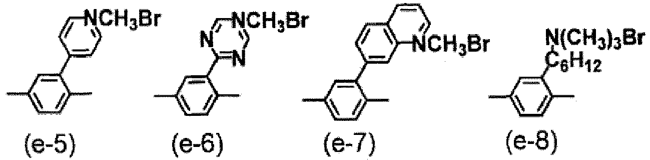 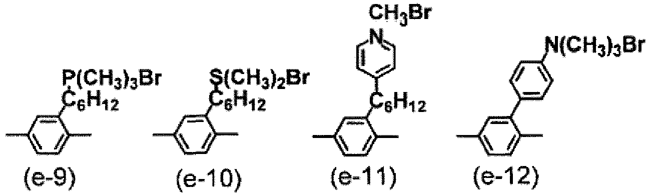 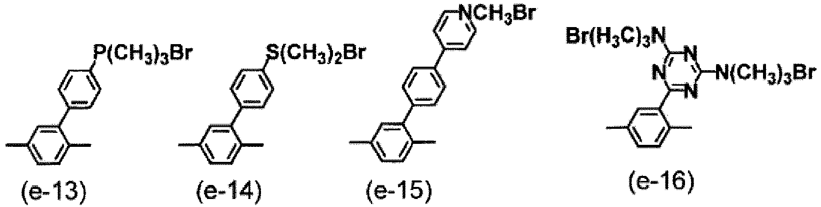 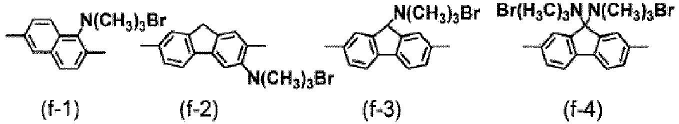 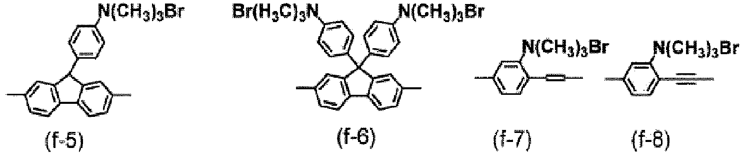 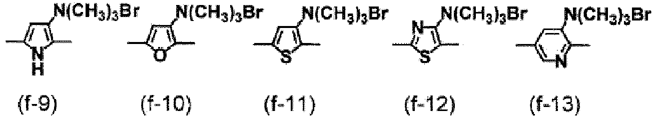 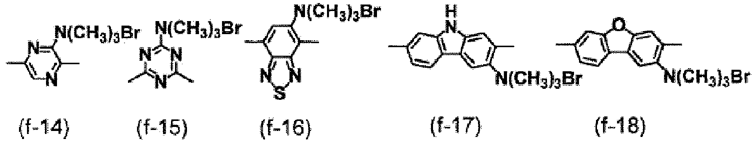 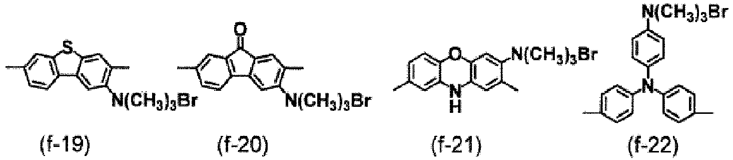 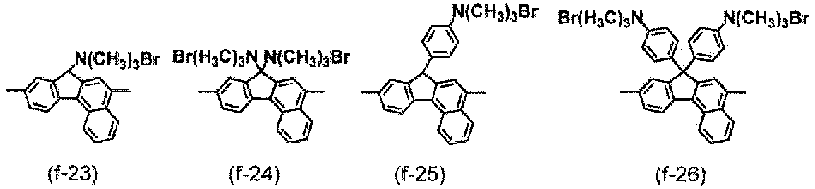 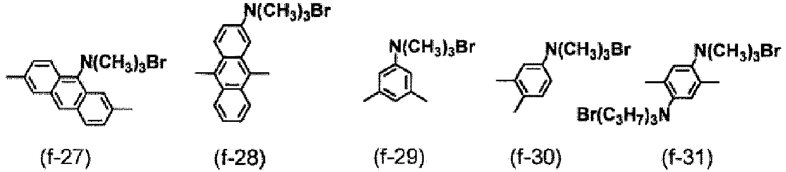 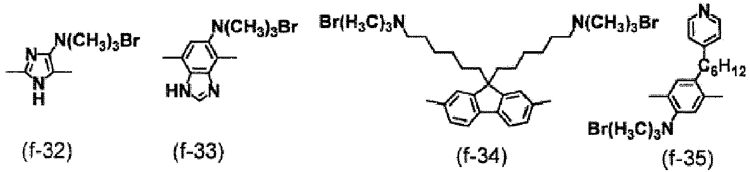 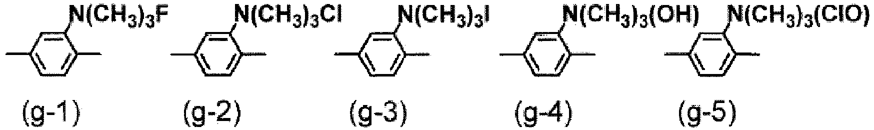 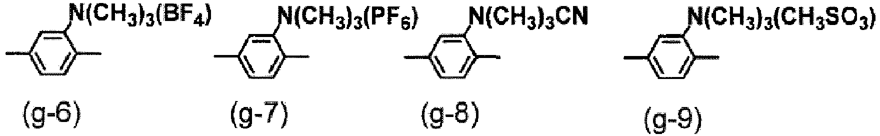 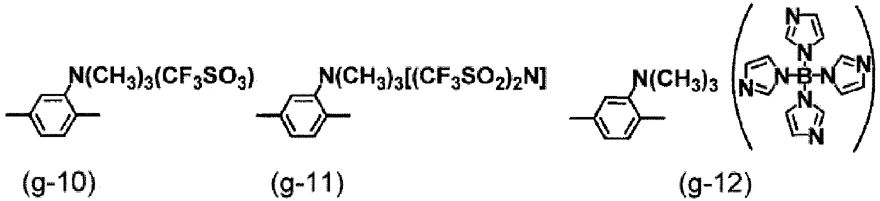 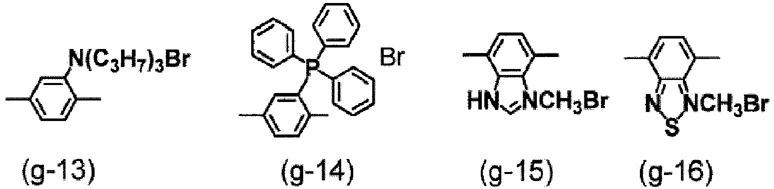 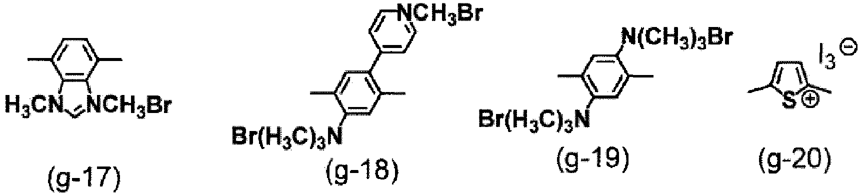 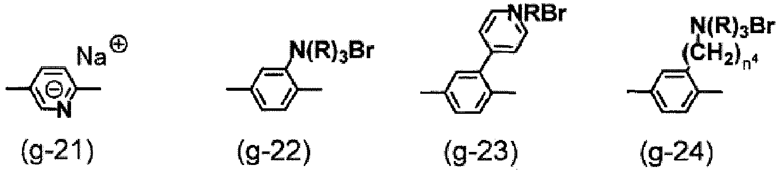 wobei n³ eine ganze Zahl von 2 oder mehr darstellt, n⁴ eine ganze Zahl von 1 oder mehr darstellt und R ein Wasserstoffatom oder eine Hydrocarbylgruppe, die gegebenenfalls einen Substituenten aufweist, darstellt.

10. Die lichtemittierende Vorrichtung nach Anspruch 9, wobei die konjugierte Verbindung mit einem Polystyrol-äquivalenten Zahlenmittel des Molekulargewichts von 1,0 x 10³ bis 5,0 x 10⁶ eine makromolekulare Verbindung mit einem oder mehreren Wiederholungseinheiten, ausgewählt aus der Gruppe bestehend aus Wiederholungseinheiten, dargestellt durch die Formeln (b-6), (b-34), (b-37), (c-1), (c-2), (c-3), (c-4), (d-38), (d-41) und (d-42), ist.

## Revendications

1. Dispositif émettant de la lumière comprenant une anode, une cathode, et une couche émettant de la lumière fournie entre l'anode et la cathode,
**caractérisé en ce que** la cathode comprend une composition composite métallique comprenant :
(1) un composite métallique dans lequel un composé conjugué ayant une masse moléculaire moyenne en nombre équivalente de polystyrène de 1,0 x 10³ à 5,0 x 10⁶ comme mesurée par chromatographie par perméation sur gel est adsorbé sur une nanostructure métallique ayant la forme d'un nanofil qui est un métal ou un oxyde de métal choisi dans le groupe consistant en oxyde d'indium, oxyde de zinc, oxyde d'étain, oxyde d'indium étain, oxyde d'aluminium zinc, oxyde d'indium zinc, oxyde d'étain antimoine et NESA et ayant un rapport d'allongement de 1,5 ou supérieur ; et
(2) un composé ionique, à condition que lorsque le composé ionique est un composé conjugué, le composé ionique est un composé conjugué ayant une masse moléculaire inférieure à 200,
dans lequel le composé ionique est un composé ayant une structure représentée par la formule (hh-1) ci-dessous :
M^{m'+}ₐX^{'n'-}_{b} (hh - 1)
dans laquelle
M^{m'+} représente un cation de métal alcalin,
X^{'n'-} représente un anion,
a et b représentent chacun indépendamment un nombre entier de 1 ou supérieur, et
lorsque chacun de M^{m'+} et X^{'n'-} est présent plusieurs fois, ils peuvent être chacun identiques ou différents les uns des autres, dans lequel le composé ionique est un composé ayant une masse moléculaire inférieure à 500, et la quantité du composé ionique est de 1 à 50 parties en masse, par rapport à 100 parties en masse du composite métallique.

2. Dispositif émettant de la lumière selon la revendication 1, dans lequel le composé conjugué ayant une masse moléculaire moyenne en nombre équivalente de polystyrène de 1,0 x 10³ à 5,0 x 10⁶ est un composé aromatique, et la nanostructure métallique est une nanostructure métallique d'un métal du groupe 11 de la classification périodique des éléments.

3. Dispositif émettant de la lumière selon la revendication 2, dans lequel le composé conjugué ayant une masse moléculaire moyenne en nombre équivalente de polystyrène de 1,0 x 10³ à 5,0 x 10⁶ est un composé aromatique ayant un groupe contenant un hétéroatome.

4. Dispositif émettant de la lumière selon la revendication 3, dans lequel le groupe contenant un hétéroatome est un groupe monovalent choisi dans le groupe (Groupe 1) consistant en un groupe mercapto, un groupe mercaptocarbonyle, un groupe mercapto-thiocarbonyle, un groupe hydrocarbylthio ayant éventuellement un substituant, un groupe hydrocarbylthiocarbonyle ayant éventuellement un substituant, un groupe hydrocarbyldithio ayant éventuellement un substituant, un groupe hydroxyle, un groupe hydrocarbyloxy ayant éventuellement un substituant, un groupe carboxyle, un groupe hydrocarbylcarbonyle ayant éventuellement un substituant, un groupe cyano, un groupe amino, un groupe hydrocarbylamino ayant éventuellement un substituant, un groupe dihydrocarbylamino ayant éventuellement un substituant, un groupe phosphino, un groupe hydrocarbylphosphino ayant éventuellement un substituant, un groupe dihydrocarbylphosphino ayant éventuellement un substituant, un groupe représenté par la formule : -P(=O)(OH)₂, un groupe sulfo, un groupe hétérocyclique monovalent, un atome d'halogène, un groupe formyle, un groupe hydrocarbyloxycarbonyle ayant éventuellement un substituant, un groupe hydrocarbylcarbonyloxy ayant éventuellement un substituant, un groupe nitro, un groupe représenté par la formule : -OP(=O)(OH)₂, un groupe carbamoyle, un groupe hydrocarbylcarbamoyle ayant éventuellement un substituant, un groupe dihydrocarbylcarbamoyle ayant éventuellement un substituant, un groupe représenté par la formule : -C(=S)NR₂, un groupe représenté par la formule : -B(OH)₂, un groupe représenté par la formule : -BR₂, un résidu d'ester d'acide borique, un groupe représenté par la formule : -Si(OR)₃, un groupe hydrocarbylsulfo ayant éventuellement un substituant, un groupe hydrocarbylsulfonyle ayant éventuellement un substituant, un groupe sulfino, un groupe hydrocarbylsulfino ayant éventuellement un substituant, un groupe représenté par la formule : -NRC(=O)OR, un groupe représenté par la formule : -NRC(=O)SR, un groupe représenté par la formule : -NRC(=S)OR, un groupe représenté par la formule : -NRC(=S)SR, un groupe représenté par la formule : -OC(=O)NR₂, un groupe représenté par la formule : -SC(=O)NR₂, un groupe représenté par la formule : -OC(=S)NR₂, un groupe représenté par la formule : -SC(=S)NR₂, un groupe représenté par la formule : -NRC(=O)NR₂, et un groupe représenté par la formule : -NRC(=S)NR₂, dans lequel R représente un atome d'hydrogène ou un groupe hydrocarbyle ayant éventuellement un substituant.

5. Dispositif émettant de la lumière selon la revendication 3, dans lequel le groupe contenant un hétéroatome est un groupe monovalent choisi dans le groupe (Groupe 2) consistant en un groupe hydrocarbyle ayant deux liaisons éther ou plus, un groupe hydrocarbyle ayant deux liaisons ester ou plus, un groupe hydrocarbyle ayant deux liaisons amido ou plus, un groupe représenté par la formule : -SM, un groupe représenté par la formule : -C(=O)SM, un groupe représenté par la formule : -CS₂M, un groupe représenté par la formule : -OM, un groupe représenté par la formule : -CO₂M, un groupe représenté par la formule : -NM₂, un groupe représenté par la formule : -NHM, un groupe représenté par la formule : -NRM, un groupe représenté par la formule : -PO₃M, un groupe représenté par la formule : -OP(=O)(OM)₂, un groupe représenté par la formule : -P(=O)(OM)₂, un groupe représenté par la formule : -C(=O)NM₂, un groupe représenté par la formule : -C(=O)NHM, un groupe représenté par la formule : -C(=O)NRM, un groupe représenté par la formule : -C(=S)NHM, un groupe représenté par la formule -C(=S)NRM, un groupe représenté par la formule : -C(=S)NM₂, un groupe représenté par la formule : -B(OM)₂, un groupe représenté par la formule : -BR₃M, un groupe représenté par la formule : -B(OR)₃M, un groupe représenté par la formule : -SO₃M, un groupe représenté par la formule : -SO₂M, un groupe représenté par la formule : -NRC(=O)OM, un groupe représenté par la formule : -NRC(=O)SM, un groupe représenté par la formule : -NRC(=S)OM, un groupe représenté par la formule : -NRC(=S)SM, un groupe représenté par la formule : -OC(=O)NM₂, un groupe représenté par la formule : -OC(=O)NRM, un groupe représenté par la formule : -OC(=S)NM₂, un groupe représenté par la formule : -OC(=S)NRM, un groupe représenté par la formule : -SC(=O)NM₂, un groupe représenté par la formule : -SC(=O)NRM, un groupe représenté par la formule : -SC(=S)NM₂, un groupe représenté par la formule : -SC(=S)NRM, un groupe représenté par la formule : -NRC(=O)NM₂, un groupe représenté par la formule : -NRC(=O)NRM, un groupe représenté par la formule : -NRC(=S)NM₂, un groupe représenté par la formule : -NRC(=S)NRM, un groupe représenté par la formule : -NR₃M', un groupe représenté par la formule : -PR₃M', un groupe représenté par la formule : -OR₂M', un groupe représenté par la formule : -SR₂M', un groupe représenté par la formule : -IRM', et un groupe hétérocyclique monovalent ayant un atome d'azote cationisé dans l'hétérocycle, dans lequel R représente un atome d'hydrogène ou un groupe hydrocarbyle ayant éventuellement un substituant, M représente un cation de métal ou un cation ammonium ayant éventuellement un substituant, et M' représente un anion.

6. Dispositif émettant de la lumière selon l'une quelconque des revendications 3 à 5, dans lequel le composé conjugué ayant une masse moléculaire moyenne en nombre équivalente de polystyrène de 1,0 x 10³ à 5,0 x 10⁶ comprend au moins un type de groupe choisi dans le Groupe 1 et au moins un type de groupe choisi dans le Groupe 2.

7. Dispositif émettant de la lumière selon l'une quelconque des revendications 1 à 6, dans lequel le composé conjugué ayant une masse moléculaire moyenne en nombre équivalente de polystyrène de 1,0 x 10³ à 5,0 x 10⁶ comprend un groupe représenté par la formule (I) ci-dessous, ou une unité répétitive représentée par la formule (II) ci-dessous, ou les deux de ceux-ci : 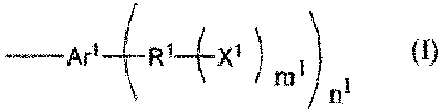 dans laquelle
Ar¹ représente un groupe aromatique (n¹+1) valent,
R¹ représente une liaison directe ou un groupe (m¹+1) valent,
X¹ représente un groupe contenant un hétéroatome,
m¹ et n¹ représentent chacun indépendamment un nombre entier de 1 ou supérieur, et
lorsque chacun de R¹, X¹ et m¹ est présent plusieurs fois, ils peuvent être identiques ou différents les uns des autres ; 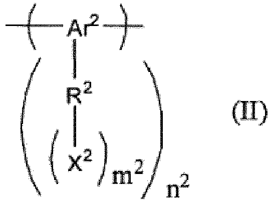
dans laquelle
Ar² représente un groupe aromatique (n²+2) valent,
R² représente une liaison directe ou un groupe (m²+1) valent,
X² représente un groupe contenant un hétéroatome,
m² et n² représentent chacun indépendamment un nombre entier de 1 ou supérieur, et
lorsque chacun de R², X² et m² est présent plusieurs fois, ils peuvent être identiques ou différents les uns des autres.

8. Dispositif émettant de la lumière selon la revendication 7, dans lequel le groupe aromatique (n¹+1) valent représenté par Ar¹ est un résidu restant après l'élimination de (n¹+1) atomes d'hydrogène liés directement à des atomes de carbone qui constituent un noyau d'un composé aromatique représenté par l'une quelconque des formules ci-dessous, le groupe (n²+2) valent aromatique représenté par Ar² est un résidu restant après l'élimination de (n²+2) atomes d'hydrogène liés directement à des atomes de carbone qui constituent un noyau d'un composé aromatique représenté par l'une quelconque des formules ci-dessous, et les groupes aromatiques sont éventuellement substitués.

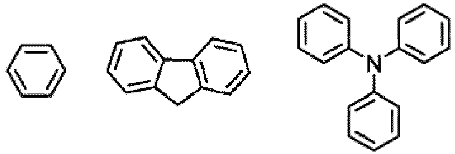

9. Dispositif émettant de la lumière selon l'une quelconque des revendications 1 à 8, dans lequel le composé conjugué ayant une masse moléculaire moyenne en nombre équivalente de polystyrène de 1,0 x 10³ à 5,0 x 10⁶ est un composé macromoléculaire ayant une ou plusieurs unités répétitives choisies dans le groupe consistant en unités répétitives représentées par les formules suivantes : 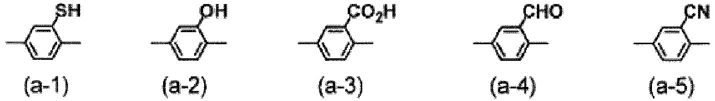 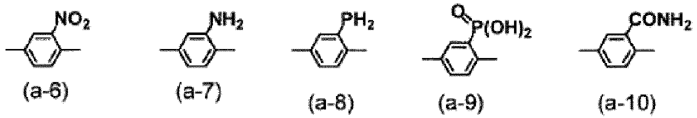 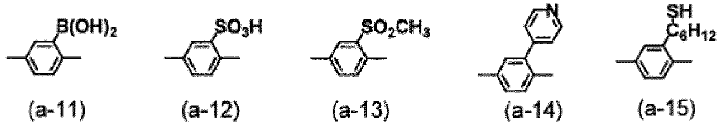 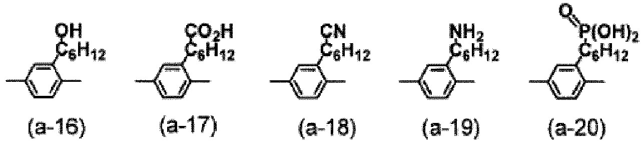 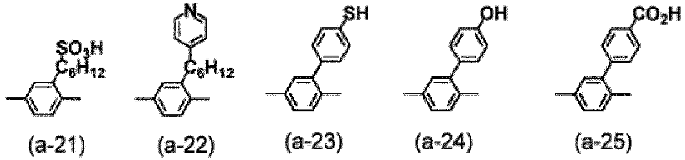 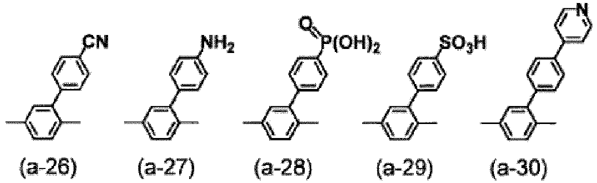 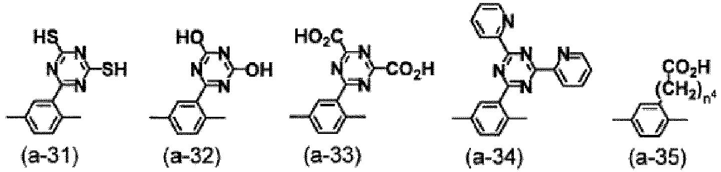 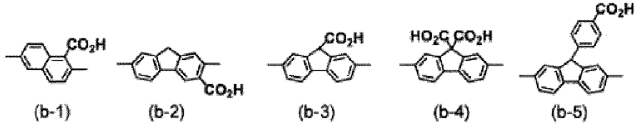 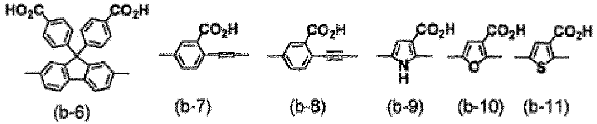 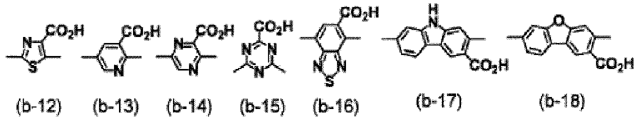 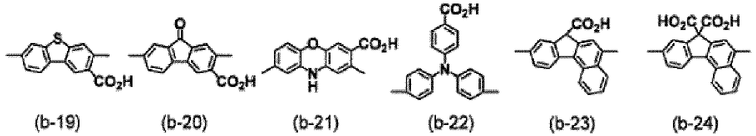 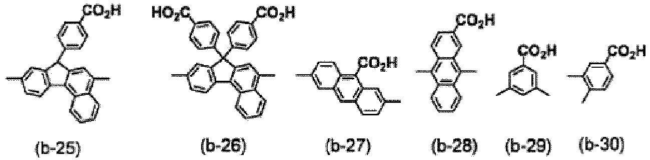 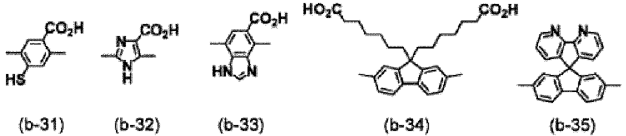 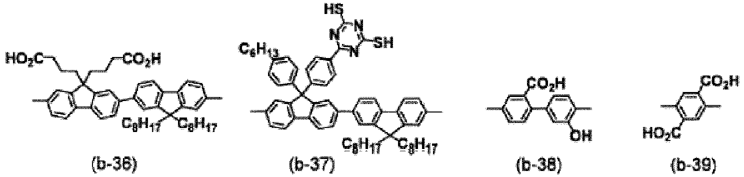 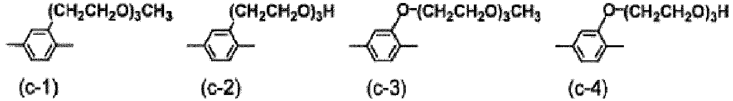 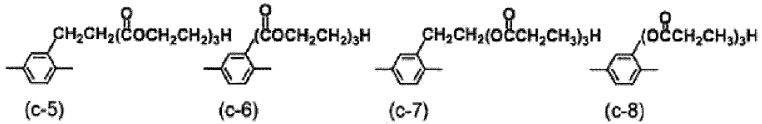 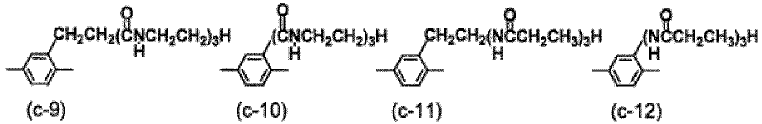 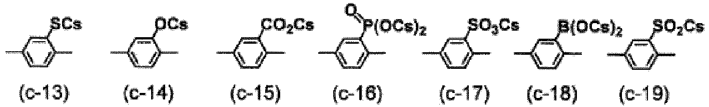 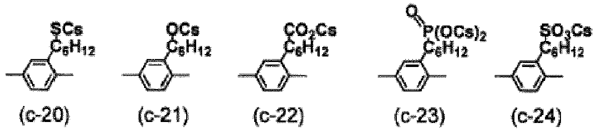 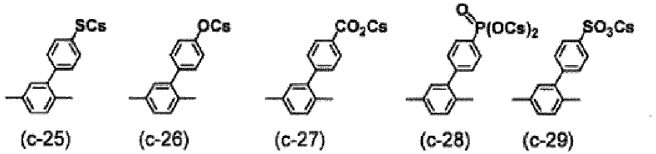 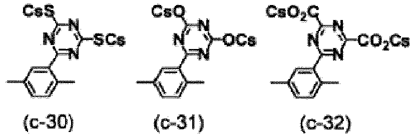 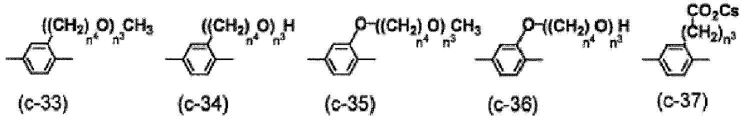 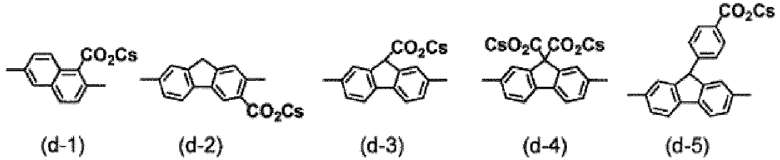 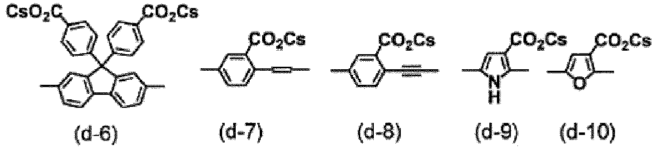 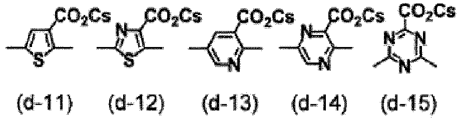 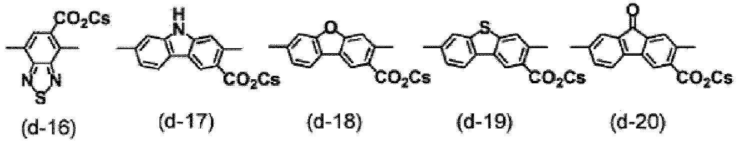 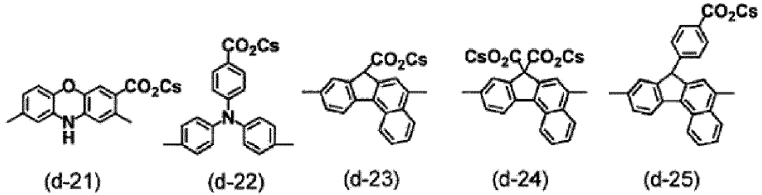 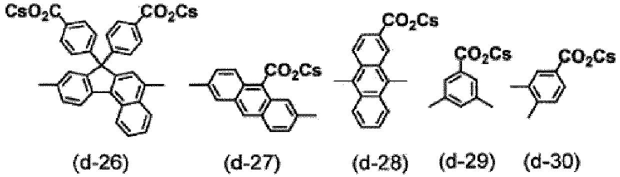 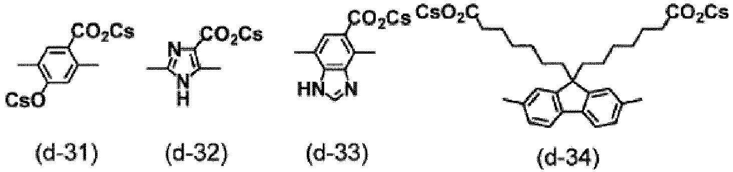 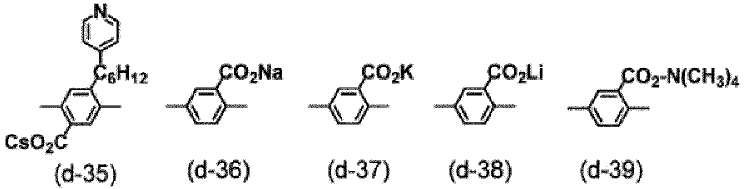 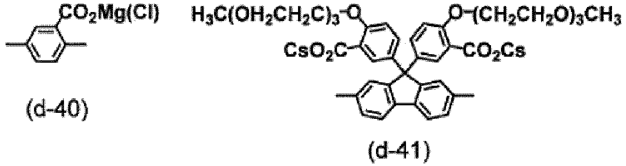 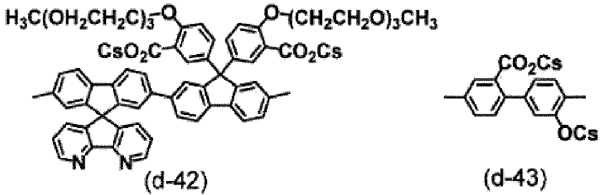 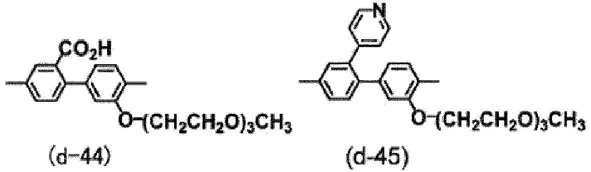 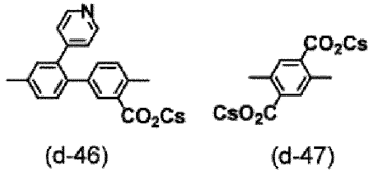 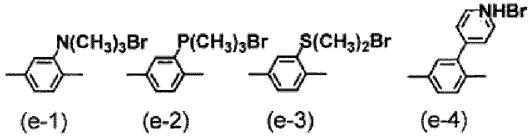 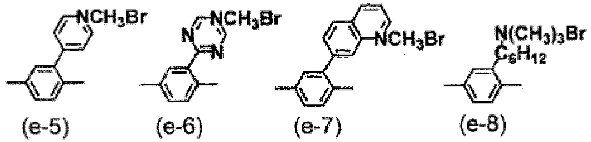 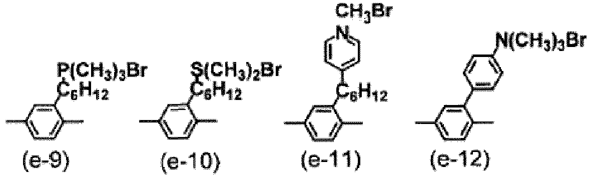 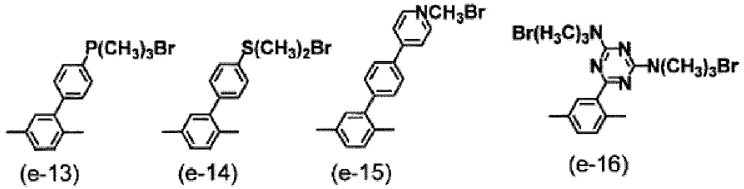 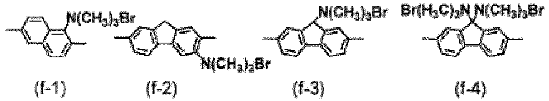 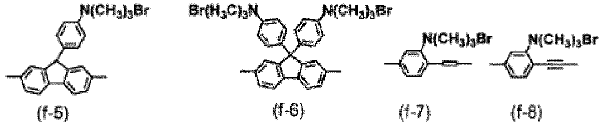 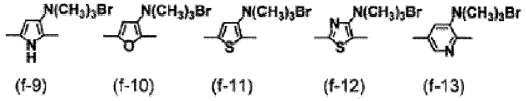 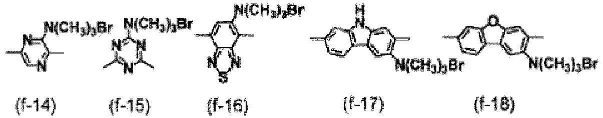 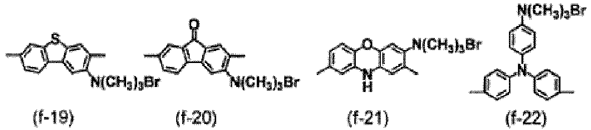 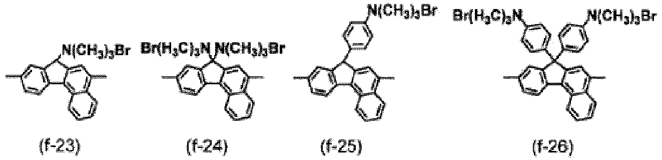 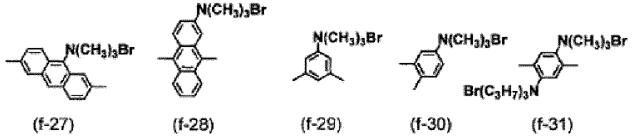 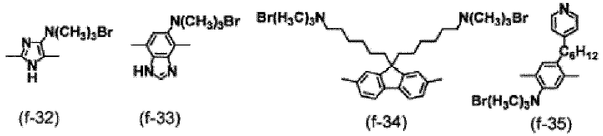 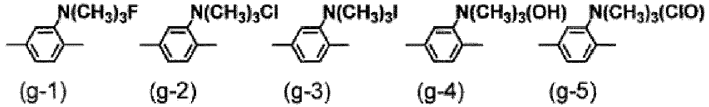 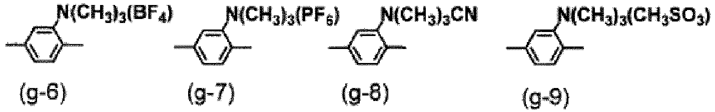 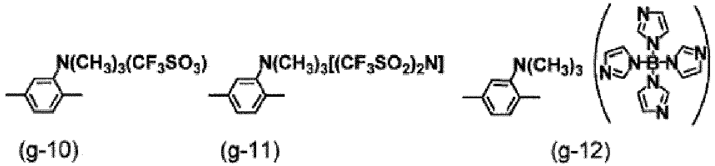 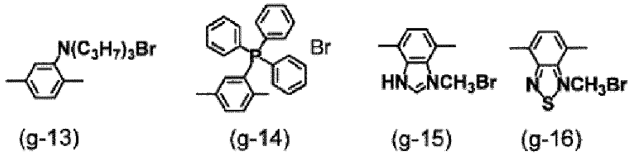 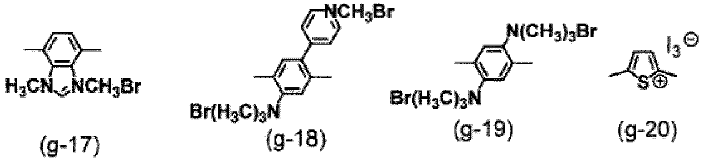 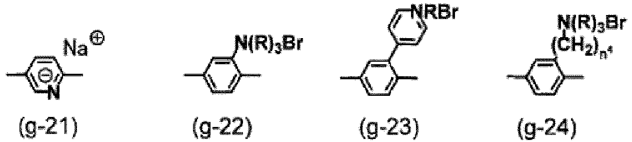 dans lesquelles n³ représente un nombre entier de 2 ou supérieur, n⁴ représente un nombre entier de 1 ou supérieur, et R représente un atome d'hydrogène ou un groupe hydrocarbyle ayant éventuellement un substituant.

10. Dispositif émettant de la lumière selon la revendication 9, dans lequel le composé conjugué ayant une masse moléculaire moyenne en nombre équivalente de polystyrène de 1,0 x 10³ à 5,0 x 10⁶ est un composé macromoléculaire ayant une ou plusieurs unités répétitives choisies dans le groupe consistant en unités répétitives représentées par les formules (b-6), (b-34), (b-37), (c-1), (c-2), (c-3), (c-4), (d-38), (d-41) et (d-42).
